(19) Europäisches Patentamt
European Patent Office
Office européen des brevets

(11) **EP 4 679 174 A1**

(12) **EUROPEAN PATENT APPLICATION**
published in accordance with Art. 153(4) EPC

(43) Date of publication:
**14.01.2026 Bulletin 2026/03**

(21) Application number: **24767042.5**

(22) Date of filing: **01.03.2024**

(51) International Patent Classification (IPC):
***G03F 7/004*** *(2006.01)* ***G03F 7/20*** *(2006.01)*
***G03F 7/038*** *(2006.01)* ***G03F 7/039*** *(2006.01)*

(52) Cooperative Patent Classification (CPC):
**G03F 7/004; G03F 7/038; G03F 7/039; G03F 7/20**

(86) International application number:
**PCT/JP2024/007719**

(87) International publication number:
**WO 2024/185674 (12.09.2024 Gazette 2024/37)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.03.2023 JP 2023034922**

(71) Applicant: **FUJIFILM Corporation**
**Tokyo 106-8620 (JP)**

(72) Inventors:
- **KANEKO, Akihiro**
  **Haibara-gun, Shizuoka 421-0396 (JP)**
- **GOTO, Akiyoshi**
  **Haibara-gun, Shizuoka 421-0396 (JP)**

(74) Representative: **HGF**
**HGF Limited**
**4th Floor, 1 City Square**
**Leeds LS1 2AL (GB)**

# (54) ACTINIC RAY-SENSITIVE OR RADIATION-SENSITIVE RESIN COMPOSITION, RESIST FILM, PATTERN-FORMING METHOD, AND PRODUCTION METHOD FOR ELECTRONIC DEVICE

(57) An actinic ray-sensitive or radiation-sensitive resin composition containing a resin that is subjected to action of an acid to undergo an increase in polarity, an onium salt (B) represented by a formula (1) described in the Specification, and a resin (C) satisfying specified conditions, a resist film, a pattern forming method, and a method for producing an electronic device that use the actinic ray-sensitive or radiation-sensitive resin composition.



Processed by Luminess, 75001 PARIS (FR)

## Description

## BACKGROUND OF THE INVENTION

1. Field of the Invention

The present invention relates to an actinic ray-sensitive or radiation-sensitive resin composition, a resist film, a pattern forming method, and a method for producing an electronic device. More specifically, the present invention relates to an actinic ray-sensitive or radiation-sensitive resin composition that can be suitably used in ultramicrolithography processes applicable to, for example, processes for producing ultra-LSIs (Large Scale Integrations) and high-capacity microchips, processes for producing nanoimprint molds, and processes for producing high-density information recording media, and other photofabrication processes, an actinic ray-sensitive or radiation-sensitive film, a pattern forming method, and a method for producing an electronic device.

2. Description of the Related Art

In fabrication processes for semiconductor devices such as ICs (Integrated Circuits) or LSIs (Large Scale Integrations), microprocessing by lithography using resist compositions has been performed. In recent years, with an increase in the degree of integration of integrated circuits, formation of ultrafine patterns in the submicron range or the quarter micron range has come to be in demand. With this, there is a trend for exposure wavelengths toward shorter wavelengths from the g-line to the i-line further to the KrF excimer laser beam; currently, exposure apparatuses using, as light sources, the ArF excimer laser having a wavelength of 193 nm have been developed. In addition, as a technique of further increasing the resolving power, a technique in which the space between a projection lens and a sample is filled with a liquid having a high refractive index (hereafter, also referred to as "immersion liquid"), what is called, the immersion method is being developed.

In addition, currently, lithography using, instead of excimer laser beams, an electron beam (EB), X-rays, extreme ultraviolet rays (EUV), or the like is also being developed. With this, resist compositions effectively sensitive to various actinic rays or radiations have been developed.

As actinic ray-sensitive or radiation-sensitive resin compositions, various compositions are known. JP2016-206586A describes a resist composition including a resin that is subjected to action of an acid to undergo a change in the degree of solubility in an organic solvent-containing developer, a photoacid generator, and a hydrophobic resin having a fluorine atom. JP2012-32782A describes a resist composition including a first polymer that is acid-sensitive, a second polymer that has a specified structure and has a surface energy lower than the surface energy of the first polymer, a photoacid generator, and a solvent.

## SUMMARY OF THE INVENTION

There has recently been an increasing demand for higher performance for resist compositions. In particular, there has been a demand for improvements in the line width roughness (Line Width Roughness: LWR) performance and reduction in the amount of residue. The LWR performance means the performance of providing a pattern having a lower LWR.

An object of the present invention is to provide an actinic ray-sensitive or radiation-sensitive resin composition that has high LWR performance and can achieve reduction in the amount of post-development residue.

Another object of the present invention is to provide a resist film, a pattern forming method, and a method for producing an electronic device that use the actinic ray-sensitive or radiation-sensitive resin composition.

The inventors of the present invention have found that the following features can address the above-described objects.

[1]
An actinic ray-sensitive or radiation-sensitive resin composition containing a resin (A) which provides an increased polarity by action of an acid, an onium salt (B) represented by a formula (1) below, and a resin (C) satisfying all of (i) to (iii) below:

(i) no fluorine atom is included,
(ii) an SP value [$SP_C$] of the resin (C) is smaller than an SP value [$SP_A$] of the resin (A) and is 17.00 or less, and
(iii) a content relative to a total solid content of the actinic ray-sensitive or radiation-sensitive resin composition is 0.01 to 10 mass%,

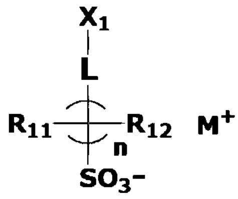

(1)

wherein, in the formula (1),

$R_{11}$ represents a hydrogen atom, a cyano group, a nitro group, a substituent represented by a formula (1A) below, or a substituent represented by a formula (1B) below,
$R_{12}$ represents a hydrogen atom or a substituent which does not have a fluorine atom,
n represents an integer of 1 to 4; when n is an integer of 2 to 4, a plurality of $R_{11}$ and a plurality of $R_{12}$ may be the same or different, and at least one $R_{11}$ represents a cyano group, a nitro group, a substituent represented by the formula (1A) below, or a substituent represented by the formula (1B) below,
L represents a single bond or a divalent linking group,
$X_1$ represents a hydrogen atom or an organic group,
$M^+$ represents an organic cation,
at least two of $R_{11}$, $R_{12}$, L, and $X_1$ may be bonded together to form a ring,

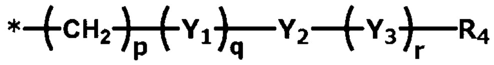

(1A)

in the formula (1A), $Y_1$ and $Y_3$ each independently represent -O- or $-NR_3-$, $R_3$ represents a hydrogen atom or an alkyl group, $Y_2$ represents -C(=O)- or $-SO_2-$, $R_4$ represents an alkyl group, a cycloalkyl group, or an aryl group, p represents an integer of 0 to 2, q and r each independently represent 0 or 1, * represents a bonding site,

$$*-CH_2-R_X \qquad (1B)$$

in the formula (1B), $R_X$ represents a cyano group or a nitro group, and * represents a bonding site.

[2] The actinic ray-sensitive or radiation-sensitive resin composition according to [1], wherein the onium salt represented by the formula (1) is represented by a formula (2) below:

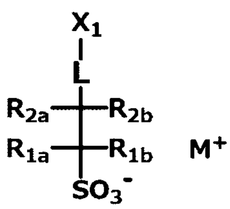

(2)

in the formula (2),

$R_{1a}$ and $R_{2a}$ each independently represent a hydrogen atom, a cyano group, a nitro group, a substituent represented by the formula (1A), or a substituent represented by the formula (1B), and at least one of $R_{1a}$ or $R_{2a}$ represents a cyano group, a nitro group, a substituent represented by the formula (1A), or a substituent represented by the formula (1B),
$R_{1b}$ and $R_{2b}$ each independently represent a hydrogen atom or a substituent which does not have a fluorine atom,
L, $X_1$, and $M^+$ respectively have the same meanings as L, $X_1$, and $M^+$ in the formula (1), and
at least two of $R_{1a}$, $R_{1b}$, $R_{2a}$, $R_{2b}$, L, and $X_1$ may be bonded together to form a ring.

[3] The actinic ray-sensitive or radiation-sensitive resin composition according to [2], wherein, in the formula (2), $R_{1a}$ represents a hydrogen atom, a cyano group, a nitro group, or a substituent represented by a formula (2A) below, $R_{2a}$ represents a cyano group, a nitro group, a substituent represented by the formula (2A) below, or a substituent represented by a formula (2B) below:

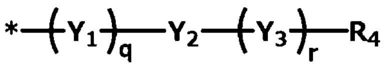

(2A)

in the formula (2A), $Y_1$ and $Y_3$ each independently represent -O- or $-NR_3-$, $R_3$ represents a hydrogen atom or an alkyl group, $Y_2$ represents -C(=O)- or $-SO_2-$, $R_4$ represents an alkyl group, a cycloalkyl group, or an aryl group, q and r each independently represent 0 or 1, * represents a bonding site,

**$*-CH_2-R_y$** (2B)

in the formula (2B), $R_Y$ represents a cyano group, a nitro group, or a substituent represented by the formula (2A), and * represents a bonding site.

[4] The actinic ray-sensitive or radiation-sensitive resin composition according to any one of [1] to [3], wherein the resin (C) does not have acid decomposability.

[5] The actinic ray-sensitive or radiation-sensitive resin composition according to any one of [1] to [4], wherein the resin (C) includes at least one of a repeating unit represented by a formula (3A) below or a repeating unit represented by a formula (3B):

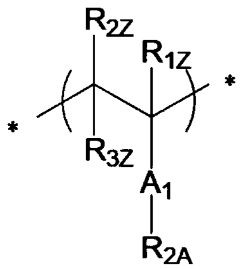

(3A)

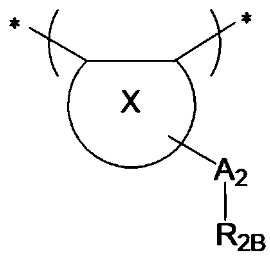

(3B)

in the formula (3A), $R_{1Z}$ represents a hydrogen atom, an alkyl group, a cycloalkyl group, or a cyano group;
$R_{2Z}$ and $R_{3Z}$ each independently represent a hydrogen atom or an alkyl group;
$A_1$ represents a divalent linking group;
$R_{2A}$ represents an organic group including two or more $CH_3$ partial structures; and
at least two of $R_{1Z}$ to $R_{3Z}$ and $A_1$ may be bonded together to form a ring, and
in the formula (3B), X represents an alicyclic group;
$A_2$ represents a divalent linking group; and
$R_{2B}$ represents an organic group including two or more $CH_3$ partial structures.

[6] The actinic ray-sensitive or radiation-sensitive resin composition according to any one of [1] to [5], wherein the resin (C) includes a repeating unit represented by a formula (3C) below and does not have acid decomposability,

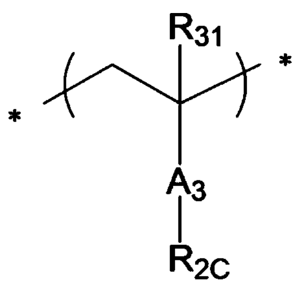

(3C)

in the formula (3C), $R_{31}$ represents a hydrogen atom, an alkyl group, a cycloalkyl group, or a cyano group, $A_3$

represents a divalent linking group, and $R_{2C}$ represents an organic group including two or more $CH_3$ partial structures.
[7] The actinic ray-sensitive or radiation-sensitive resin composition according to [2] or [3], wherein, in the formula (2), $R_{1a}$ represents a cyano group, a nitro group, or a substituent represented by the formula (2A).
[8] The actinic ray-sensitive or radiation-sensitive resin composition according to [7], wherein the onium salt represented by the formula (2) is represented by a formula (4) below:

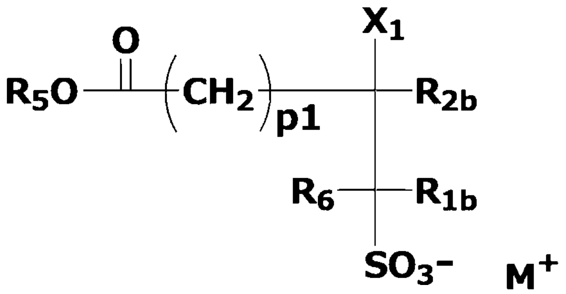

(4)

in the formula (4), $R_5$ represents an alkyl group, a cycloalkyl group, or an aryl group, p1 represents 0 or 1, $R_6$ represents a cyano group or a group represented by $-SO_2-R_7$, $R_7$ represents an alkyl group, a cycloalkyl group, or an aryl group, and $R_{1b}$, $R_{2b}$, $X_1$, and $M^+$ respectively have the same meanings as $R_{1b}$, $R_{2b}$, $X_1$, and $M^+$ in the formula (2).
[9] The actinic ray-sensitive or radiation-sensitive resin composition according to any one of [1] to [8], wherein a mass ratio ((C)/(B)) of a content of the resin (C) to a content of the onium salt (B) in the actinic ray-sensitive or radiation-sensitive resin composition is 0.05 to 3.0.
[10] The actinic ray-sensitive or radiation-sensitive resin composition according to any one of [1] to [9], wherein a fluorine atom content relative to the total solid content of the actinic ray-sensitive or radiation-sensitive resin composition is 1.00 mass% or less.
[11] A resist film formed using the actinic ray-sensitive or radiation-sensitive resin composition according to any one of [1] to [10].
[12] A pattern forming method including:

a step of using the actinic ray-sensitive or radiation-sensitive resin composition according to any one of [1] to [10] to form a resist film on a substrate;
a step of exposing the resist film; and
a step of developing the exposed resist film using a developer.

[13] A method for producing an electronic device, the method including the pattern forming method according to [12].

The present invention can provide an actinic ray-sensitive or radiation-sensitive resin composition that has high LWR performance and can achieve reduction in the amount of post-development residue.
The present invention can also provide a resist film, a pattern forming method, and a method for producing an electronic device that use the actinic ray-sensitive or radiation-sensitive resin composition.

## DESCRIPTION OF THE PREFERRED EMBODIMENTS

Hereinafter, the present invention will be described in detail.
In the following descriptions, features may be described on the basis of representative embodiments of the present invention; however, the present invention is not limited to such embodiments.
In this Specification, "actinic ray" or "radiation" means, for example, the emission line spectrum of a mercury lamp, far-ultraviolet rays represented by excimer lasers, extreme ultraviolet rays (EUV: Extreme Ultraviolet), X-rays, soft X-rays, or an electron beam (EB: Electron Beam).
In this Specification, "light" means an actinic ray or a radiation.
In this Specification, "exposure" includes, unless otherwise specified, not only exposure using, for example, the emission line spectrum of a mercury lamp, far-ultraviolet rays represented by excimer lasers, extreme ultraviolet rays, X-rays, or EUV, but also patterning using a corpuscular beam such as an electron beam or an ion beam.
In this Specification, "a value 'to' another value" is used to mean that it includes the value and the other value as the lower limit value and the upper limit value.
In this Specification, (meth)acrylate represents at least one of acrylate or methacrylate. (Meth)acrylic acid represents at least one of acrylic acid or methacrylic acid.
In this Specification, for resins, the weight-average molecular weight (Mw), the number-average molecular

weight (Mn), and the dispersity (also referred to as molecular weight distribution) (Mw/Mn) are defined as polystyrene-equivalent values measured, using a GPC (Gel Permeation Chromatography) apparatus (HLC-8120GPC, manufactured by Tosoh Corporation), by GPC measurement (solvent: tetrahydrofuran, flow rate (sample injection amount): 10 μL, column: TSK gel Multipore HXL-M, manufactured by Tosoh Corporation, column temperature: 40°C, flow rate: 1.0 mL/min, detector: differential refractive index detector (Refractive Index Detector)).

In this Specification, for written forms of groups (atomic groups), written forms without referring to substituted or unsubstituted encompass, in addition to groups not having a substituent, groups including a substituent without departing from the spirit and scope of the present invention. For example, "alkyl group" encompasses not only alkyl groups not having a substituent (unsubstituted alkyl groups), but also alkyl groups having a substituent (substituted alkyl groups). In this Specification, "organic group" refers to a group including at least one carbon atom.

The substituent is preferably a monovalent substituent unless otherwise specified. Examples of the substituent include monovalent non-metallic atomic groups except for the hydrogen atom and, for example, can be selected from the group consisting of the following Substituents T.

Substituents T

Examples of the substituents T include halogen atoms such as a fluorine atom, a chlorine atom, a bromine atom, and an iodine atom; alkoxy groups such as a methoxy group, an ethoxy group, and a tert-butoxy group; cycloalkyloxy groups; aryloxy groups such as a phenoxy group and a p-tolyloxy group; alkoxycarbonyl groups such as a methoxycarbonyl group and a butoxycarbonyl group; cycloalkyloxycarbonyl groups; aryloxycarbonyl groups such as a phenoxycarbonyl group; acyloxy groups such as an acetoxy group, a propionyloxy group, and a benzoyloxy group; acyl groups such as an acetyl group, a benzoyl group, an isobutyryl group, an acryloyl group, a methacryloyl group, and a methoxalyl group; a sulfanyl group; alkylsulfanyl groups such as a methylsulfanyl group and a tert-butylsulfanyl group; arylsulfanyl groups such as a phenylsulfanyl group and a p-tolylsulfanyl group; alkyl groups; alkenyl groups; cycloalkyl groups; aryl groups; aromatic heterocyclic groups; a hydroxy group; a carboxyl group; a formyl group; a sulfo group; a cyano group; alkylaminocarbonyl groups; arylaminocarbonyl groups; a sulfonamide group; a silyl group; an amino group; and a carbamoyl group. When such a substituent can additionally have one or more substituents, a group having, as the additional substituents, one or more substituents selected from the group consisting of the substituents described above (such as a monoalkylamino group, a dialkylamino group, an arylamino group, or a trifluoromethyl group) is also included in examples of the substituents T.

Note that, in the cases of descriptions of not having fluorine atoms such as the "substituent not having fluorine atoms" in $R_{1b}$ and $R_{2b}$ in the formula (2), the substituents T do not include fluorine atoms.

In this Specification, the bonding directions of divalent groups described are not limited unless otherwise specified. For example, in a compound represented by a formula "X-Y-Z" where Y is -COO-, Y may be -CO-O- or may be -O-CO-. The compound may be "X-CO-O-Z" or may be "X-O-CO-Z".

In this Specification, the acid dissociation constant (pKa) represents pKa in an aqueous solution, specifically, a value determined using the following Software package 1, on the basis of the Hammett's substituent constant and the database of values in publicly known documents, by calculation. All the values of pKa described in this Specification are values determined by calculation using this software package.

Software package 1: Advanced Chemistry Development (ACD/Labs) Software V8.14 for Solaris (1994-2007 ACD/Labs)

Alternatively, pKa can be determined by a molecular orbital calculation method. Specifically, this method may be a calculation method of calculating $H^+$ dissociation free energy in an aqueous solution based on a thermodynamic cycle. The $H^+$ dissociation free energy can be calculated by a method such as DFT (density functional theory); however, the calculation method is not limited thereto and various other methods have been reported in documents and the like. Note that there are a plurality of pieces of software for performing DFT, such as Gaussian 16.

In this Specification, as described above, pKa refers to a value determined using Software package 1, on the basis of the Hammett's substituent constant and the database of values in publicly known documents, by calculation; however, when use of this method cannot determine pKa, a value determined on the basis of DFT (density function theory) using Gaussian 16 is employed.

In this Specification, as described above, pKa refers to "pKa in an aqueous solution"; however, when pKa in an aqueous solution cannot be determined, "pKa in a dimethyl sulfoxide (DMSO) solution" is employed.

In this Specification, "solid content" means components forming the actinic ray-sensitive or radiation-sensitive film and does not include solvents. As long as a component forms the actinic ray-sensitive or radiation-sensitive film, even when the component has the form of liquid, it is regarded as the solid content.

Actinic ray-sensitive or radiation-sensitive resin composition

An actinic ray-sensitive or radiation-sensitive resin composition of the present invention (also referred to as "the composition of the present invention") is an actinic ray-sensitive or radiation-sensitive resin composition containing a resin (A) that is subjected to action of an acid to undergo an increase in polarity, an onium salt (B) represented by a formula (1) below, and a resin (C) satisfying all of (i) to (iii) below:

(i) no fluorine atoms are included,
(ii) an SP value [$SP_C$] of the resin (C) is smaller than an SP value [$SP_A$] of the resin (A) and is 17.00 or less, and
(iii) a content relative to a total solid content of the actinic ray-sensitive or radiation-sensitive resin composition is 0.01 to 10 mass%,

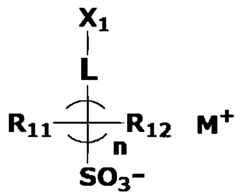

(1)

in the formula (1),

$R_{11}$ represents a hydrogen atom, a cyano group, a nitro group, a substituent represented by a formula (1A) below, or a substituent represented by a formula (1B) below,
$R_{12}$ represents a hydrogen atom or a substituent not having fluorine atoms,
n represents an integer of 1 to 4; when n is an integer of 2 to 4, a plurality of $R_{11}$ and a plurality of $R_{12}$ may be the same or different, and at least one $R_{11}$ represents a cyano group, a nitro group, a substituent represented by the formula (1A) below, or a substituent represented by the formula (1B) below,
L represents a single bond or a divalent linking group,
$X_1$ represents a hydrogen atom or an organic group,
$M^+$ represents an organic cation,
at least two of $R_{11}$, $R_{12}$, L, and $X_1$ may be bonded together to form a ring,

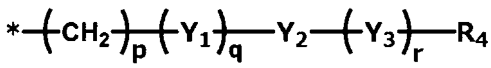

(1A)

in the formula (1A), $Y_1$ and $Y_3$ each independently represent -O- or $-NR_3-$, $R_3$ represents a hydrogen atom or an alkyl group, $Y_2$ represents -C(=O)- or $-SO_2-$, $R_4$ represents an alkyl group, a cycloalkyl group, or an aryl group, p represents an integer of 0 to 2, q and r each independently represent 0 or 1, * represents a bonding site,

$$*-CH_2-R_X \qquad (1B)$$

in the formula (1B), $R_X$ represents a cyano group or a nitro group, and * represents a bonding site.

The mechanism by which the composition of the present invention has high LWR performance and can achieve reduction in the amount of post-development residue is not clear, but is inferred by the inventors of the present invention as follows. However, the present invention is not limited at all by the following inferred mechanism.

The onium salt (B) contained in the composition of the present invention and represented by the formula (1) has, as $R_{11}$ in the formula (1), at least one of a cyano group, a nitro group, a substituent represented by the formula (1A), or a substituent represented by the formula (1B). These groups having electron-withdrawing properties are hydrophilic and have high compatibility with the resin (A) that is subjected to action of an acid to undergo an increase in polarity, so that the onium salt (B) is homogeneously dispersed, and the variation in the acid generated from the onium salt (B) is suppressed; as a result, high LWR performance is exhibited, inferentially. In addition, the onium salt represented by the formula (1) is homogeneously dispersed, so that ionic aggregate that causes residue is less likely to be generated and the amount of post-development residue can be inferentially reduced. Furthermore, in the onium salt represented by the formula (1), a cyano group, a nitro group, a substituent represented by the formula (1A), or a substituent represented by the formula (1B), which have electron-withdrawing properties, is bonded to the carbon atom to which $-SO_3^-$ is bonded and the carbon atom bonded to the above-described carbon atom, and the acid strength of the acid generated from the onium salt can also be

ensured.

In the case of using a resist composition in which a photoacid generator and a hydrophobic resin are used in combination, in the film thickness direction of a resist film formed from the resist composition, the hydrophobic resin is localized in a surface on a side opposite from the substrate and the photoacid generator having high hydrophilicity is relatively localized on the substrate side, inferentially.

The resin (C) included in the composition of the present invention has higher hydrophobicity than the resin (A) and is inferentially localized in a surface on a side opposite from the substrate in the film thickness direction of the resist film; however, the resin (C) does not include fluorine atoms and hence does not have as high hydrophobicity as fluorine-containing hydrophobic resins generally used in resist compositions, and is inferentially localized moderately on a surface side on a side opposite from the substrate. As a result, the dispersibility of the onium salt (B) in the film thickness direction is improved, and the LWR performance is further improved, inferentially.

The composition of the present invention is typically a resist composition, and may be a positive resist composition or may be a negative resist composition. The composition of the present invention may be a resist composition for alkali development or may be a resist composition for organic-solvent development.

The composition of the present invention may be a chemical amplification resist composition or may be a non-chemical amplification resist composition. The composition of the present invention is typically a chemical amplification resist composition.

The composition of the present invention can be used to form an actinic ray-sensitive or radiation-sensitive film. The actinic ray-sensitive or radiation-sensitive film formed using the composition of the present invention is typically a resist film.

Hereinafter, first, various components of the composition of the present invention will be described in detail.

Resin (A) that is subjected to action of acid to undergo increase in polarity

The composition of the present invention contains a resin (A) that is subjected to action of an acid to undergo an increase in polarity (also referred to as "resin (A)").

The resin (A) ordinarily includes a group that is decomposed by action of an acid to undergo an increase in polarity (also referred to as an "acid-decomposable group"), and preferably includes a repeating unit having an acid-decomposable group. When the resin (A) has an acid-decomposable group, in a pattern forming method in this Specification, typically, in the case of employing a developer that is an alkali developer, a positive-type pattern is suitably formed or, in the case of employing a developer that is an organic-based developer, a negative-type pattern is suitably formed.

The repeating unit having an acid-decomposable group is preferably, in addition to the repeating unit having an acid-decomposable group, a repeating unit having an acid-decomposable group including an unsaturated bond.

Repeating unit having acid-decomposable group

The acid-decomposable group refers to a group that is decomposed by action of an acid to generate a polar group. The acid-decomposable group preferably has a structure in which the polar group is protected with a group (leaving group) that leaves by action of an acid. Thus, the resin (A) has a repeating unit having a group that is decomposed by action of an acid to generate a polar group. The resin having the repeating unit is subjected to action of an acid to undergo an increase in polarity to undergo an increase in the degree of solubility in the alkali developer, but undergo a decrease in the degree of solubility in organic solvents.

The polar group is preferably an alkali-soluble group; examples include acidic groups such as a carboxyl group, a phenolic hydroxyl group, fluorinated alcohol groups, a sulfonic acid group, a phosphoric acid group, a sulfonamide group, a sulfonylimide group, (alkylsulfonyl)(alkylcarbonyl)methylene groups, (alkylsulfonyl)(alkylcarbonyl)imide groups, bis(alkylcarbonyl)methylene groups, bis(alkylcarbonyl)imide groups, bis(alkylsulfonyl)methylene groups, bis(alkylsulfonyl)imide groups, tris(alkylcarbonyl)methylene groups, and tris(alkylsulfonyl)methylene groups, and an alcoholic hydroxyl group.

In particular, the polar group is preferably a carboxyl group, a phenolic hydroxy group, a fluorinated alcohol group (preferably a hexafluoroisopropanol group), or a sulfonic acid group.

Examples of the group that leaves by action of an acid include groups represented by formulas (Y1) to (Y4).

formula (Y1): $-C(Rx_1)(Rx_2)(Rx_3)$

formula (Y2): $-C(=O)OC(Rx_1)(Rx_2)(Rx_3)$

formula (Y3): $-C(R_{36})(R_{37})(OR_{38})$

formula (Y4): -C(Rn)(H)(Ar)

In the formula (Y1) and the formula (Y2), $Rx_1$ to $Rx_3$ each independently represent an alkyl group (linear or branched), a cycloalkyl group (monocyclic or polycyclic), an alkenyl group (linear or branched), or an aryl group (monocyclic or polycyclic). Note that, when $Rx_1$ to $Rx_3$ are all alkyl groups (linear or branched), at least two of $Rx_1$ to $Rx_3$ are preferably methyl groups.

In particular, $Rx_1$ to $Rx_3$ preferably each independently represent a linear or branched alkyl group, and $Rx_1$ to $Rx_3$ more preferably each independently represent a linear alkyl group.

Two of $Rx_1$ to $Rx_3$ may be bonded together to form a monocycle or a polycycle.

For $Rx_1$ to $Rx_3$, the alkyl group is preferably an alkyl group having 1 to 5 carbon atoms such as a methyl group, an ethyl group, an n-propyl group, an isopropyl group, an n-butyl group, an isobutyl group, or a t-butyl group.

For $Rx_1$ to $Rx_3$, the cycloalkyl group is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

For $Rx_1$ to $Rx_3$, the aryl group is preferably an aryl group having 6 to 10 carbon atoms, and may be, for example, a phenyl group, a naphthyl group, or an anthryl group.

For $Rx_1$ to $Rx_3$, the alkenyl group is preferably a vinyl group.

The ring formed by bonding together two of $Rx_1$ to $Rx_3$ is preferably a cycloalkyl group. The cycloalkyl group formed by bonding together two of $Rx_1$ to $Rx_3$ is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group, and more preferably a monocyclic cycloalkyl group having 5 to 6 carbon atoms.

In the cycloalkyl group formed by bonding together two of $Rx_1$ to $Rx_3$, one of methylene groups constituting the ring may be replaced by a heteroatom such as an oxygen atom, a group including a heteroatom such as a carbonyl group, or a vinylidene group. In the cycloalkyl group, one or more ethylene groups constituting the cycloalkane ring may be replaced by vinylene groups.

The group represented by the formula (Y1) or the formula (Y2) preferably has a form in which, for example, $Rx_1$ is a methyl group or an ethyl group, and $Rx_2$ and $Rx_3$ are bonded together to form the above-described cycloalkyl group.

When the actinic ray-sensitive or radiation-sensitive resin composition is, for example, a resist composition used for EUV exposure, the alkyl groups, the cycloalkyl groups, the alkenyl groups, and the aryl groups represented by $Rx_1$ to $Rx_3$ and the ring formed by bonding together two of $Rx_1$ to $Rx_3$ also preferably further have, as a substituent, a fluorine atom or an iodine atom.

In the formula (Y3), $R_{36}$ to $R_{38}$ each independently represent a hydrogen atom or a monovalent organic group. $R_{37}$ and $R_{38}$ may be bonded together to form a ring. The monovalent organic group may be an alkyl group, a cycloalkyl group, an aryl group, an aralkyl group, or an alkenyl group. $R_{36}$ is also preferably a hydrogen atom.

Note that the alkyl group, the cycloalkyl group, the aryl group, and the aralkyl group may include a heteroatom such as an oxygen atom and/or a group including a heteroatom such as a carbonyl group. For example, in the alkyl group, the cycloalkyl group, the aryl group, and the aralkyl group, one or more methylene groups may be replaced by a heteroatom such as an oxygen atom and/or a group including a heteroatom such as a carbonyl group.

$R_{38}$ and another substituent of the main chain of the repeating unit may be bonded together to form a ring. The group formed by bonding together $R_{38}$ and another substituent of the main chain of the repeating unit is preferably an alkylene group such as a methylene group.

When the actinic ray-sensitive or radiation-sensitive resin composition is, for example, a resist composition used for EUV exposure, the monovalent organic groups represented by $R_{36}$ to $R_{38}$ and the ring formed by bonding together $R_{37}$ and $R_{38}$ also preferably further have, as a substituent, a fluorine atom or an iodine atom.

The formula (Y3) is preferably a group represented by the following formula (Y3-1).

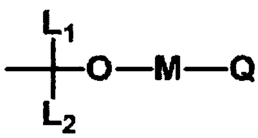

(Y3-1)

$L_1$ and $L_2$ each independently represent a hydrogen atom, an alkyl group, a cycloalkyl group, an aryl group, or a group that is a combination of the foregoing (for example, a group that is a combination of an alkyl group and an aryl group).

M represents a single bond or a divalent linking group.

Q represents an alkyl group that may include a heteroatom, a cycloalkyl group that may include a heteroatom, an aryl group that may include a heteroatom, an amino group, an ammonium group, a mercapto group, a cyano group, an aldehyde group, or a group that is a combination of the foregoing (for example, a group that is a combination of an alkyl group and a cycloalkyl group).

In the alkyl group and the cycloalkyl group, for example, one of methylene groups may be replaced by a heteroatom such as an oxygen atom or a group including a heteroatom such as a carbonyl group.

Note that one of $L_1$ and $L_2$ is preferably a hydrogen atom and the other is preferably an alkyl group, a cycloalkyl group, an aryl group, or a group that is a combination of an alkylene group and an aryl group.

At least two of Q, M, and $L_1$ may be bonded together to form a ring (preferably a 5-membered or 6-membered ring).

From the viewpoint of forming finer patterns, $L_2$ is preferably a secondary or tertiary alkyl group, and more preferably a tertiary alkyl group. Examples of the secondary alkyl group include an isopropyl group, a cyclohexyl group, and a norbornyl group; examples of the tertiary alkyl group include a tert-butyl group and an adamantane group. In such examples, Tg (glass transition temperature) and activation energy are increased, so that film hardness is ensured and fogging can also be suppressed.

When the actinic ray-sensitive or radiation-sensitive resin composition is, for example, a resist composition used for EUV exposure, the alkyl groups, cycloalkyl groups, aryl groups, and groups that are combinations of the foregoing represented by $L_1$ and $L_2$ also preferably further have, as a substituent, a fluorine atom or an iodine atom. The alkyl groups, the cycloalkyl groups, the aryl groups, and the aralkyl groups also preferably include, in addition to a fluorine atom and an iodine atom, a heteroatom such as an oxygen atom. Specifically, in the alkyl groups, the cycloalkyl groups, the aryl groups, and the aralkyl groups, for example, one of methylene groups may be replaced by a heteroatom such as an oxygen atom or a group including a heteroatom such as a carbonyl group.

When the actinic ray-sensitive or radiation-sensitive resin composition is, for example, a resist composition used for EUV exposure, in the alkyl group that may include a heteroatom, cycloalkyl group that may include a heteroatom, aryl group that may include a heteroatom, amino group, ammonium group, mercapto group, cyano group, aldehyde group, and group that is a combination of the foregoing represented by Q, such a heteroatom is also preferably a heteroatom selected from the group consisting of a fluorine atom, an iodine atom, and an oxygen atom.

In the formula (Y4), Ar represents an aromatic ring group. Rn represents an alkyl group, a cycloalkyl group, or an aryl group. Rn and Ar may be bonded together to form a non-aromatic ring. Ar is preferably an aryl group.

When the actinic ray-sensitive or radiation-sensitive resin composition is, for example, a resist composition used for EUV exposure, the aromatic ring group represented by Ar and the alkyl group, cycloalkyl group, and aryl group represented by Rn also preferably have, as a substituent, a fluorine atom or an iodine atom.

From the viewpoint of providing a repeating unit having high acid-decomposability, in the leaving group protecting the polar group, when a non-aromatic ring is directly bonded to the polar group (or its residue), in the non-aromatic ring, a ring-member atom adjacent to a ring-member atom directly bonded to the polar group (or its residue) also preferably does not have, as a substituent, a halogen atom such as a fluorine atom.

Alternatively, the group that leaves by action of an acid may be a 2-cyclopentenyl group having a substituent (such as an alkyl group) such as a 3-methyl-2-cyclopentenyl group, or a cyclohexyl group having a substituent (such as an alkyl group) such as a 1,1,4,4-tetramethylcyclohexyl group.

The repeating unit having an acid-decomposable group is also preferably a repeating unit represented by a formula (A).

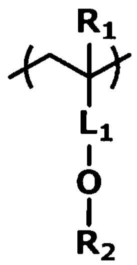

(A)

$L_1$ represents a divalent linking group that may have a fluorine atom or an iodine atom; $R_1$ represents a hydrogen atom, a fluorine atom, an iodine atom, an alkyl group that may have a fluorine atom or an iodine atom, or an aryl group that may have a fluorine atom or an iodine atom; $R_2$ represents a leaving group that leaves by action of an acid and that may have a fluorine atom or an iodine atom. Note that at least one of $L_1$, $R_1$, or $R_2$ has a fluorine atom or an iodine atom.

Examples of the divalent linking group that is represented by $L_1$ and may have a fluorine atom or an iodine atom include -CO-, -O-, -S-, -SO-, $-SO_2-$, hydrocarbon groups that may have a fluorine atom or an iodine atom (for example, alkylene groups, cycloalkylene groups, alkenylene groups, and arylene groups), and linking groups provided by linking together a plurality of the foregoing. In particular, $L_1$ is preferably -CO-, an arylene group, or an -arylene group-alkylene group having a fluorine atom or an iodine atom-, and more preferably -CO- or an -arylene group-alkylene group having a fluorine atom or an iodine atom-.

The arylene group is preferably a phenylene group.

The alkylene group may be linear or may be branched. The number of carbon atoms of the alkylene group is not particularly limited, but is preferably 1 to 10, and more preferably 1 to 3.

In the alkylene group having a fluorine atom or an iodine atom, the total number of fluorine atoms and iodine atoms is not particularly limited, but is preferably 2 or more, more preferably 2 to 10, and still more preferably 3 to 6.

The alkyl group represented by $R_1$ may be linear or may be branched. The number of carbon atoms of the alkyl group is not particularly limited, but is preferably 1 to 10, and more preferably 1 to 3.

In the alkyl group represented by $R_1$ and having a fluorine atom or an iodine atom, the total number of fluorine atoms and iodine atoms is not particularly limited, but is preferably 1 or more, more preferably 1 to 5, and still more preferably 1 to 3.

The alkyl group represented by $R_1$ may include a heteroatom other than halogen atoms, such as an oxygen atom.

Examples of the leaving group that is represented by $R_2$ and may have a fluorine atom or an iodine atom include leaving groups that are represented by the above-described formulas (Y1) to (Y4) and that have a fluorine atom or an iodine atom.

The repeating unit having an acid-decomposable group is also preferably a repeating unit represented by a formula (AI).

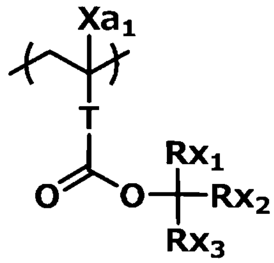

(AI)

In the formula (AI), $Xa_1$ represents a hydrogen atom or an alkyl group that may have a substituent. T represents a single bond or a divalent linking group. $Rx_1$ to $Rx_3$ each independently represent an alkyl group (linear or branched), a cycloalkyl group (monocyclic or polycyclic), an alkenyl group (linear or branched), or an aryl group (monocyclic or polycyclic). Note that, when $Rx_1$ to $Rx_3$ are all alkyl groups (linear or branched), at least two of $Rx_1$ to $Rx_3$ are preferably methyl groups.

Two of $Rx_1$ to $Rx_3$ may be bonded together to form a monocycle or a polycycle (such as a monocyclic or polycyclic cycloalkyl group).

The alkyl group that is represented by $Xa_1$ and may have a substituent may be, for example, a methyl group or a group represented by $-CH_2-R_{11}$. $R_{11}$ represents a halogen atom (such as a fluorine atom), a hydroxy group, or a monovalent organic group. The monovalent organic group represented by $R_{11}$ is, for example, an alkyl group that has 5 or less carbon atoms and that may be substituted with a halogen atom, an acyl group that has 5 or less carbon atoms and that may be substituted with a halogen atom, or an alkoxy group that has 5 or less carbon atoms and that may be substituted with a halogen atom, and preferably an alkyl group having 3 or less carbon atoms, and more preferably a methyl group. $Xa_1$ is preferably a hydrogen atom, a methyl group, a trifluoromethyl group, or a hydroxymethyl group.

For T, the divalent linking group may be an alkylene group, an aromatic ring group, a -COO-Rt- group, or an -O-Rt- group. In the formulas, Rt represent an alkylene group or a cycloalkylene group.

T is preferably a single bond or a -COO-Rt- group. When T represents a -COO-Rt- group, Rt is preferably an alkylene group having 1 to 5 carbon atoms, and more preferably a $-CH_2$-group, a $-(CH_2)_2-$ group, or a $-(CH_2)_3-$ group.

For $Rx_1$ to $Rx_3$, the alkyl group is preferably an alkyl group having 1 to 4 carbon atoms such as a methyl group, an ethyl group, an n-propyl group, an isopropyl group, an n-butyl group, an isobutyl group, or a t-butyl group.

For $Rx_1$ to $Rx_3$, the cycloalkyl group is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

For $Rx_1$ to $Rx_3$, the aryl group is preferably an aryl group having 6 to 10 carbon atoms and may be, for example, a phenyl group, a naphthyl group, or an anthryl group.

For $Rx_1$ to $Rx_3$, the alkenyl group is preferably a vinyl group.

The cycloalkyl group formed by bonding together two of $Rx_1$ to $Rx_3$ is preferably a monocyclic cycloalkyl group such as a cyclopentyl group or a cyclohexyl group. Also preferred are polycyclic cycloalkyl groups such as a norbornyl group, a tetracyclodecanyl group, a tetracyclododecanyl group, and an adamantyl group. In particular, preferred is a monocyclic cycloalkyl group having 5 to 6 carbon atoms.

In the cycloalkyl group formed by bonding together two of $Rx_1$ to $Rx_3$, for example, one of methylene groups constituting the ring may be replaced by a heteroatom such as an oxygen atom, a group including a heteroatom such as a

carbonyl group, or a vinylidene group. In the cycloalkyl group, one or more of the ethylene groups constituting the cycloalkane ring may be replaced by vinylene groups.

The repeating unit represented by the formula (AI) preferably has a form in which, for example, $Rx_1$ is a methyl group or an ethyl group, and $Rx_2$ and $Rx_3$ are bonded together to form the above-described cycloalkyl group.

When the above-described groups each have a substituent, examples of the substituent include alkyl groups (having 1 to 4 carbon atoms), halogen atoms, a hydroxyl group, alkoxy groups (having 1 to 4 carbon atoms), a carboxyl group, and alkoxycarbonyl groups (having 2 to 6 carbon atoms). The substituent preferably has 8 or less carbon atoms.

The repeating unit represented by the formula (AI) is preferably an acid-decomposable (meth)acrylic acid tertiary alkyl ester-based repeating unit (the repeating unit where $Xa_1$ represents a hydrogen atom or a methyl group and T represents a single bond).

The following are non-limiting specific examples of the repeating unit having an acid-decomposable group. Note that, in the formulas, $Xa_1$ represent H, $CH_3$, $CF_3$, or $CH_2OH$, and Rxa and Rxb each independently represent a linear or branched alkyl group having 1 to 5 carbon atoms.

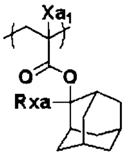
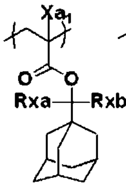
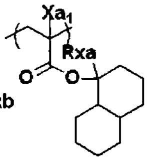
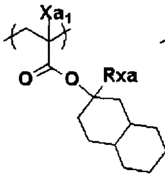
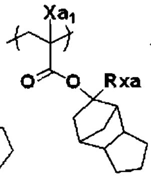
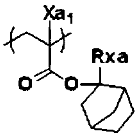
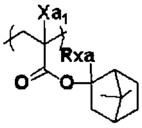
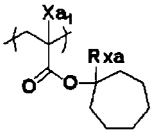
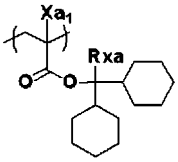
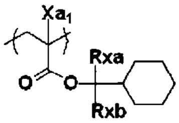
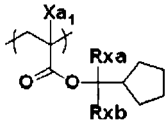
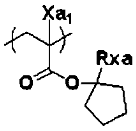
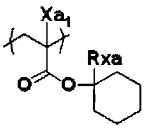
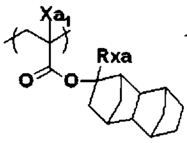
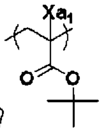
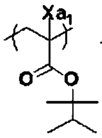
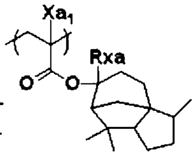
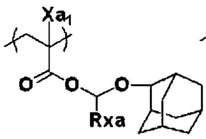
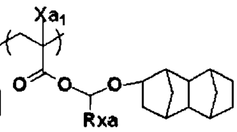
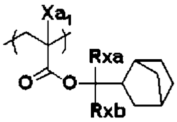
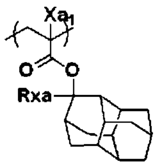
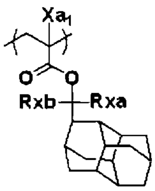
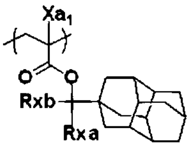
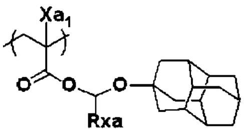
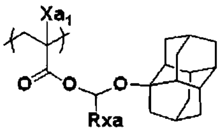

The resin (A) may have, as a repeating unit having an acid-decomposable group, a repeating unit having an acid-decomposable group including an unsaturated bond.

The repeating unit having an acid-decomposable group including an unsaturated bond is preferably a repeating unit represented by a formula (B).

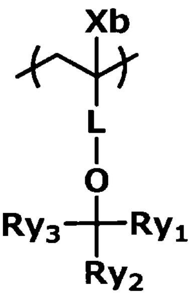
(B)

In the formula (B), Xb represents a hydrogen atom, a halogen atom, or an alkyl group that may have a substituent. L represents a single bond or a divalent linking group that may have a substituent. $Ry_1$ to $Ry_3$ each independently represent a linear or branched alkyl group, a monocyclic or polycyclic cycloalkyl group, an alkenyl group, an alkynyl group, or a monocyclic or polycyclic aryl group. Note that at least one of $Ry_1$ to $Ry_3$ represents an alkenyl group, an alkynyl group, a monocyclic or polycyclic cycloalkenyl group, or a monocyclic or polycyclic aryl group.

Two of $Ry_1$ to $Ry_3$ may be bonded together to form a monocycle or a polycycle (such as a monocyclic or polycyclic cycloalkyl group or cycloalkenyl group).

For Xb, the alkyl group that may have a substituent may be, for example, a methyl group or a group represented by $-CH_2-R_{11}$. $R_{11}$ represents a halogen atom (such as a fluorine atom), a hydroxy group, or a monovalent organic group such as an alkyl group that has 5 or less carbon atoms and that may be substituted with a halogen atom, an acyl group that has 5 or less carbon atoms and that may be substituted with a halogen atom, or an alkoxy group that has 5 or less carbon atoms and that may be substituted with a halogen atom, is preferably an alkyl group having 3 or less carbon atoms, and more preferably a methyl group. Xb is preferably a hydrogen atom, a fluorine atom, a methyl group, a trifluoromethyl group, or a hydroxymethyl group.

For L, the divalent linking group may be an -Rt- group, a -CO- group, a -COO-Rt-group, a -COO-Rt-CO- group, an -Rt-CO- group, or an -O-Rt- group. In the formulas, Rt represent an alkylene group, a cycloalkylene group, or an aromatic ring group, and is preferably an aromatic ring group.

L is preferably an -Rt- group, a -CO- group, a -COO-Rt-CO- group, or an -Rt-CO- group. Rt may have a substituent such as a halogen atom, a hydroxy group, or an alkoxy group.

For $Ry_1$ to $Ry_3$, the alkyl group is preferably an alkyl group having 1 to 4 carbon atoms such as a methyl group, an ethyl group, an n-propyl group, an isopropyl group, an n-butyl group, an isobutyl group, or a t-butyl group.

For $Ry_1$ to $Ry_3$, the cycloalkyl group is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

For $Ry_1$ to $Ry_3$, the aryl group is preferably an aryl group having 6 to 10 carbon atoms, and may be, for example, a phenyl group, a naphthyl group, or an anthryl group.

For $Ry_1$ to $Ry_3$, the alkenyl group is preferably a vinyl group.

For $Ry_1$ to $Ry_3$, the alkynyl group is preferably an ethynyl group.

For $Ry_1$ to $Ry_3$, the cycloalkenyl group is preferably a structure in which a monocyclic cycloalkyl group such as a cyclopentyl group or a cyclohexyl group includes partially a double bond.

The cycloalkyl group formed by bonding together two of $Ry_1$ to $Ry_3$ is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group. In particular, more preferred is a monocyclic cycloalkyl group having 5 to 6 carbon atoms.

In the cycloalkyl group or the cycloalkenyl group formed by bonding together two of $Ry_1$ to $Ry_3$, for example, one of methylene groups constituting the ring may be replaced by a heteroatom such as an oxygen atom, a group including a heteroatom such as a carbonyl group, a $-SO_2-$ group, or a $-SO_3-$ group, a vinylidene group, or a combination of the foregoing. In the cycloalkyl group or the cycloalkenyl group, one or more ethylene groups constituting the cycloalkane ring or the cycloalkene ring may be replaced by vinylene groups.

The repeating unit represented by the formula (B) preferably has a form in which, for example, $Ry_1$ is a methyl group, an ethyl group, a vinyl group, an allyl group, or an aryl group, and $Ry_2$ and $Ry_3$ are bonded together to form the above-described cycloalkyl group or cycloalkenyl group.

When the above-described groups each have a substituent, examples of the substituent include alkyl groups (having 1 to 4 carbon atoms), halogen atoms, a hydroxyl group, alkoxy groups (having 1 to 4 carbon atoms), a carboxyl group, and alkoxycarbonyl groups (having 2 to 6 carbon atoms). The substituent preferably has 8 or less carbon atoms.

The repeating unit represented by the formula (B) is preferably an acid-decomposable (meth)acrylic acid tertiary ester-based repeating unit (the repeating unit where Xb represents a hydrogen atom or a methyl group, and L represents a -CO- group), an acid-decomposable hydroxystyrene tertiary alkyl ether-based repeating unit (the repeating unit where Xb represents a hydrogen atom or a methyl group, and L represents a phenyl group), or an acid-decomposable styrenecarboxylic acid tertiary ester-based repeating unit (the repeating unit where Xb represents a hydrogen atom or a methyl group, and L represents an -Rt-CO- group (where Rt is an aromatic group)).

The content of the repeating unit having an acid-decomposable group including an unsaturated bond relative to all the repeating units in the resin (A) is preferably 15 mol% or more, more preferably 20 mol% or more, and still more preferably 30 mol% or more. The upper limit value relative to all the repeating units in the resin (A) is preferably 80 mol% or less, more preferably 70 mol% or less, and still more preferably 60 mol% or less.

Specific examples of the repeating unit having an acid-decomposable group including an unsaturated bond include, for example, the repeating units described in [0067] to [0071] of WO2022/024928A. The above description is incorporated herein.

The content of the repeating unit having an acid-decomposable group relative to all the repeating units in the resin (A) is preferably 15 mol% or more, more preferably 20 mol% or more, and still more preferably 30 mol% or more. The upper limit value relative to all the repeating units in the resin (A) is preferably 90 mol% or less, more preferably 80 mol% or less, still more preferably 70 mol% or less, and particularly preferably 60 mol% or less.

The resin (A) may include at least one repeating unit species selected from the group consisting of the following Group A and/or at least one repeating unit species selected from the group consisting of the following Group B:

Group A: a group consisting of the following repeating units (20) to (25),
(20) a repeating unit (described later) having an acid group;
(21) a repeating unit (described later) not having an acid-decomposable group or an acid group, but having a fluorine atom, a bromine atom, or an iodine atom;
(22) a repeating unit (described later) having a lactone group, a sultone group, or a carbonate group;
(23) a repeating unit (described later) having a photoacid generation group;
(24) a repeating unit (described later) represented by a formula (V-1) or a formula (V-2) below; and
(25) a repeating unit for lowering the mobility of the main chain.

Note that the repeating units described later and represented by a formula (A) to a formula (E) correspond to the repeating unit (25) for lowering the mobility of the main chain.

Group B: a group consisting of the following repeating units (30) to (32),

(30) a repeating unit (described later) having at least one group species selected from the group consisting of a lactone group, a sultone group, a carbonate group, a hydroxy group, a cyano group, and an alkali-soluble group;
(31) a repeating unit (described later) having an alicyclic hydrocarbon structure and not exhibiting acid-decomposability; and
(32) a repeating unit (described later) not having a hydroxy group or a cyano group and represented by a formula (III).

The resin (A) preferably has an acid group and preferably includes a repeating unit having an acid group as described later. Note that the definition of the acid group will be described in a later part together with preferred examples of the repeating unit having an acid group. When the resin (A) has an acid group, a better interaction between the resin (A) and the acid generated from the photoacid generator is provided. This results in further suppression of diffusion of the acid, so that a pattern having a more square profile can be formed.

The resin (A) may have at least one repeating unit species selected from the group consisting of Group A above. When the actinic ray-sensitive or radiation-sensitive resin composition is used as an actinic ray-sensitive or radiation-sensitive resin composition for EUV exposure, the resin (A) preferably has at least one repeating unit species selected from the group consisting of Group A above.

The resin (A) may include at least one of a fluorine atom or an iodine atom. When the actinic ray-sensitive or radiation-sensitive resin composition is used as an actinic ray-sensitive or radiation-sensitive resin composition for EUV exposure, the resin (A) preferably includes at least one of a fluorine atom or an iodine atom. When the resin (A) includes both of a fluorine atom and an iodine atom, the resin (A) may have a repeating unit including both of a fluorine atom and an iodine atom, or the resin (A) may include two species that are a repeating unit having a fluorine atom and a repeating unit including an iodine atom.

The resin (A) may have a repeating unit having an aromatic group. When the actinic ray-sensitive or radiation-sensitive resin composition is used as an actinic ray-sensitive or radiation-sensitive resin composition for EUV exposure, the resin (A) also preferably has a repeating unit having an aromatic group.

The resin (A) may have at least one repeating unit species selected from the group consisting of Group B above. When the actinic ray-sensitive or radiation-sensitive resin composition is used as an actinic ray-sensitive or radiation-sensitive resin composition for ArF, the resin (A) preferably has at least one repeating unit species selected from the group consisting of Group B above.

Note that, when the actinic ray-sensitive or radiation-sensitive resin composition is used as an actinic ray-sensitive or radiation-sensitive resin composition for ArF, the resin (A) preferably does not include fluorine atoms or silicon atoms.

When the actinic ray-sensitive or radiation-sensitive resin composition is used as an actinic ray-sensitive or radiation-sensitive resin composition for ArF, the resin (A) preferably does not have aromatic groups.

Repeating unit having acid group

The resin (A) may have a repeating unit having an acid group.

The acid group is preferably an acid group having a pKa of 13 or less. The acid group preferably has an acid

dissociation constant of 13 or less, more preferably 3 to 13, and still more preferably 5 to 10.

When the resin (A) has an acid group having a pKa of 13 or less, the content of the acid group in the resin (A) is not particularly limited, but is often 0.2 to 6.0 mmol/g. In particular, preferred is 0.8 to 6.0 mmol/g, more preferred is 1.2 to 5.0 mmol/g, and still more preferred is 1.6 to 4.0 mmol/g. When the content of the acid group is within such a range, development suitably proceeds to form a pattern having a good profile at high resolution.

The acid group is preferably, for example, a carboxyl group, a phenolic hydroxyl group, a fluoroalcohol group (preferably a hexafluoroisopropanol group), a sulfonic acid group, a sulfonamide group, or an isopropanol group.

In the hexafluoroisopropanol group, one or more (preferably one to two) of the fluorine atoms may be substituted with groups other than fluorine atoms (such as alkoxycarbonyl groups). The acid group is also preferably $-C(CF_3)(OH)-CF_2-$ formed in this manner. Alternatively, one or more of the fluorine atoms may be substituted with groups other than fluorine atoms, to form a ring including $-C(CF_3)(OH)-CF_2-$.

The repeating unit having an acid group is preferably a repeating unit different from the above-described repeating unit having a structure in which a polar group is protected with a group that leaves by action of an acid and repeating units described later and having a lactone group, a sultone group, or a carbonate group.

The repeating unit having an acid group may have a fluorine atom or an iodine atom.

Specific examples of the repeating unit having an acid group include, for example, the repeating units described in [0088] to [0089] and [0103] to [0110] of WO2022/024928A. The above description is incorporated herein.

The repeating unit having an acid group is preferably a repeating unit represented by a formula (b1-1) below.

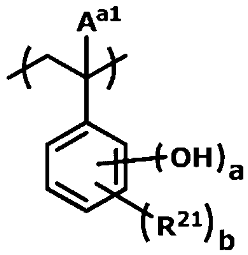

(b1-1)

In the formula (b1-1), $A^{a1}$ represents a hydrogen atom, an alkyl group, a cycloalkyl group, a halogen atom, or a cyano group. $R^{21}$ represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group; when there are a plurality of $R^{21}$'s, they may be the same or different. When there are a plurality of $R^{21}$'s, they may together form a ring. $R^{21}$ is preferably a hydrogen atom. a represents an integer of 1 to 3. b represents an integer of 0 to (5 - a).

When the resin (A) includes a repeating unit having an acid group, the content of the repeating unit having an acid group is, relative to all the repeating units in the resin (A), preferably 10 mol% or more, and more preferably 15 mol% or more. The upper limit value relative to all the repeating units in the resin (A) is preferably 70 mol% or less, more preferably 65 mol% or less, and still more preferably 60 mol% or less.

Repeating unit not having acid-decomposable group or acid group, but having fluorine atom, bromine atom, or iodine atom

The resin (A) may have, aside from the above-described <repeating unit having an acid-decomposable group> and <repeating unit having an acid group>, a repeating unit not having an acid-decomposable group or an acid group, but having a fluorine atom, a bromine atom, or an iodine atom (hereafter, also referred to as unit X). This <repeating unit not having an acid-decomposable group or an acid group, but having a fluorine atom, a bromine atom, or an iodine atom> is preferably different from other repeating unit species belonging to Group A such as the <repeating unit having a lactone group, a sultone group, or a carbonate group> and the <repeating unit having a photoacid generation group> described later.

The unit X is preferably a repeating unit represented by a formula (C).

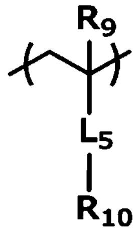

(C)

$L_5$ represents a single bond or an ester group. $R_9$ represents a hydrogen atom or an alkyl group that may have a fluorine atom or an iodine atom. $R_{10}$ represents a hydrogen atom, an alkyl group that may have a fluorine atom or an iodine atom, a cycloalkyl group that may have a fluorine atom or an iodine atom, an aryl group that may have a fluorine atom or an iodine atom, or a group that is a combination of the foregoing.

Specific examples of the repeating unit having a fluorine atom or an iodine atom include, for example, the repeating units described in [0116] to [0117] of WO2022/024928A. The above description is incorporated herein.

The unit X content relative to all the repeating units in the resin (A) is preferably 0 mol% or more, more preferably 5 mol% or more, and still more preferably 10 mol% or more. The upper limit value relative to all the repeating units in the resin (A) is preferably 50 mol% or less, more preferably 45 mol% or less, and still more preferably 40 mol% or less.

Of the repeating units of the resin (A), the total content of the repeating unit including at least one of a fluorine atom, a bromine atom, or an iodine atom relative to all the repeating units of the resin (A) is preferably 10 mol% or more, more preferably 20 mol% or more, still more preferably 30 mol% or more, and particularly preferably 40 mol% or more. The upper limit value is not particularly limited, but is, for example, relative to all the repeating units of the resin (A), 100 mol% or less.

Note that examples of the repeating unit including at least one of a fluorine atom, a bromine atom, or an iodine atom include a repeating unit having a fluorine atom, a bromine atom, or an iodine atom and having an acid-decomposable group, a repeating unit having a fluorine atom, a bromine atom, or an iodine atom and having an acid group, and a repeating unit having a fluorine atom, a bromine atom, or an iodine atom.

Repeating unit having lactone group, sultone group, or carbonate group

The resin (A) may have a repeating unit having at least one selected from the group consisting of a lactone group, a sultone group, and a carbonate group (hereafter, also referred to as "unit Y").

The unit Y also preferably does not have acid groups such as a hydroxy group and a hexafluoropropanol group.

The lactone group or the sultone group has a lactone structure or a sultone structure. The lactone structure or the sultone structure is preferably a 5- to 7-membered lactone structure or a 5- to 7-membered sultone structure. In particular, more preferred is a 5- to 7-membered lactone structure to which another ring structure is fused so as to form a bicyclo structure or a spiro structure, or a 5- to 7-membered sultone structure to which another ring structure is fused so as to form a bicyclo structure or a spiro structure.

The resin (A) preferably has a repeating unit having a lactone group or a sultone group provided by withdrawing, from a ring-member atom of the lactone structure represented by any one of formulas (LC1-1) to (LC1-21) below or the sultone structure represented by any one of formulas (SL1-1) to (SL1-3) below, one or more hydrogen atoms, and the lactone group or the sultone group may be directly bonded to the main chain. For example, a ring-member atom of the lactone group or the sultone group may constitute the main chain of the resin (A).

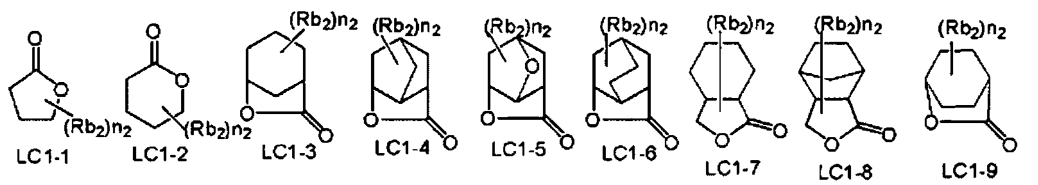

LC1-1 LC1-2 LC1-3 LC1-4 LC1-5 LC1-6 LC1-7 LC1-8 LC1-9

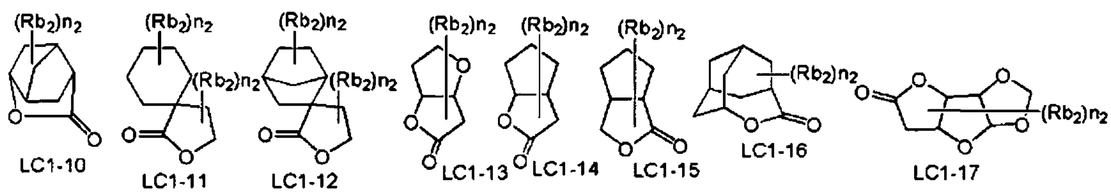

LC1-10 LC1-11 LC1-12 LC1-13 LC1-14 LC1-15 LC1-16 LC1-17

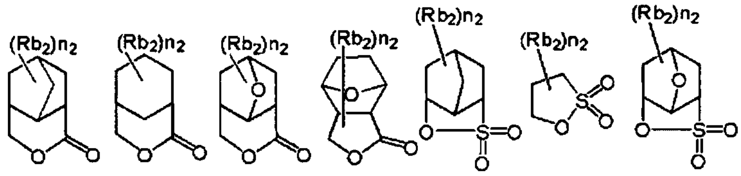

LC1-18 LC1-19 LC1-20 LC1-21 SL1-1 SL1-2 SL1-3

The lactone structure or the sultone structure may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a cyano group, and an acid-decomposable group. $n_2$ represent an integer of 0 to 4. When $n_2$ is 2 or more, the plurality of $Rb_2$'s present may be different, and the plurality of $Rb_2$'s present may be bonded together to form a ring.

The repeating unit having a group including the lactone structure represented by any one of the formulas (LC1-1) to (LC1-21) or the sultone structure represented by any one of the formulas (SL1-1) to (SL1-3) may be, for example, a repeating unit represented by the following formula (AI-2).

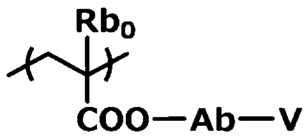

(AI-2)

In the formula (AI-2), $Rb_0$ represents a hydrogen atom, a halogen atom, or an alkyl group having 1 to 4 carbon atoms. Preferred examples of the substituent that the alkyl group of $Rb_0$ may have include a hydroxy group and a halogen atom.

For $Rb_0$, the halogen atom may be a fluorine atom, a chlorine atom, a bromine atom, or an iodine atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent linking group that is a combination of the foregoing. In particular, Ab is preferably a single bond or a linking group represented by $-Ab_1-CO_2-$. $Ab_1$ is a linear or branched alkylene group or a monocyclic or polycyclic cycloalkylene group, and preferably a methylene group, an ethylene group, a cyclohexylene group, an adamantylene group, or a norbornylene group.

V represents a group formed by withdrawing, from a ring-member atom of the lactone structure represented by any one of the formulas (LC1-1) to (LC1-21), a single hydrogen atom, or a group formed by withdrawing, from a ring-member atom of the sultone structure represented by any one of the formulas (SL1-1) to (SL1-3), a single hydrogen atom.

When the repeating unit having a lactone group or a sultone group has an optical isomer, any optical isomer may be used. A single optical isomer may be used alone, or a plurality of optical isomers may be used in combination. In the case of mainly using one of the optical isomers, its optical purity (ee) is preferably 90 or more, and more preferably 95 or more.

The carbonate group is preferably a cyclic carbonic acid ester group.

For the repeating unit having a cyclic carbonic acid ester group, for example, the description in [0127] to [0133] of WO2022/024928A can be referred to. The above description is incorporated herein.

When the resin (A) includes the unit Y, the content of the unit Y relative to all the repeating units in the resin (A) is preferably 1 mol% or more, and more preferably 10 mol% or more. The upper limit value relative to all the repeating units in the resin (A) is preferably 85 mol% or less, more preferably 80 mol% or less, still more preferably 70 mol% or less, and particularly preferably 60 mol% or less.

Repeating unit having photoacid generation group

The resin (A) may have, as another repeating unit, a repeating unit having a group that generates an acid upon irradiation with an actinic ray or a radiation (also referred to as "photoacid generation group").

The repeating unit having a photoacid generation group may be a repeating unit represented by a formula (4).

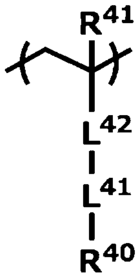

(4)

$R^{41}$ represents a hydrogen atom or a methyl group. $L^{41}$ represents a single bond or a divalent linking group. $L^{42}$ represents a divalent linking group. $R^{40}$ represents a structural moiety that is decomposed upon irradiation with an actinic ray or a radiation to generate an acid in the side chain.

Specific examples of the repeating unit having a photoacid generation group include, for example, the repeating units described in [0094] to [0105] of JP2014-041327A, the repeating units described in [0094] of WO2018/193954A, and the repeating units described in [0138] of WO2022/024928A. The above descriptions are incorporated herein.

Examples of the repeating unit represented by the formula (4) include the repeating units described in Paragraphs [0094] to [0105] of JP2014-041327A, and the repeating units described in Paragraph [0094] of WO2018/193954A.

The content of the repeating unit having a photoacid generation group relative to all the repeating units in the resin (A) is preferably 1 mol% or more, and more preferably 5 mol% or more. The upper limit value relative to all the repeating units in the resin (A) is preferably 40 mol% or less, more preferably 35 mol% or less, and still more preferably 30 mol% or less.

The above-described onium salt (B) can also be used as the photoacid generation moiety of the repeating unit having a photoacid generation group.

Repeating unit represented by formula (V-1) or formula (V-2) below

The resin (A) may have a repeating unit represented by a formula (V-1) below or a formula (V-2) below.

The repeating unit represented by the formula (V-1) below or the formula (V-2) below is preferably a repeating unit different from the above-described repeating units.

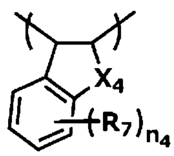

(V-1)

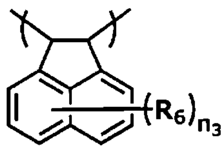

(V-2)

In the formulas,

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR: R is an alkyl group or a fluorinated alkyl group having 1 to 6 carbon atoms), or a carboxyl group. The alkyl group is preferably a linear, branched, or cyclic alkyl group having 1 to 10 carbon atoms.
$n_3$ represents an integer of 0 to 6.
$n_4$ represents an integer of 0 to 4.
$X_4$ is a methylene group, an oxygen atom, or a sulfur atom.

Examples of the repeating unit represented by the formula (V-1) or (V-2) are as follows.

Examples of the repeating unit represented by the formula (V-1) or (V-2) include the repeating units described in Paragraph [0100] of WO2018/193954A.

Repeating unit for lowering mobility of main chain

The resin (A) preferably has, from the viewpoint of suppressing excessive diffusion of the generated acid or pattern collapse during development, a relatively high glass transition temperature (Tg). Tg is preferably more than 90°C,

more preferably more than 100°C, still more preferably more than 110°C, and particularly preferably more than 125°C. Note that, from the viewpoint of having a high dissolution rate in developers, Tg is preferably 400°C or less, and more preferably 350°C or less.

Note that, in this Specification, the glass transition temperatures (Tg) of polymers such as the resin (A) (hereafter, "Tg's of repeating units") are calculated in the following manner. First, for the repeating units included in a polymer, the Tg's of homopolymers composed only of the repeating units are individually calculated by the Bicerano method. Subsequently, the mass ratios (%) of the repeating units relative to all the repeating units in the polymer are calculated. Subsequently, the Fox equation (described in Materials Letters 62 (2008) 3152, for example) is used to calculate Tg's for the mass ratios and the Tg's are summed up to determine the Tg(°C) of the polymer.

The Bicerano method is described in Prediction of polymer properties, Marcel Dekker Inc, New York (1993). The calculation of Tg by the Bicerano method can be performed using a software for estimating properties of polymers, MDL Polymer (MDL Information Systems, Inc.).

In order to increase the Tg of the resin (A) (preferably, making Tg be more than 90°C), the mobility of the main chain of the resin (A) is preferably lowered. Examples of the method for lowering the mobility of the main chain of the resin (A) include the following methods (a) to (e):

(a) introduction of a bulky substituent to the main chain;
(b) introduction of a plurality of substituents to the main chain;
(c) introduction of a substituent that induces interaction between the resins (A), to the vicinity of the main chain;
(d) formation of the main chain using a ring structure; and
(e) linkage of a ring structure to the main chain.

Note that the resin (A) preferably has a repeating unit whose homopolymer has a Tg of 130°C or more.

Note that the repeating unit species whose homopolymer has a Tg of 130°C or more is not particularly limited and is a repeating unit whose homopolymer has a Tg of 130°C or more calculated by the Bicerano method. Note that the repeating units represented by a formula (A) to a formula (E) described later may, depending on the functional group species, belong to the repeating unit whose homopolymer has a Tg of 130°C or more.

An example of specific means for achieving (a) above is a method of introducing, into the resin (A), a repeating unit represented by a formula (A).

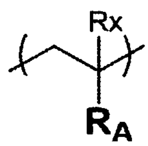

(A)

For the formula (A), $R_A$ represents a group including a polycyclic structure. $R_x$ represents a hydrogen atom, a methyl group, or an ethyl group. The group including a polycyclic structure is a group including a plurality of cyclic structures; the plurality of cyclic structures may be fused together or may not be fused together.

Specific examples of the repeating unit represented by the formula (A) include those described in Paragraphs [0107] to [0119] of WO2018/193954A.

An example of specific means for achieving (b) above is a method of introducing, into the resin (A), a repeating unit represented by a formula (B).

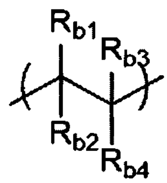

(B)

In the formula (B), $R_{b1}$ to $R_{b4}$ each independently represent a hydrogen atom or an organic group; at least two or more of $R_{b1}$ to $R_{b4}$ represent organic groups.

When at least one of the organic groups is a group whose cyclic structure is directly linked to the main chain in the repeating unit, the other organic group species is not particularly limited.

When none of the organic groups is a group whose cyclic structure is directly linked to the main chain in the repeating unit, at least two or more of the organic groups are substituents having three or more constituent atoms (except for hydrogen atoms).

Specific examples of the repeating unit represented by the formula (B) include those described in Paragraphs

[0113] to [0115] of WO2018/193954A.

An example of specific means for achieving (c) above is a method of introducing, into the resin (A), a repeating unit represented by a formula (C).

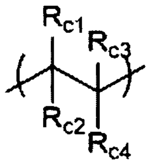

(C)

In the formula (C), $R_{c1}$ to $R_{c4}$ each independently represent a hydrogen atom or an organic group; at least one of $R_{c1}$ to $R_{c4}$ is a group including a hydrogen-bond-forming hydrogen atom positioned within three atoms from the carbon atom in the main chain. In particular, from the viewpoint of inducing the interaction between the main chains of the resin (A), it preferably has a hydrogen-bond-forming hydrogen atom positioned within two atoms (closer to the main chain side).

Specific examples of the repeating unit represented by the formula (C) include those described in Paragraphs [0119] to [0121] of WO2018/193954A.

An example of specific means for achieving (d) above is a method of introducing, into the resin (A), a repeating unit represented by a formula (D).

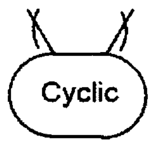

(D)

In the formula (D), "Cyclic" represents a group in which a ring structure forms the main chain. The number of atoms constituting the ring is not particularly limited.

Specific examples of the repeating unit represented by the formula (D) include those described in Paragraphs [0126] to [0127] of WO2018/193954A.

An example of specific means for achieving (e) above is a method of introducing, into the resin (A), a repeating unit represented by a formula (E).

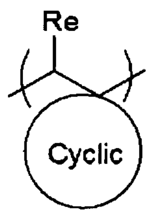

(E)

In the formula (E), Re each independently represent a hydrogen atom or an organic group. Examples of the organic group include alkyl groups, cycloalkyl groups, aryl groups, aralkyl groups, and alkenyl groups that may have a substituent.

"Cyclic" is a cyclic group including a carbon atom of the main chain. The number of atoms included in the cyclic group is not particularly limited.

Specific examples of the repeating unit represented by the formula (E) include those described in Paragraphs [0131] to [0133] of WO2018/193954A.

Repeating unit having at least one group species selected from the group consisting of lactone group, sultone group, carbonate group, hydroxy group, cyano group, and alkali-soluble group

The resin (A) may have a repeating unit having at least one group species selected from the group consisting of a lactone group, a sultone group, a carbonate group, a hydroxy group, a cyano group, and an alkali-soluble group.

In the resin (A), the repeating unit having a lactone group, a sultone group, or a carbonate group may be the repeating unit having been described above in <Repeating unit having lactone group, sultone group, or carbonate group>. Preferred contents are also the same as those having been described above in <Repeating unit having lactone group, sultone group, or carbonate group>.

The resin (A) may have a repeating unit having a hydroxy group or a cyano group. This results in improvement in

adhesiveness to the substrate and affinity for the developer.

The repeating unit having a hydroxy group or a cyano group is preferably a repeating unit having an alicyclic hydrocarbon structure substituted with a hydroxy group or a cyano group.

The repeating unit having a hydroxy group or a cyano group preferably does not have an acid-decomposable group. Examples of the repeating unit having a hydroxy group or a cyano group include those described in Paragraphs [0081] to [0084] of JP2014-098921A.

The resin (A) may have a repeating unit having an alkali-soluble group.

The alkali-soluble group may be a carboxyl group, a sulfonamide group, a sulfonylimide group, a bissulfonylimide group, or an aliphatic alcohol group substituted, at the $\alpha$ position, with an electron-withdrawing group (for example, a hexafluoroisopropanol group), and is preferably a carboxyl group. When the resin (A) includes the repeating unit having an alkali-soluble group, increased resolution is provided in the contact hole application. Examples of the repeating unit having an alkali-soluble group include those described in Paragraphs [0085] and [0086] of JP2014-098921A.

Repeating unit having alicyclic hydrocarbon structure and not exhibiting acid-decomposability

The resin (A) may have a repeating unit having an alicyclic hydrocarbon structure and not exhibiting acid-decomposability. This results in, during liquid immersion exposure, a reduction in leaching of, from the resist film to the immersion liquid, low-molecular-weight components. Examples of the repeating unit having an alicyclic hydrocarbon structure and not exhibiting acid-decomposability include a repeating unit derived from 1-adamantyl (meth)acrylate, diamantyl (meth)acrylate, tricyclodecanyl (meth)acrylate, or cyclohexyl (meth)acrylate.

Repeating unit not having hydroxy group or cyano group and represented by formula (III)

The resin (A) may have a repeating unit not having a hydroxy group or a cyano group and represented by a formula (III).

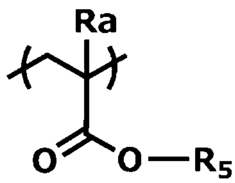

(III)

In the formula (III), $R_5$ represents a hydrocarbon group having at least one ring structure and not having a hydroxy group or a cyano group.

Ra represents a hydrogen atom, an alkyl group, or a $-CH_2-O-Ra_2$ group. In the formula, $Ra_2$ represents a hydrogen atom, an alkyl group, or an acyl group.

Examples of the repeating unit not having a hydroxy group or a cyano group and represented by the formula (III) include those described in Paragraphs [0087] to [0094] of JP2014-098921A.

Other repeating unit

Furthermore, the resin (A) may have another repeating unit other than the above-described repeating units.

For example, the resin (A) may have a repeating unit selected from the group consisting of a repeating unit having an oxathiane ring group, a repeating unit having an oxazolone ring group, a repeating unit having a dioxane ring group, and a repeating unit having a hydantoin ring group.

The resin (A) may have, in addition to such repeating structure units, for the purpose of adjusting, for example, dry etching resistance, standard developer suitability, substrate adhesiveness, resist profile, resolution, heat resistance, and sensitivity, various repeating structure units.

For the resin (A), particularly when the composition of the present invention is used as an actinic ray-sensitive or radiation-sensitive resin composition for ArF, all the repeating units are preferably constituted by a repeating unit derived from a compound having an ethylenically unsaturated bond. In particular, all the repeating units are also preferably constituted by a (meth)acrylate-based repeating unit. When all the repeating units are constituted by a (meth)acrylate-based repeating unit, all the repeating units can be a methacrylate-based repeating unit, all the repeating units can be an acrylate-based repeating unit, or all the repeating units can be a methacrylate-based repeating unit and an acrylate-based repeating unit; the acrylate-based repeating unit content relative to all the repeating units is preferably 50 mol% or less.

As described above, the resin (A) may include a fluorine atom, but the fluorine atom content relative to the total solid content of the composition of the present invention is preferably adjusted so as to be in a range satisfying a range

described later, and the resin (A) also preferably does not include fluorine atoms.

As described later, the SP value [$SP_C$] of the resin (C) is smaller than the SP value [$SP_A$] of the resin (A) and is 17.00 or less. [$SP_A$] is preferably more than 17.00, more preferably 17.50 or more, and still more preferably 18.00 or more. The upper limit is not particularly limited, but is, for example, preferably 21.00 or less.

The method for measuring the SP value of a resin will be described in the section of Resin (C).

The resin (A) can be synthesized by standard procedures (for example, radical polymerization).

The resin (A) has a weight-average molecular weight (Mw) of, as a polystyrene-equivalent value determined by the GPC method, preferably 30000 or less, more preferably 1000 to 30000, still more preferably 3000 to 30000, and particularly preferably 5000 to 15000.

The resin (A) has a dispersity (molecular weight distribution, Mw/Mn) of preferably 1 to 5, more preferably 1 to 3, still more preferably 1.2 to 3.0, and particularly preferably 1.2 to 2.0. As the dispersity lowers, the resolution becomes higher, the resist profile becomes better, the sidewalls of the resist pattern become smoother, and the roughness performance becomes higher.

In the actinic ray-sensitive or radiation-sensitive resin composition, the content of the resin (A) is, relative to the total solid content of the actinic ray-sensitive or radiation-sensitive resin composition, preferably 30.0 to 99.9 mass%, more preferably 40.0 to 99.9 mass%, and still more preferably 60.0 to 90.0 mass%.

Such resins (A) may be used alone or may be used in combination of two or more thereof. When two or more thereof are used, the total content thereof is preferably within such a preferred content range.

Onium salt (B)

The onium salt (B) included in the composition of the present invention and represented by the following formula (1) will be described.

The onium salt (B) is preferably a compound that is irradiated with an actinic ray or a radiation to generate an acid (photoacid generator).

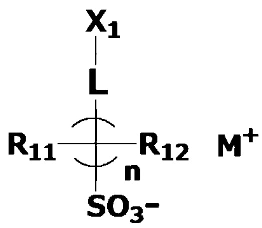

(1)

In the formula (1),

$R_{11}$ represents a hydrogen atom, a cyano group, a nitro group, a substituent represented by a formula (1A) below, or a substituent represented by a formula (1B) below.
$R_{12}$ represents a hydrogen atom or a substituent not having fluorine atoms.
n represents an integer of 1 to 4. When n is an integer of 2 to 4, a plurality of $R_{11}$ and a plurality of $R_{12}$ may be the same or different, and at least one of $R_{11}$ represents a cyano group, a nitro group, a substituent represented by the formula (1A) below, or a substituent represented by the formula (1B) below.
L represents a single bond or a divalent linking group.
$X_1$ represents a hydrogen atom or an organic group.
$M^+$ represents an organic cation.
At least two of $R_{11}$, $R_{12}$, L, and $X_1$ may be bonded together to form a ring.

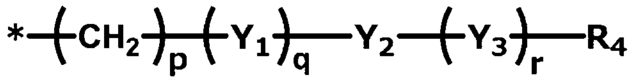

(1A)

In the formula (1A), $Y_1$ and $Y_3$ each independently represent -O- or $-NR_3-$, and $R_3$ represents a hydrogen atom or an alkyl group. $Y_2$ represents -C(=O)- or $-SO_2-$. $R_4$ represents an alkyl group, a cycloalkyl group, or an aryl group. p represents an integer of 0 to 2, and q and r each independently represent 0 or 1. * represents a bonding site.

$*-CH_2-R_X$ (1B)

In the formula (1B), Rx represents a cyano group or a nitro group. * represents a bonding site.

In the formula (1), $R_{11}$ represents a hydrogen atom, a cyano group, a nitro group, a substituent represented by the formula (1A), or a substituent represented by the formula (1B).

In the formula (1A), $Y_1$ and $Y_3$ each independently represent -O- or -$NR_3$-, and $R_3$ represents a hydrogen atom or an alkyl group. The alkyl group represented by $R_3$ may be linear or branched, and is preferably an alkyl group having 1 to 12 carbon atoms, more preferably an alkyl group having 1 to 6 carbon atoms, and still more preferably an alkyl group having 1 to 3 carbon atoms.

$Y_1$ and $Y_3$ preferably represent -O-.
p preferably represents 0 or 1.
q preferably represents 0.
r preferably represents 1.

In the formula (1A), $Y_2$ represents -C(=O)- or -$SO_2$-, and preferably represents -C(=O)-.

In the formula (1A), $R_4$ represents an alkyl group, a cycloalkyl group, or an aryl group.

$R_4$ preferably represents an alkyl group or a cycloalkyl group.

The alkyl group represented by $R_4$ may be linear or branched, and is preferably an alkyl group having 1 to 12 carbon atoms, more preferably an alkyl group having 1 to 6 carbon atoms, and still more preferably an alkyl group having 1 to 3 carbon atoms. Examples of the alkyl group represented by $R_4$ include a methyl group, an ethyl group, an n-propyl group, an isopropyl group, an n-butyl group, an isobutyl group, a sec-butyl group, and a t-butyl group. The alkyl group represented by $R_4$ may have a substituent. The substituent that the alkyl group represented by $R_4$ may have is not particularly limited, but may be, for example, a cycloalkyl group or an aryl group. The descriptions and preferred ranges of the cycloalkyl group and the aryl group serving as the substituent that the alkyl group represented by $R_4$ may have are respectively the same as the descriptions and preferred ranges of the cycloalkyl group and the aryl group represented by $R_4$ described below.

The cycloalkyl group represented by $R_4$ may be monocyclic or polycyclic, and is preferably a cycloalkyl group having 3 to 20 carbon atoms, more preferably a cycloalkyl group having 4 to 15 carbon atoms, and still more preferably a cycloalkyl group having 5 to 10 carbon atoms. Examples of the cycloalkyl group represented by $R_4$ include a cyclopentyl group, a 1-methylcyclopentyl group, a cyclohexyl group, an adamantyl group, and a 1-ethyladamantyl group. The cycloalkyl group represented by $R_4$ may have a substituent. The substituent that the cycloalkyl group represented by $R_4$ may have is not particularly limited, but may be, for example, an alkyl group or an aryl group. The descriptions and preferred ranges of the alkyl group and the aryl group serving as the substituent that the cycloalkyl group represented by $R_4$ may have are respectively the same as the above descriptions and preferred ranges of the alkyl group represented by $R_4$ and below descriptions and preferred ranges of the aryl group represented by $R_4$. One or more methylene groups in the cycloalkyl group represented by $R_4$ may be substituted with an oxygen atom, a carbonyl group, or an ester group.

The aryl group represented by $R_4$ is preferably an aryl group having 6 to 20 carbon atoms, more preferably an aryl group having 6 to 15 carbon atoms, still more preferably an aryl group having 6 to 10 carbon atoms, particularly preferably a phenyl group or a naphthyl group, and most preferably a phenyl group. The aryl group represented by $R_4$ may have a substituent. The substituent that the aryl group represented by $R_4$ may have is not particularly limited, but may be, for example, an alkyl group or a cycloalkyl group. The descriptions and preferred ranges of the alkyl group and the cycloalkyl group serving as the substituent that the aryl group represented by $R_4$ may have are respectively the same as the above descriptions and preferred ranges of the alkyl group and the cycloalkyl group represented by $R_4$.

The alkyl group represented by $R_3$, and the alkyl group, the cycloalkyl group, and the aryl group represented by $R_4$ preferably do not have fluorine atoms. In other words, the substituent represented by the formula (1A) preferably does not have fluorine atoms.

In the formula (1), $R_{12}$ represents a hydrogen atom or a substituent not having fluorine atoms.

The substituent not having fluorine atoms represented by $R_{12}$ is not particularly limited as long as it does not have fluorine atoms, but may be, for example, an organic group or a nitro group.

The organic group is not particularly limited, but is, for example, preferably a cyano group, an alkyl group, a cycloalkyl group, an aryl group, a substituent represented by the formula (1A), or a substituent represented by the formula (1B).

The alkyl group may be linear or branched, and is preferably an alkyl group having 1 to 12 carbon atoms, more preferably an alkyl group having 1 to 6 carbon atoms, and still more preferably an alkyl group having 1 to 3 carbon atoms. Examples of the alkyl group include a methyl group, an ethyl group, an n-propyl group, an isopropyl group, an n-butyl group, an isobutyl group, a sec-butyl group, and a t-butyl group.

The cycloalkyl group may be monocyclic or polycyclic, and is preferably a cycloalkyl group having 3 to 20 carbon atoms, more preferably a cycloalkyl group having 4 to 15 carbon atoms, and still more preferably a cycloalkyl group having 5 to 10 carbon atoms. Examples of the cycloalkyl group include a cyclopentyl group, a 1-methylcyclopentyl group, a cyclohexyl group, an adamantyl group, and a 1-ethyladamantyl group.

The aryl group is preferably an aryl group having 6 to 20 carbon atoms, more preferably an aryl group having 6 to 15 carbon atoms, still more preferably an aryl group having 6 to 10 carbon atoms, particularly preferably a phenyl group or a naphthyl group, and most preferably a phenyl group.

The alkyl group, the cycloalkyl group, and the aryl group may have a substituent other than a fluorine atom.

When $R_{12}$ is a substituent represented by the formula (1A) and a substituent represented by the formula (1B), the descriptions and preferred ranges of the substituent represented by the formula (1A) and the substituent represented by the formula (1B) are respectively the same as the descriptions and preferred ranges of the substituent represented by the formula (1A) and the substituent represented by the formula (1B) in $R_{11}$.

In the formula (1), n represents an integer of 1 to 4, preferably 1 or 2, and more preferably 2.

In the formula (1), L represents a single bond or a divalent linking group.

The divalent linking group represented by L is not particularly limited, but may be, for example, -O-CO-O-, -COO-, -CONH-, -CO-, -O-, -S-, -SO-, $-SO_2-$, an alkylene group (preferably having 1 to 6 carbon atoms), a cycloalkylene group (preferably having 3 to 15 carbon atoms), an alkenylene group (preferably having 2 to 6 carbon atoms), or a divalent linking group in which a plurality of the foregoing are combined.

The alkylene group, the cycloalkylene group, and the alkenylene group may have a substituent, but preferably do not have fluorine atoms.

In the formula (1), $X_1$ represents a hydrogen atom or an organic group.

The organic group is not particularly limited, but is, for example, preferably a cyano group, an alkyl group, a cycloalkyl group, an aryl group, a substituent represented by the formula (1A), or a substituent represented by the formula (1B).

The alkyl group may be linear or branched, and is preferably an alkyl group having 1 to 12 carbon atoms, more preferably an alkyl group having 1 to 6 carbon atoms, and still more preferably an alkyl group having 1 to 3 carbon atoms. Examples of the alkyl group include a methyl group, an ethyl group, an n-propyl group, an isopropyl group, an n-butyl group, an isobutyl group, a sec-butyl group, and a t-butyl group.

The cycloalkyl group may be monocyclic or polycyclic, and is preferably a cycloalkyl group having 3 to 20 carbon atoms, more preferably a cycloalkyl group having 4 to 15 carbon atoms, and still more preferably a cycloalkyl group having 5 to 10 carbon atoms. Examples of the cycloalkyl group include a cyclopentyl group, a 1-methylcyclopentyl group, a cyclohexyl group, an adamantyl group, and a 1-ethyladamantyl group.

The aryl group is preferably an aryl group having 6 to 20 carbon atoms, more preferably an aryl group having 6 to 15 carbon atoms, still more preferably an aryl group having 6 to 10 carbon atoms, particularly preferably a phenyl group or a naphthyl group, and most preferably a phenyl group.

The above-described alkyl group, cycloalkyl group, and aryl group may have a substituent. The substituent preferably does not include fluorine atoms.

When $X_1$ is a substituent represented by the formula (1A) and a substituent represented by the formula (1B), the descriptions and preferred ranges of the substituent represented by the formula (1A) and the substituent represented by the formula (1B) are respectively the same as the descriptions and preferred ranges of the substituent represented by the formula (1A) and the substituent represented by the formula (1B) in $R_{11}$.

In the formula (1), $M^+$ represents an organic cation.

$M^+$ is preferably a sulfonium cation or an iodonium cation.

The cation represented by $M^+$ is not particularly limited. The cation may have a valence of 1, 2, or more. The cation is preferably a cation represented by a formula (ZaI) (hereafter, also referred to as "cation (ZaI)") or a cation represented by a formula (ZaII) (hereafter, also referred to as "cation (ZaII)").

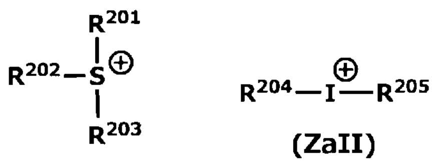

(ZaI) (ZaII)

In the formula (ZaI), $R^{201}$, $R^{202}$, and $R^{203}$ each independently represent an organic group.

For $R^{201}$, $R^{202}$, and $R^{203}$, the organic group preferably has 1 to 30 carbon atoms, and more preferably 1 to 20 carbon atoms. Of $R^{201}$ to $R^{203}$, two may be bonded together to form a ring structure and the ring may include an oxygen atom, a sulfur atom, an ester group, an amide group, or a carbonyl group. Examples of the group formed by bonding together two of $R^{201}$ to $R^{203}$ include alkylene groups (such as a butylene group and a pentylene group), and $-CH_2-CH_2-O-CH_2-CH_2-$.

Preferred examples of the organic cation in the formula (ZaI) include a cation (ZaI-1), a cation (ZaI-2), a cation

(ZaI-3b), and a cation (ZaI-4b) described later.

First, the cation (ZaI-1) will be described.

The cation (ZaI-1) is an aryl sulfonium cation represented by the above-described formula (ZaI) where at least one of $R^{201}$ to $R^{203}$ is an aryl group.

In the aryl sulfonium cation, all of $R^{201}$ to $R^{203}$ may be aryl groups, or a part of $R^{201}$ to $R^{203}$ may be an aryl group and the other may be an alkyl group or a cycloalkyl group.

Alternatively, one of $R^{201}$ to $R^{203}$ may be an aryl group and the other two of $R^{201}$ to $R^{203}$ may be bonded together to form a ring structure in which the ring may include an oxygen atom, a sulfur atom, an ester group, an amide group, or a carbonyl group. Examples of the group formed by bonding together two of $R^{201}$ to $R^{203}$ include alkylene groups in which one or more methylene groups may be substituted with an oxygen atom, a sulfur atom, an ester group, an amide group, and/or a carbonyl group (such as a butylene group, a pentylene group, and $-CH_2-CH_2-O-CH_2-CH_2-$).

Examples of the aryl sulfonium cation include triaryl sulfonium cations, diaryl alkyl sulfonium cations, aryl dialkyl sulfonium cations, diaryl cycloalkyl sulfonium cations, and aryl dicycloalkyl sulfonium cations.

The aryl group included in the aryl sulfonium cation is preferably a phenyl group or a naphthyl group, and more preferably a phenyl group. The aryl group may be an aryl group having a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. When the aryl sulfonium cation has two or more aryl groups, the two or more aryl groups may be the same or different.

The alkyl group or cycloalkyl group that the aryl sulfonium cation has as needed is preferably a linear alkyl group having 1 to 15 carbon atoms, a branched alkyl group having 3 to 15 carbon atoms, or a cycloalkyl group having 3 to 15 carbon atoms, and more preferably a methyl group, an ethyl group, a propyl group, an n-butyl group, a sec-butyl group, a t-butyl group, a cyclopropyl group, a cyclobutyl group, or a cyclohexyl group.

For $R^{201}$ to $R^{203}$, a substituent that the aryl group, the alkyl group, and the cycloalkyl group may have is preferably an alkyl group (having, for example, 1 to 15 carbon atoms), a cycloalkyl group (having, for example, 3 to 15 carbon atoms), an aryl group (having, for example, 6 to 14 carbon atoms), an alkoxy group (having, for example, 1 to 15 carbon atoms), a cycloalkylalkoxy group (having, for example, 1 to 15 carbon atoms), a halogen atom (for example, iodine), a hydroxyl group, a carboxyl group, an ester group, a sulfinyl group, a sulfonyl group, an alkylthio group, or a phenylthio group.

When possible, the substituent may further have a substituent.

Such substituents are also preferably combined appropriately to form an acid-decomposable group.

Hereinafter, the cation (ZaI-2) will be described.

The cation (ZaI-2) is a cation represented by the formula (ZaI) where $R^{201}$ to $R^{203}$ each independently represent an organic group not having an aromatic ring. The aromatic ring also encompasses aromatic rings including a heteroatom.

For $R^{201}$ to $R^{203}$, the organic group not having an aromatic ring preferably has 1 to 30 carbon atoms and more preferably 1 to 20 carbon atoms.

$R^{201}$ to $R^{203}$ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably a linear or branched 2-oxoalkyl group.

For $R^{201}$ to $R^{203}$, the alkyl group and the cycloalkyl group may be, for example, a linear alkyl group having 1 to 10 carbon atoms or a branched alkyl group having 3 to 10 carbon atoms (for example, a methyl group, an ethyl group, a propyl group, a butyl group, or a pentyl group), or a cycloalkyl group having 3 to 10 carbon atoms (for example, a cyclopentyl group, a cyclohexyl group, or a norbornyl group).

$R^{201}$ to $R^{203}$ may be further substituted with a halogen atom, an alkoxy group (having, for example, 1 to 5 carbon atoms), a hydroxy group, a cyano group, or a nitro group.

For $R^{201}$ to $R^{203}$, substituents are also preferably provided independently as appropriate combinations of substituents to form acid-decomposable groups.

Hereinafter, the cation (ZaI-3b) will be described.

The cation (ZaI-3b) is a cation represented by the following formula (ZaI-3b).

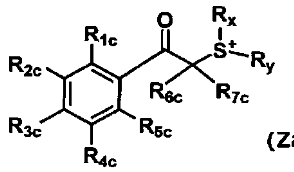

(ZaI-3b)

In the formula (ZaI-3b), $R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxy group, a nitro group, an alkylthio group, or an arylthio group.

$R_{6c}$ and $R_{7c}$ each independently represent a hydrogen atom, an alkyl group (for example, a t-butyl group), a cycloalkyl group, a halogen atom, a cyano group, or an aryl group.

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

For $R_{1c}$ to $R_{7c}$ and $R_x$ and $R_y$, such substituents are also preferably provided independently as appropriate combinations of substituents to form acid-decomposable groups.

Any two or more of $R_{1c}$ to $R_{5c}$, $R_{5c}$ and $R_{6c}$, $R_{6c}$ and $R_{7c}$, $R_{5c}$ and $R_x$, and $R_x$ and $R_y$ may be individually bonded together to form rings; these rings may each independently include an oxygen atom, a sulfur atom, a ketone group, an ester bond, or an amide bond.

Such a ring may be an aromatic or non-aromatic hydrocarbon ring, an aromatic or non-aromatic heterocycle, or a polycyclic fused ring formed as a combination of two or more of these rings. The ring may be a 3- to 10-membered ring, and is preferably a 4- to 8-membered ring, and more preferably a 5- or 6-membered ring.

Examples of the groups formed by bonding together any two or more of $R_{1c}$ to $R_{5c}$, $R_{6c}$ and $R_{7c}$, and $R_x$ and $R_y$ include alkylene groups such as a butylene group and a pentylene group. In such an alkylene group, a methylene group may be substituted with a heteroatom such as an oxygen atom.

The groups formed by bonding together $R_{5c}$ and $R_{6c}$, and $R_{5c}$ and $R_x$ are preferably single bonds or alkylene groups. Examples of the alkylene groups include a methylene group and an ethylene group.

$R_{1c}$ to $R_{5c}$, $R_{6c}$, $R_{7c}$, $R_x$, $R_y$, and the rings formed by individually bonding together any two or more of $R_{1c}$ to $R_{5c}$, $R_{5c}$ and $R_{6c}$, $R_{6c}$ and $R_{7c}$, $R_{5c}$ and $R_x$, and $R_x$ and $R_y$ may have a substituent.

Hereinafter, the cation (ZaI-4b) will be described.

The cation (ZaI-4b) is a cation represented by the following formula (ZaI-4b).

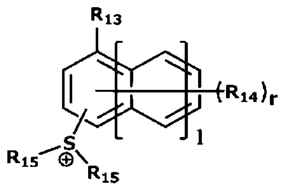

(ZaI-4b)

In the formula (ZaI-4b), 1 represents an integer of 0 to 2, and r represents an integer of 0 to 8.

$R_{13}$ represents a hydrogen atom, a halogen atom (for example, an iodine atom), a hydroxyl group, an alkyl group, an alkyl halide group, an alkoxy group, a carboxyl group, an alkoxycarbonyl group, or a group including a cycloalkyl group (may be the cycloalkyl group itself or may be a group including, as a part thereof, the cycloalkyl group). These groups may have a substituent.

$R_{14}$ represents a hydroxyl group, a halogen atom (for example, an iodine atom), an alkyl group, an alkyl halide group, an alkoxy group, an alkoxycarbonyl group, an alkylcarbonyl group, an alkylsulfonyl group, a cycloalkylsulfonyl group, or a group including a cycloalkyl group (may be the cycloalkyl group itself or may be a group including, as a part thereof, the cycloalkyl group). These groups may have a substituent. When a plurality of $R_{14}$'s are present, $R_{14}$'s each independently represent such a group, for example, a hydroxyl group.

$R_{15}$'s each independently represent an alkyl group, a cycloalkyl group, or a naphthyl group. Two $R_{15}$'s may be bonded together to form a ring. When two $R_{15}$'s are bonded together to form a ring, the ring skeleton may include a heteroatom such as an oxygen atom or a nitrogen atom.

In an example, two $R_{15}$'s are preferably alkylene groups and bonded together to form a ring structure. Note that the alkyl group, the cycloalkyl group, the naphthyl group, and the ring formed by bonding together two $R_{15}$'s may have a substituent.

In the formula (ZaI-4b), for $R_{13}$, $R_{14}$, and $R_{15}$, the alkyl groups may be linear or branched. Such an alkyl group preferably has 1 to 10 carbon atoms. Preferred examples of the alkyl group include a methyl group, an ethyl group, an n-butyl group, and a t-butyl group.

For $R_{13}$ to $R_{15}$, and $R_x$ and $R_y$, such substituents are also preferably provided independently as appropriate combinations of substituents to form acid-decomposable groups.

Hereinafter, the formula (ZaII) will be described.

In the formula (ZaII), $R^{204}$ and $R^{205}$ each independently represent an aryl group, an alkyl group, or a cycloalkyl group.

For $R^{204}$ and $R^{205}$, the aryl group is preferably a phenyl group or a naphthyl group, and more preferably a phenyl group. For $R^{204}$ and $R^{205}$, the aryl group may be an aryl group having a heterocycle having an oxygen atom, a nitrogen atom, a sulfur atom, or the like. Examples of the skeleton of the aryl group having a heterocycle include pyrrole, furan, thiophene, indole, benzofuran, and benzothiophene.

For $R^{204}$ and $R^{205}$, the alkyl group and the cycloalkyl group are preferably a linear alkyl group having 1 to 10

carbon atoms, a branched alkyl group having 3 to 10 carbon atoms (for example, a methyl group, an ethyl group, a propyl group, a butyl group, or a pentyl group), or a cycloalkyl group having 3 to 10 carbon atoms (for example, a cyclopentyl group, a cyclohexyl group, or a norbornyl group).

For $R^{204}$ and $R^{205}$, the aryl group, the alkyl group, and the cycloalkyl group may each independently have a substituent. For $R^{204}$ and $R^{205}$, examples of the substituent that the aryl group, the alkyl group, and the cycloalkyl group may have include alkyl groups (having, for example, 1 to 15 carbon atoms), cycloalkyl groups (having, for example, 3 to 15 carbon atoms), aryl groups (having, for example, 6 to 15 carbon atoms), alkoxy groups (having, for example, 1 to 15 carbon atoms), halogen atoms, a hydroxy group, and a phenylthio group. For $R^{204}$ and $R^{205}$, substituents are also preferably provided independently as appropriate combinations of substituents to form acid-decomposable groups.

$M^+$ preferably does not have fluorine atoms.

The following are non-limiting specific examples of the cation represented by $M^+$.

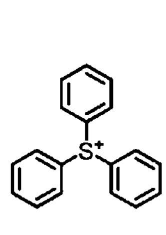 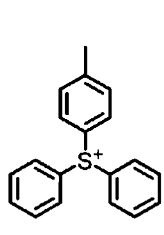 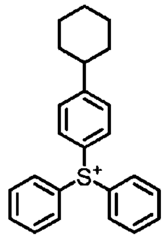 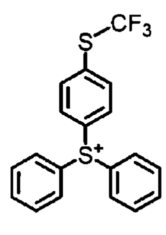 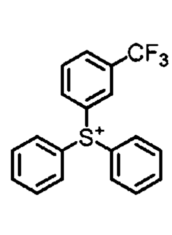

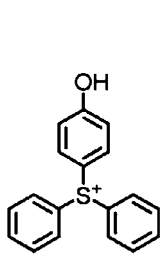 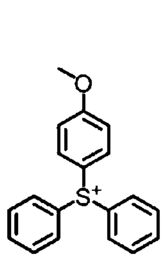 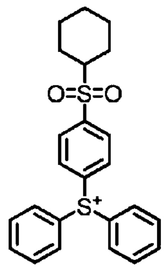 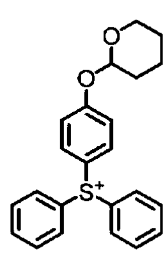 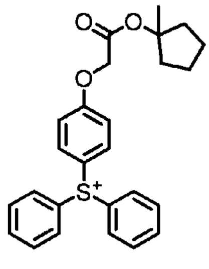

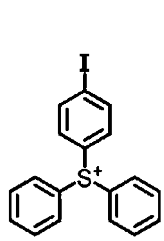 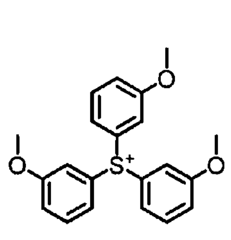 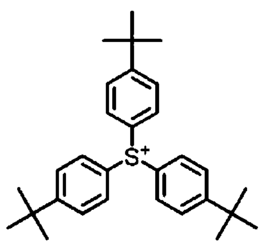 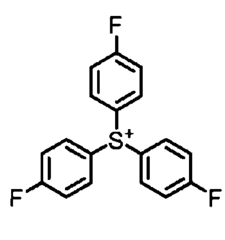

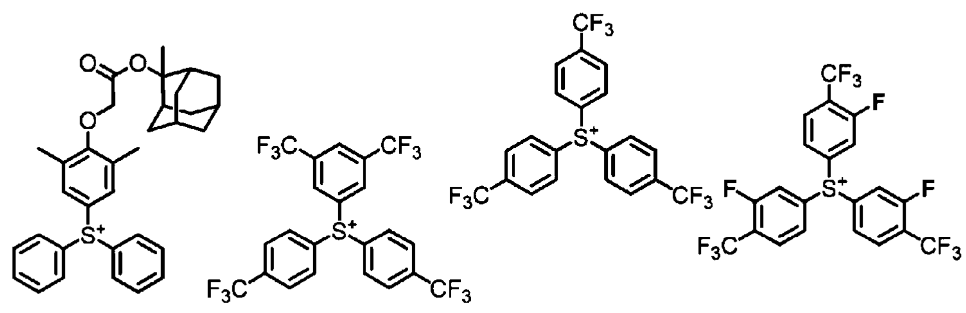

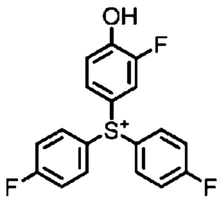
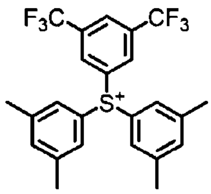
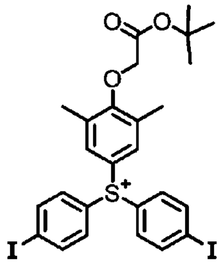
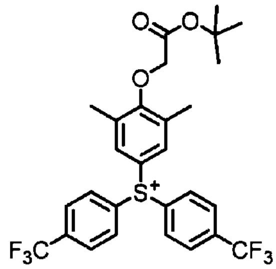

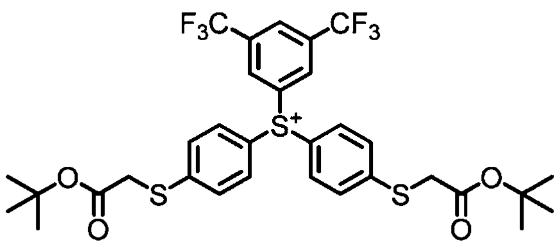
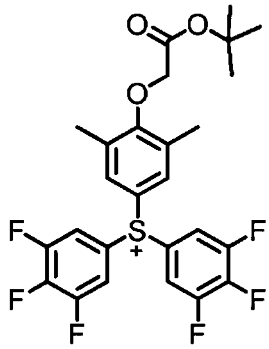
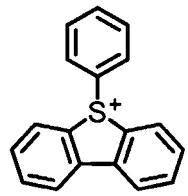
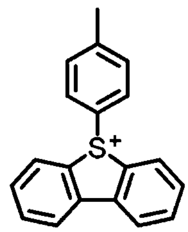

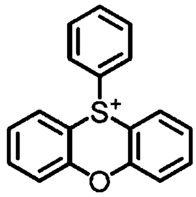
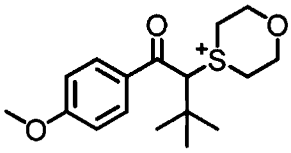
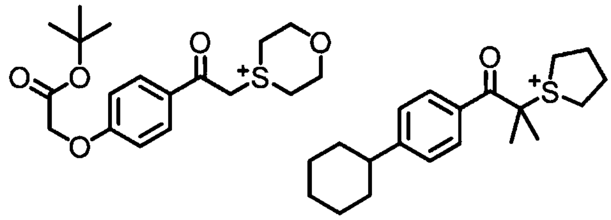

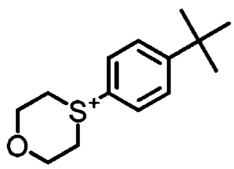
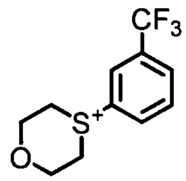
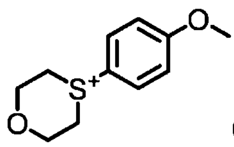
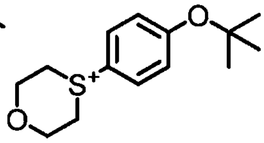

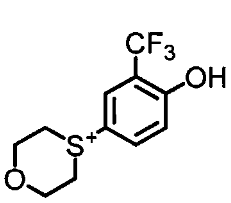
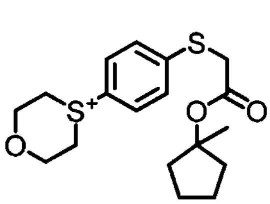
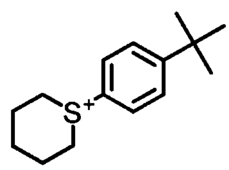
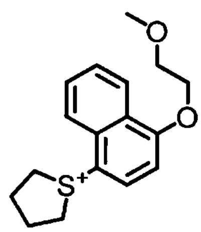

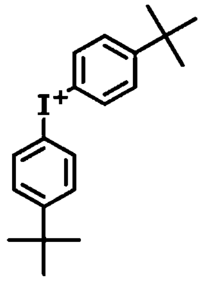 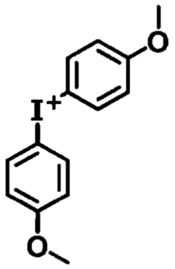 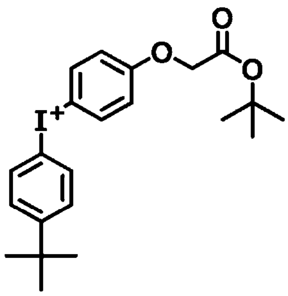 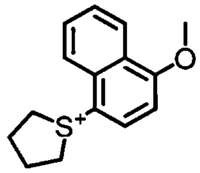

The onium salt represented by the formula (1) is preferably represented by a formula (2) below.

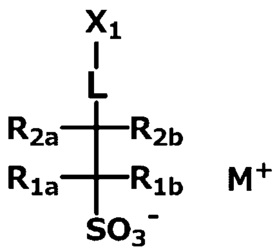

**(2)**

In the formula (2),

$R_{1a}$ and $R_{2a}$ each independently represent a hydrogen atom, a cyano group, a nitro group, a substituent represented by the formula (1A), or a substituent represented by the formula (1B), and at least one of $R_{1a}$ or $R_{2a}$ represents a cyano group, a nitro group, a substituent represented by the formula (1A), or a substituent represented by the formula (1B).
$R_{1b}$ and $R_{2b}$ each independently represent a hydrogen atom or a substituent not having fluorine atoms.
L, $X_1$, and $M^+$ respectively have the same meanings as L, $X_1$, and $M^+$ in the formula (1).
At least two of $R_{1a}$, $R_{1b}$, $R_{2a}$, $R_{2b}$, L, and $X_1$ may be bonded together to form a ring.

In the formula (2), $R_{1a}$ and $R_{2a}$ each independently represent a hydrogen atom, a cyano group, a nitro group, a substituent represented by the formula (1A), or a substituent represented by the formula (1B), and at least one of $R_{1a}$ or $R_{2a}$ represents a cyano group, a nitro group, a substituent represented by the formula (1A), or a substituent represented by the formula (1B). When $R_{1a}$ and $R_{2a}$ are substituents represented by the formula (1A), the description and preferred ranges of the substituents represented by the formula (1A) are the same as the above description and preferred ranges of the substituent represented by the formula (1A) in $R_{11}$. When $R_{1a}$ and $R_{2a}$ are substituents represented by the formula (1B), the description of the substituents represented by the formula (1B) is the same as the above description of the substituent represented by the formula (1B) in $R_{11}$.

In the formula (2), $R_{1a}$ preferably represents a hydrogen atom, a cyano group, a nitro group, or a substituent represented by a formula (2A) below, and $R_{2a}$ preferably represents a cyano group, a nitro group, a substituent represented by the formula (2A) below, or a substituent represented by a formula (2B) below.

$$*\!-\!(Y_1)_q\!-\!Y_2\!-\!(Y_3)_r\!-\!R_4 \qquad \textbf{(2A)}$$

In the formula (2A), $Y_1$ and $Y_3$ each independently represent -O- or $-NR_3-$, and $R_3$ represents a hydrogen atom or an alkyl group. $Y_2$ represents -C(=O)- or $-SO_2-$. $R_4$ represents an alkyl group, a cycloalkyl group, or an aryl group. q and r each independently represent 0 or 1. * represents a bonding site.

$$*\text{-}CH_2\text{-}R_Y \qquad (2B)$$

In the formula (2B), $R_Y$ represents a cyano group, a nitro group, or a substituent represented by the formula (2A). * represents a bonding site.

The definitions, descriptions, and preferred ranges of $Y_1$ to $Y_3$, $R_4$, q, and r in the formula (2A) are respectively the same as the definitions, descriptions, and preferred ranges of $Y_1$ to $Y_3$, $R_4$, q, and r in the formula (1A).

In the formula (2B), the definitions, descriptions, and preferred ranges of $Y_1$ to $Y_3$, $R_4$, q, and r in the substituent represented by the formula (2A) and serving as $R_Y$ are respectively the same as the definitions, descriptions, and preferred

ranges of $Y_1$ to $Y_3$, $R_4$, q, and r in the formula (1A).

$R_Y$ in the formula (2B) preferably represents a cyano group, a nitro group, $-COOR_4$, $-OCOOR_4$, $-OCOR_4$, or $-SO_2R_4$, more preferably represents a cyano group, a nitro group, $-COOR_4$, $-OCOOR_4$, or $-SO_2R_4$, and still more preferably represents a cyano group, $-COOR_4$, $-OCOOR_4$, or $-SO_2R_4$. The definition, descriptions, and preferred ranges of $R_4$ are as described above.

In the formula (2), $R_{1a}$ preferably represents a cyano group, a nitro group, or a substituent represented by the formula (2A), more preferably represents a cyano group, a nitro group, $-COOR_4$, $-OCOOR_4$, $-OCOR_4$, or $-SO_2R_4$, still more preferably represents a cyano group, a nitro group, $-COOR_4$, $-OCOOR_4$, or $-SO_2R_4$, and particularly preferably represents a cyano group, $-COOR_4$, $-OCOOR_4$, or $-SO_2R_4$. The definition, descriptions, and preferred ranges of $R_4$ are as described above.

In the formula (2), $R_{2a}$ preferably represents a cyano group, a nitro group, $-COOR_4$, $-OCOOR_4$, $-OCOR_4$, $-SO_2R_4$, or a substituent represented by a formula (2C) below, more preferably represents a cyano group, a nitro group, $-COOR_4$, $-OCOOR_4$, $-SO_2R_4$, or a substituent represented by the formula (2C) below, and still more preferably represents a cyano group, $-COOR_4$, $-OCOOR_4$, $-SO_2R_4$, or a substituent represented by the formula (2C) below. The definition, descriptions, and preferred ranges of $R_4$ are as described above.

$$*-CH_2-R_{Y2} \qquad (2C)$$

In the formula (2C), $R_{Y2}$ represents a cyano group, a nitro group, $-COOR_4$, $-OCOOR_4$, or $-SO_2R_4$. $R_4$ has the same meaning as $R_4$ in the formula (1A). * represents a bonding site. The descriptions and preferred ranges of $R_4$ are as described above.

The definitions, descriptions, and preferred ranges of $R_{1b}$ and $R_{2b}$ in the formula (2) are the same as the above-described definition, descriptions, and preferred ranges of $R_{11}$ in the formula (1).

The definitions, descriptions, and preferred ranges of L, $X_1$, and $M^+$ in the formula (2) are respectively the same as the above-described definitions, descriptions, and preferred ranges of L, $X_1$, and $M^+$ in the formula (1).

The onium salt represented by the formula (2) preferably does not have fluorine atoms.

For the reason that the composition of the present invention has further improved LWR performance and can achieve a further reduction in the amount of post-development residue, preferably, when $R_{1a}$, $R_{1b}$, $R_{2a}$, and $R_{2b}$ in the formula (2) correspond to (i) below, $R_{2b}$ represents a nitro group, a substituent represented by the formula (2A), or a substituent represented by the formula (2B),

when $R_{1a}$, $R_{1b}$, $R_{2a}$, and $R_{2b}$ in the formula (2) correspond to (ii) below, $X_1$ represents an organic group, or when $R_{1a}$, $R_{1b}$, and $R_{2a}$ in the formula (2) correspond to (iii) below, $X_1$ represents an organic group:

(i) a case where both of $R_{1a}$ and $R_{1b}$ are not substituents represented by the formula (2A) and only one of $R_{1a}$ and $R_{1b}$ is a cyano group, $R_{2a}$ is a cyano group, and $R_{2b}$ is not a cyano group,
(ii) a case where only one of $R_{1a}$ and $R_{1b}$ is a cyano group, and both of $R_{2a}$ and $R_{2b}$ are cyano groups, or
(iii) a case where $R_{1a}$ is a substituent represented by the formula (2A), and $Y_2$ in the formula (2A) is -C(=O)-, $R_{1b}$ is a hydrogen atom, and $R_{2a}$ is a substituent represented by the formula (2A).

Note that cases not corresponding to any of (i) to (iii) above are also included in preferred embodiments of the onium salt (B).

The onium salt represented by the formula (2) is preferably represented by the following formula (4).

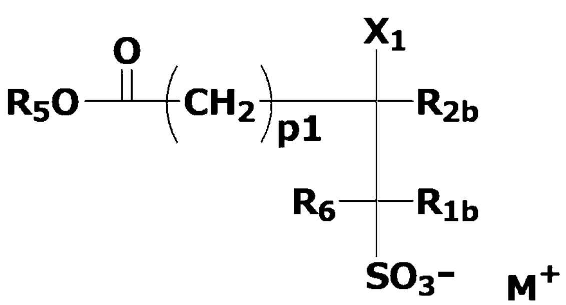

(4)

In the formula (4), $R_5$ represents an alkyl group, a cycloalkyl group, or an aryl group. p1 represents 0 or 1. $R_6$ represents a cyano group or a group represented by $-SO_2-R_7$. $R_7$ represents an alkyl group, a cycloalkyl group, or an aryl group. $R_{1b}$, $R_{2b}$, $X_1$, and $M^+$ respectively have the same meanings as $R_{1b}$, $R_{2b}$, $X_1$, and $M^+$ in the formula (2).

The descriptions and preferred ranges of the alkyl group, the cycloalkyl group, and the aryl group represented by

$R_5$ in the formula (4) are the same as the above descriptions and preferred ranges of the alkyl group, the cycloalkyl group, and the aryl group represented by $R_4$.

In the formula (4), $R_7$ in $-SO_2-R_7$ represented by $R_6$ represents an alkyl group, a cycloalkyl group, or an aryl group. The descriptions and preferred ranges of the alkyl group, the cycloalkyl group, and the aryl group represented by $R_7$ are the same as the above descriptions and preferred ranges of the alkyl group, the cycloalkyl group, and the aryl group represented by $R_4$.

The descriptions and preferred ranges of $R_{1b}$, $R_{2b}$, $X_1$, and $M^+$ in the formula (4) are respectively the same as the descriptions and preferred ranges of $R_{1b}$, $R_{2b}$, $X_1$, and $M^+$ in the formula (2).

The onium salt represented by the formula (4) preferably does not have fluorine atoms.

Specific examples of the onium salt (B) include PAG1 to PAG31 used in Examples described later, but the present invention is not limited thereto.

The onium salt (B) may be in the form of a low-molecular-weight compound, or may be in the form of being incorporated into a portion of a polymer. Alternatively, the form of a low-molecular-weight compound and the form of being incorporated into a portion of a polymer may be used in combination.

When the onium salt (B) is in the form of a low-molecular-weight compound, the molecular weight of the onium salt (B) is not particularly limited, but is, for example, preferably 5000 or less, more preferably 3000 or less, and particularly preferably 2000 or less. The onium salt (B) has a molecular weight of preferably 100 or more, and more preferably 200 or more.

When the onium salt (B) is in the form of being incorporated into a portion of a polymer, it may be incorporated into a portion of the resin (A), or may be incorporated into a resin different from the resin (A).

The onium salt (B) is preferably in the form of a low-molecular-weight compound.

The content of the onium salt (B) in the composition of the present invention is not particularly limited, but is, relative to the total solid content of the composition of the present invention, preferably 1 mass% or more and 50 mass% or less, more preferably 5 mass% or more and 45 mass% or less, and still more preferably 10 mass% or more and 40 mass% or less.

Such onium salts (B) may be used alone or may be used in combination of two or more thereof. When two or more thereof are used, the total content thereof is preferably within such a preferred content range.

The method for producing the onium salt (B) is not particularly limited, and the onium salt (B) can be synthesized by a publicly known method.

For example, a compound represented by the formula (2) where $R_{1a}$ is CN, $R_{1b}$ is H, $R_{2a}$ is $-COOR_4$, $R_{2b}$ is H, L is a single bond, and $X_1$ is H can be synthesized with reference to Non Patent Literature "Journal of Medicinal Chemistry, vol. 54 (2011), pp. 3606 to 3623".

Note that the composition of the present invention may further include, as long as advantages of the present invention are not impaired, a compound (B2) that is a compound that is irradiated with an actinic ray or a radiation to generate an acid and is different from the onium salt (B).

Specific examples of the compound (B2) include, for example, the compounds described in [0320] to [0321] of WO2022/172715A. The above description is incorporated herein.

Resin (C)

The composition of the present invention contains a resin (C) satisfying all of the following (i) to (iii):

(i) no fluorine atoms are included,
(ii) an SP value [$SP_C$] of the resin (C) is smaller than an SP value [$SP_A$] of the resin (A) and is 17.00 or less, and
(iii) a content relative to a total solid content of the actinic ray-sensitive or radiation-sensitive resin composition is 0.01 to 10 mass%.

The resin (C) is a hydrophobic resin not including fluorine atoms. Hydrophobic resins used in resist compositions are ordinarily resins including fluorine atoms; however, a hydrophobic resin not including fluorine atoms is used, so that the dispersibility of the onium salt (B) in the film thickness direction of the resist film is improved, and the LWR performance is improved.

For the resin (C), the SP value [$SP_C$] calculated by the following calculation method is smaller than the SP value [$SP_A$] of the resin (A) and is 17.00 or less.

The SP value of such a resin is calculated by the following calculation method. Calculation method of SP value of resin

1. The SP values of the repeating units constituting the resin are calculated using "HSPiP 5th Edition 5.1.08".

2. The mass-based content ratios of the repeating units relative to the resin and the SP values of the repeating units obtained in 1. above are multiplied, and the resultant values are summed up to determine the SP value of the resin.

In this way, the SP value [$SP_C$] of the resin (C) and the SP value [$SP_A$] of the resin (A) are calculated.

In 1. of the calculation method, the SP values of the repeating units constituting the resin are values calculated using the software and using the structures of the monomers corresponding to the raw material monomers of the repeating units.

When two or more resins are used in combination, in 2. of the calculation method, the mass-based content ratios of the resins and the SP values of the resins are multiplied, and the resultant values are summed up to determine the SP value of the resin.

The SP value [$SP_C$] of the resin (C) is smaller than the SP value [$SP_A$] of the resin (A).

The difference between [$SP_C$] and [$SP_A$] is, from the viewpoint of localization of the resin (C) to the film surface layer, preferably 0.5 or more, more preferably 1.0 or more, and still more preferably 1.5 or more. In addition, from the viewpoint of improving the dispersibility of the onium salt (B) in the film thickness direction of the resist film, it is preferably 5.0 or less, and more preferably 4.0 or less.

The SP value [$SP_C$] of the resin (C) is 17.00 or less, is, from the viewpoint of localization of the resin (C) to the film surface layer, preferably 16.70 or less, and more preferably 16.50 or less. In addition, from the viewpoint of improving the dispersibility of the onium salt (B) in the film thickness direction of the resist film, it is preferably 14.00 or more, and more preferably 15.00 or more.

As for the specific structure of the resin (C), it preferably has one or more of a "silicon atom" or a "$CH_3$ partial structure contained in a side chain portion of the resin".

When the resin (C) includes a silicon atom, the silicon atom in the resin (C) may be included in the main chain of the resin or may be included in a side chain.

For the partial structure having a silicon atom, preferred is a resin having an alkylsilyl structure (preferably a trialkylsilyl group) or a cyclic siloxane structure.

Examples of a repeating unit having a silicon atom include those exemplified in [0519] of US2012/0251948A.

When the resin (C) includes a silicon atom, the resin (C) preferably has a repeating unit including a silicon atom. The content of the repeating unit including a silicon atom relative to all the repeating units included in the resin (C) is preferably 10 to 100 mol%, and more preferably 20 to 100 mol%.

The resin (C) also preferably includes a $CH_3$ partial structure in a side chain portion.

The $CH_3$ partial structure of a side chain portion in the resin (C) (hereafter, also simply referred to as "side chain $CH_3$ partial structure") encompasses a $CH_3$ partial structure in an ethyl group, a propyl group, or the like.

On the other hand, a methyl group directly bonded to the main chain of the resin (C) (for example, an $\alpha$-methyl group of a repeating unit having a methacrylic acid structure) has a small contribution to the surface localization of the resin (C) due to the influence of the main chain, and thus is not encompassed in the $CH_3$ partial structure in the present invention.

More specifically, when the resin (C) includes, for example, a repeating unit derived from a monomer having a polymerizable moiety having a carbon-carbon double bond, such as a repeating unit represented by the following general formula (M), and when $R_{11}$ to $R_{14}$ are $CH_3$ "itself", the $CH_3$ are not encompassed in the $CH_3$ partial structure of a side chain portion in the present invention.

On the other hand, a $CH_3$ partial structure present via an atom from the C-C main chain corresponds to the $CH_3$ partial structure in the present invention. For example, when $R_{11}$ is an ethyl group ($CH_2CH_3$), "one" $CH_3$ partial structure in the present invention is present.

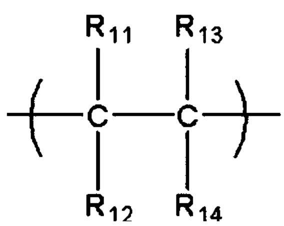

(M)

In the general formula (M),

$R_{11}$ to $R_{14}$ each independently represent a side chain portion.

Examples of $R_{11}$ to $R_{14}$ serving as side chain portions include a hydrogen atom and monovalent organic groups.

Examples of the monovalent organic groups for $R_{11}$ to $R_{14}$ include alkyl groups, cycloalkyl groups, aryl groups, alkyloxycarbonyl groups, cycloalkyloxycarbonyl groups, aryloxycarbonyl groups, alkylaminocarbonyl groups, cycloalkylaminocarbonyl groups, and arylaminocarbonyl groups, and these groups may further have a substituent.

At least two of $R_{11}$ to $R_{14}$ may be bonded together to form a ring.

The resin (C) is preferably a resin having a repeating unit having a $CH_3$ partial structure in a side chain portion, and preferably includes at least one of a repeating unit represented by the following formula (3A) or a repeating unit represented by a formula (3B).

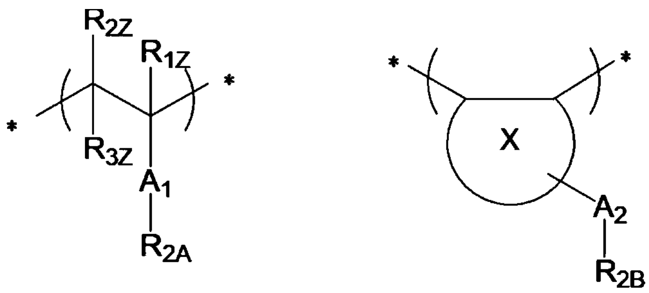

(3A) (3B)

In the formula (3A), $R_{1Z}$ represents a hydrogen atom, an alkyl group, a cycloalkyl group, or a cyano group. $R_{2Z}$ and $R_{3Z}$ each independently represent a hydrogen atom or an alkyl group. $A_1$ represents a divalent linking group. $R_{2A}$ represents an organic group including two or more $CH_3$ partial structures. At least two of $R_{1Z}$ to $R_{3Z}$ and $A_1$ may be bonded together to form a ring.

In the formula (3B), X represents an alicyclic group. $A_2$ represents a divalent linking group. $R_{2B}$ represents an organic group including two or more $CH_3$ partial structures.

In the formula (3A), $R_{1Z}$ represents a hydrogen atom, an alkyl group, a cycloalkyl group, or a cyano group.

The alkyl group represented by $R_{1Z}$ preferably has 1 to 4 carbon atoms, may be a methyl group, an ethyl group, a propyl group, a hydroxymethyl group, or the like, and is preferably a methyl group.

The cycloalkyl group represented by $R_{1Z}$ may be monocyclic or polycyclic, is preferably a cycloalkyl group having 3 to 20 carbon atoms, more preferably a cycloalkyl group having 4 to 15 carbon atoms, and still more preferably a cycloalkyl group having 5 to 10 carbon atoms. Examples of the cycloalkyl group represented by $R_1$ include a cyclopentyl group, a 1-methylcyclopentyl group, a cyclohexyl group, an adamantyl group, and a 1-ethyladamantyl group.

$R_{1Z}$ is preferably a hydrogen atom or a methyl group.

In the formula (3A), $R_{2Z}$ and $R_{3Z}$ each independently represent a hydrogen atom or an alkyl group.

The alkyl groups represented by $R_{2Z}$ and $R_{3Z}$ may be the alkyl group represented by $R_{1Z}$ and preferred examples thereof are also the same.

$R_{2Z}$ and $R_{3Z}$ are preferably hydrogen atoms.

The divalent linking group represented by $A_1$ in the formula (3A) may be -CO-, -O-, - S-, -SO-, $-SO_2-$, a hydrocarbon group (for example, an alkylene group, a cycloalkylene group, an alkenylene group, a cycloalkenylene group, or an arylene group), or a linking group in which a plurality of the foregoing are linked together.

The alkylene group may be a linear or branched alkylene group having 1 to 10 carbon atoms, and is preferably an alkylene group having 1 to 3 carbon atoms.

The cycloalkylene group may be a monocyclic or polycyclic cycloalkylene group having 3 to 15 carbon atoms.

The alkenylene group may be a linear or branched alkenylene group having 2 to 10 carbon atoms.

The cycloalkenylene group may be a monocyclic or polycyclic cycloalkenylene group having 3 to 15 carbon atoms.

The arylene group may be an arylene group having 6 to 14 carbon atoms, and is preferably a phenylene group.

The hydrocarbon group may further have a substituent. One or more methylene groups forming the alkylene group, the cycloalkylene group, the alkenylene group, and the cycloalkenylene group may be substituted with an oxygen atom, a sulfur atom, an ester group, an amide group, and/or a carbonyl group.

$A_1$ is preferably -CO-O- or a phenylene group.

In the formula (3A), $R_{2A}$ represents an organic group including two or more $CH_3$ partial structures. The organic group may be, for example, an alkyl group, a cycloalkyl group, an alkenyl group, a cycloalkenyl group, an aryl group, or an aralkyl group. The cycloalkyl group, the alkenyl group, the cycloalkenyl group, the aryl group, and the aralkyl group preferably further have, as a substituent, an alkyl group.

The alkyl group may be a branched alkyl group, and is preferably an alkyl group having 3 to 20 carbon atoms, and more preferably an alkyl group having 3 to 10 carbon atoms. Examples of the alkyl group include an isopropyl group, an isobutyl group, a sec-butyl group, a t-butyl group, a 2-ethylhexyl group, a 2,4-dimethyl-3-pentyl group, and a 2,2-dimethyl-3-butyl group.

The cycloalkyl group may be monocyclic or polycyclic, is preferably a cycloalkyl group having 3 to 20 carbon

atoms, more preferably a cycloalkyl group having 4 to 15 carbon atoms, and still more preferably a cycloalkyl group having 5 to 10 carbon atoms. Examples of the cycloalkyl group include a cyclopentyl group, a cyclohexyl group, a norbornyl group, a tricyclodecanyl group, and an adamantyl group.

The alkenyl group is preferably a linear or branched alkenyl group, preferably an alkenyl group having 2 to 20 carbon atoms, and more preferably an alkenyl group having 2 to 10 carbon atoms.

The cycloalkenyl group may be monocyclic or polycyclic, is preferably a cycloalkenyl group having 3 to 20 carbon atoms, more preferably a cycloalkenyl group having 4 to 15 carbon atoms, and still more preferably a cycloalkenyl group having 5 to 10 carbon atoms.

The aryl group is preferably an aryl group having 6 to 20 carbon atoms, more preferably an aryl group having 6 to 15 carbon atoms, and still more preferably an aryl group having 6 to 10 carbon atoms.

The aryl group in the aralkyl group is preferably an aryl group having 6 to 20 carbon atoms, more preferably an aryl group having 6 to 15 carbon atoms, and still more preferably an aryl group having 6 to 10 carbon atoms. The alkyl group in the aralkyl group may be a linear or branched alkyl group, is preferably an alkyl group having 1 to 20 carbon atoms, and more preferably an alkyl group having 1 to 10 carbon atoms.

The alkyl group serving as the substituent in the cycloalkyl group, the alkenyl group, the cycloalkenyl group, the aryl group, and the aralkyl group may be a linear or branched alkyl group, is preferably an alkyl group having 1 to 20 carbon atoms, and more preferably an alkyl group having 1 to 10 carbon atoms. One or two or more alkyl groups may serve as such substituents.

$R_{2A}$ is preferably an alkyl group or an alkyl-substituted cycloalkyl group having two or more $CH_3$ partial structures.

The organic group serving as $R_{2A}$ and having two or more $CH_3$ partial structures preferably has 2 or more and 10 or less $CH_3$ partial structures, and more preferably has 2 or more and 8 or less $CH_3$ partial structures.

In the formula (3B), X represents an alicyclic group. The alicyclic ring in the alicyclic group represented by X may be, for example, a monocyclic or polycyclic cycloalkane ring or cycloalkene ring having 3 to 20 carbon atoms, and is preferably a monocyclic or polycyclic cycloalkane ring having 5 to 10 carbon atoms.

The divalent linking group represented by $A_2$ in the formula (3B) may be the divalent linking group represented by $A_1$ in the formula (3A), and preferred examples thereof are also the same.

The organic group including two or more $CH_3$ partial structures and represented by $R_{2B}$ in the formula (3B) may be the organic group including two or more $CH_3$ partial structures and represented by $R_{2A}$ in the formula (3A), and preferred examples thereof are also the same.

The organic group having two or more $CH_3$ partial structures and serving as $R_{2B}$ preferably has 2 or more and 10 or less $CH_3$ partial structures, and more preferably has 2 or more and 8 or less $CH_3$ partial structures.

The repeating unit represented by the formula (3A) and the repeating unit represented by the formula (3B) are preferably repeating units not having acid-decomposability.

The repeating unit represented by the formula (3A) is preferably a repeating unit represented by the following formula (3C) and not having acid-decomposability.

In other words, the resin (C) preferably includes a repeating unit represented by the following formula (3C) and not having acid-decomposability.

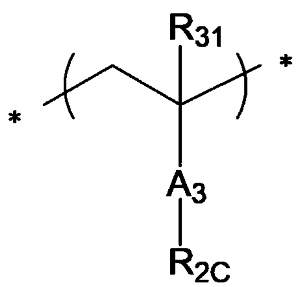

(3C)

In the formula (3C), $R_{31}$ represents a hydrogen atom, an alkyl group, a cycloalkyl group, or a cyano group. $A_3$ represents a divalent linking group. $R_{2C}$ represents an organic group including two or more $CH_3$ partial structures.

$R_{31}$, $A_3$, and $R_{2C}$ in the formula (3C) respectively have the same definitions as $R_{1Z}$, $A_1$, and $R_{2A}$ in the formula (3A), and preferred examples thereof are also the same. However, cases where any of $R_{31}$ and $-A_3-R_{2C}$ has a group that is decomposed by action of an acid to generate a polar group are excluded. Specifically, cases of having the structure having been described for the resin (A), in which a polar group is protected by an acid-decomposable group, in other words, a

group that leaves by action of an acid (leaving group), are excluded.

The following are preferred specific examples of the raw material monomer of the repeating unit represented by the formula (3A) or formula (3B). Note that the present invention is not limited thereto.

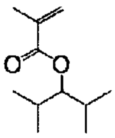
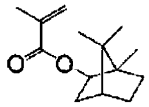
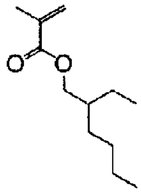
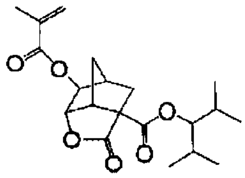

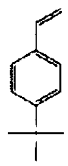
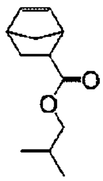
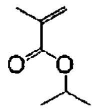
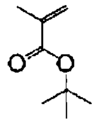

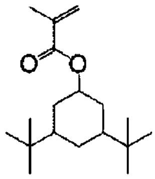
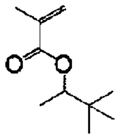
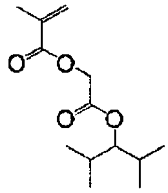

In the resin (C), the content of at least one repeating unit (x) of the repeating unit represented by the formula (3A) or the repeating unit represented by the formula (3B) relative to all the repeating units of the resin (C) is preferably 70 mol% or more, and more preferably 80 mol% or more. The content relative to all the repeating units of the resin (C) is ordinarily 100 mol% or less.

The resin (C) may have at least one group selected from the group consisting of the following (x) to (z) in a case (i) where the resin (C) includes a silicon atom and in a case (ii) where the resin (C) includes a $CH_3$ partial structure in a side chain portion:

(x) an acidic group,
(y) a group having a lactone structure, an acid anhydride group, or an acid imide group, and
(z) a group that is decomposed by action of an acid.

The acidic group (x) may be a phenolic hydroxyl group, a carboxylic acid group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, or a tris(alkylsulfonyl)methylene group.

The acidic group is preferably a sulfonimide group or a bis(alkylcarbonyl)methylene group.

The repeating unit having the acidic group (x) may be, for example, a repeating unit in which the acidic group is directly bonded to the main chain of the resin, such as a repeating unit derived from acrylic acid or methacrylic acid, or a repeating unit in which the acidic group is bonded to the main chain of the resin via a linking group; furthermore, a polymerization initiator or chain transfer agent having an acidic group can be used during polymerization to achieve introduction into a terminal of the polymer chain; the foregoing cases are all preferred. The repeating unit having the acidic group (x) may have a silicon atom.

The content of the repeating unit having the acidic group (x) relative to all the repeating units in the resin (C) is preferably 1 to 50 mol%, more preferably 3 to 35 mol%, and still more preferably 5 to 20 mol%.

The group having a lactone structure, the acid anhydride group, or the acid imide group (y) is particularly preferably a group having a lactone structure.

The repeating unit including such a group is, for example, a repeating unit in which this group is directly bonded to the main chain of the resin, such as a repeating unit derived from an acrylic acid ester or a methacrylic acid ester. Alternatively, this repeating unit may be a repeating unit in which this group is bonded to the main chain of the resin via a linking group. Alternatively, this repeating unit may be introduced into a terminal of the resin by using a polymerization initiator or chain transfer agent having this group during polymerization.

Examples of the repeating unit having the group having a lactone structure include those similar to the repeating unit having a lactone structure having been described above in the section of Resin (A) (provided that those having a fluorine atom as a substituent are excluded).

The repeating unit having the group having a lactone structure, the acid anhydride group, or the acid imide group (y) may include a $CH_3$ partial structure in a side chain portion.

The content of the repeating unit having the group having a lactone structure, the acid anhydride group, or the acid imide group relative to all the repeating units in the resin (C) is preferably 1 to 100 mol%, more preferably 3 to 98 mol%, and still more preferably 5 to 95 mol%.

In the resin (C), the repeating unit having the group (z) that is decomposed by action of an acid may be the same as the above-described repeating unit having an acid-decomposable group for the resin (A). The repeating unit having the group (z) that is decomposed by action of an acid may have a silicon atom, and may include a $CH_3$ partial structure in a side chain portion. The content of the repeating unit having the group (z) that is decomposed by action of an acid in the resin (C) relative to all the repeating units in the resin (C) is preferably 1 to 80 mol%, more preferably 10 to 80 mol%, and still more preferably 20 to 60 mol%.

The resin (C) may or may not have the group (z) that is decomposed by action of an acid, but preferably does not have the group.

In other words, the resin (C) preferably does not have acid-decomposability.

The resin (C) may further have a repeating unit other than the above-described repeating units.

The standard polystyrene-equivalent weight-average molecular weight of the resin (C) is preferably 1,000 to 100,000, and more preferably 1,000 to 50,000.

The content of the resin (C) in the composition relative to the total solid content in the composition of the present invention is 0.01 to 10 mass%, more preferably 0.05 to 8 mass%, and still more preferably 0.1 to 7 mass%.

Such resins (C) may be used alone or may be used in combination of two or more thereof. When two or more thereof are used, the total content thereof is preferably within such a preferred content range.

The mass ratio ((C)/(B)) of the resin (C) to the content of the onium salt (B) included in the composition of the present invention is preferably 0.05 to 3.0 from the viewpoint of improvement in LWR performance. The mass ratio is more preferably 0.1 to 3.0, and still more preferably 0.15 to 2.8.

The resin (C) contains residual monomers and oligomer components in an amount of preferably 0.01 to 5 mass%, and more preferably 0.01 to 3 mass%. The molecular weight distribution (Mw/Mn, also referred to as dispersity) is preferably in the range of 1 to 5, and more preferably in the range of 1 to 3.

The resin (C) can be various commercially available products or can be synthesized in accordance with standard procedures (for example, radical polymerization).

Acid diffusion control agent

The composition of the present invention may include an acid diffusion control agent.

The acid diffusion control agent serves as a quencher that traps the acid generated from the photoacid generator or the like upon exposure and that suppresses the reaction of the acid-decomposable resin in the unexposed regions, the reaction being caused by an excess of generated acid.

The type of the acid diffusion control agent is not particularly limited, and examples thereof include a basic compound (DA), a low-molecular-weight compound (DB) having a nitrogen atom and having a group that leaves by action of an acid, and a compound (DC) whose acid diffusion control ability is reduced or lost upon irradiation with an actinic ray or a radiation.

Examples of the compound (DC) include an onium salt compound (DD) that becomes a weak acid relative to the photoacid generator, and a basic compound (DE) whose basicity is reduced or lost upon irradiation with an actinic ray or a radiation.

Specific examples of the basic compound (DA) include, for example, those described in Paragraphs [0132] to [0136] of WO2020/066824A; specific examples of the basic compound (DE) whose basicity is reduced or lost upon irradiation with an actinic ray or a radiation include those described in Paragraphs [0137] to [0155] of WO2020/066824A, and those described in Paragraph [0164] of WO2020/066824A; and, specific examples of the low-molecular-weight compound (DB) having a nitrogen atom and having a group that leaves by action of an acid include those described in Paragraphs [0156] to [0163] of WO2020/066824A.

Specific examples of the onium salt compound (DD) that becomes a weak acid relative to the photoacid generator include, for example, those described in Paragraphs [0305] to [0314] of WO2020/158337A.

In addition to those described above, for example, the publicly known compounds disclosed in Paragraphs [0627] to [0664] in US2016/0070167A, Paragraphs [0095] to [0187] in US2015/0004544A, Paragraphs [0403] to [0423] in US2016/0237190A, and Paragraphs [0259] to [0328] in US2016/0274458A can be suitably used as acid diffusion control agents.

When the composition of the present invention includes an acid diffusion control agent, the content of the acid diffusion control agent (when there are a plurality of acid diffusion control agents, the total content thereof) is, relative to the total solid content of the composition of the present invention, preferably 0.1 to 30.0 mass%, more preferably 0.1 to 15.0 mass%, and still more preferably 1.0 to 15.0 mass%.
Such acid diffusion control agents may be used alone or may be used in combination of two or more thereof. When two or more thereof are used, the total content thereof is preferably within such a preferred content range.

Surfactant

The composition of the present invention may include a surfactant. In the case of including a surfactant, a pattern having higher adhesiveness and a less number of development defects can be formed.
The surfactant is preferably a fluorine-based and/or silicone-based surfactant.
Examples of the fluorine-based and/or silicone-based surfactant include the surfactants disclosed in Paragraphs [0218] and [0219] of WO2018/193954A.
Such surfactants may be used alone or may be used in combination of two or more thereof.
When the composition of the present invention includes a surfactant, the surfactant content relative to the total solid content of the composition of the present invention is preferably 0.0001 to 2.0 mass%, more preferably 0.0005 to 1.0 mass%, and still more preferably 0.1 to 1.0 mass%.
Such surfactants may be used alone or may be used in combination of two or more thereof. When two or more thereof are used, the total content thereof is preferably within such a preferred content range.
As described above, as the surfactant, a fluorine-based surfactant may be used, but the fluorine atom content relative to the total solid content of the composition of the present invention is preferably adjusted so as to be in a range satisfying a range described later. Solvent
The composition of the present invention preferably includes a solvent.
The solvent preferably includes at least one of (M1) a propylene glycol monoalkyl ether carboxylate or (M2) at least one selected from the group consisting of a propylene glycol monoalkyl ether, a lactate, an acetate, an alkoxypropionate, a chain ketone, a cyclic ketone, a lactone, and an alkylene carbonate. Note that the solvent may further include a component other than the components (M1) and (M2).
A combination of the above-described solvent and the above-described resin is preferred from the viewpoint of improving the coatability of the composition of the present invention and reducing the number of pattern development defects. The above-described solvent is well-balanced in terms of solubility of the above-described resin, boiling point, and viscosity, to thereby suppress, for example, unevenness of the film thickness of the resist film and generation of deposit during spin-coating.
Details of the component (M1) and the component (M2) are described in Paragraphs [0218] to [0226] in WO2020/004306A, and these contents are incorporated herein.
When the solvent further includes a component other than the components (M1) and (M2), the content of the component other than the components (M1) and (M2) relative to the total amount of the solvent is preferably 5 to 30 mass%.
The content of the solvent in the composition of the present invention is set such that the solid-content concentration is preferably 0.5 to 30 mass%, and more preferably 1 to 20 mass%. This further improves the coatability of the composition of the present invention. Other additives
The composition of the present invention may further include a dissolution-inhibiting compound, a dye, a plasticizer, a photosensitizer, a light absorbent, and/or a compound that promotes solubility in a developer (for example, a phenol compound having a molecular weight of 1000 or less, or an alicyclic or aliphatic compound including a carboxyl group).
The "dissolution-inhibiting compound" is a compound that is decomposed by action of an acid to cause a decrease in the degree of solubility in organic-based developers, and has a molecular weight of 3000 or less.
The composition of the present invention preferably has a fluorine atom content of, relative to the total solid content of the composition, 1.00 mass% or less from the viewpoint of exhibiting advantages of the present invention. The fluorine atom content relative to the total solid content of the composition is more preferably 0.50 mass% or less, and still more preferably 0.10 mass% or less. The lower limit is not particularly limited, but preferred is no content of fluorine atoms.
The fluorine atom content represents the mass ratio of fluorine atoms in the total solid content to all atoms of the total solid content in the composition. For example, when the total solid content in the composition is constituted by carbon atoms, hydrogen atoms, fluorine atoms, nitrogen atoms, oxygen atoms, and sulfur atoms, the fluorine atom content (mass%) can be calculated by the following formula:

$$100 \times 19 \times [F]/(12 \times [C] + 1 \times [H] + 19 \times [F] + 14 \times [N] + 16 \times [O] + 32 \times [S])$$

[C] represents the molar ratio of carbon atoms in the total solid content, [H] represents the molar ratio of hydrogen atoms in the total solid content, [F] represents the molar ratio of fluorine atoms in the total solid content, [N] represents the molar ratio of nitrogen atoms in the total solid content, [O] represents the molar ratio of oxygen atoms in the total solid content, and [S] represents the molar ratio of sulfur atoms in the total solid content. The molar ratio [C] of carbon atoms in the total solid content can be calculated from the number of carbon atoms, the molecular weight, and the content of each constituent component in the solid content. For example, the molar ratio of carbon atoms of the onium salt (B) can be calculated by the following formula.

$$B_w/B_M \times B_C$$

$B_w$ represents the amount (g or mass%) of the onium salt (B) in the total solid content; $B_M$ represents the molecular weight of the onium salt (B); and $B_C$ represents the number of carbon atoms of the onium salt (B). For the other constituent components, similarly, the molar ratio of carbon atoms can be calculated and summed up to thereby calculate the molar ratio [C] of carbon atoms in the total solid content. In the formula, the carbon atoms can be replaced by other atoms to thereby similarly calculate the molar ratios of the other atoms. Even when the total solid content in the composition includes atoms other than those described above, the atomic weight and molar ratio in the total solid content of the atoms can be used to similarly achieve the calculation. Alternatively, instead of the above-described method, for example, an analytical method such as elemental analysis on a resist film obtained by evaporating the solvent component of the composition can also be used to achieve the calculation.

The composition of the present invention is also suitably used as a photosensitive composition for EUV exposure.

Actinic ray-sensitive or radiation-sensitive film and pattern forming method

The present invention also relates to an actinic ray-sensitive or radiation-sensitive film formed from the composition of the present invention. The actinic ray-sensitive or radiation-sensitive film of the present invention is preferably a resist film.

The procedures of the pattern forming method using the composition of the present invention are not particularly limited, but preferably have the following steps:

Step 1: a step of using the composition of the present invention to form a resist film on a substrate;
Step 2: a step of exposing the resist film; and
Step 3: a step of developing the exposed resist film using a developer.

Hereinafter, procedures of the steps will be individually described in detail.

Step 1: Resist film formation step

The step 1 is a step of using the composition of the present invention to form a resist film on a substrate.

Examples of the method of using the composition of the present invention to form a resist film on a substrate include a method of applying the composition of the present invention onto a substrate.

Note that the composition of the present invention is preferably filtered through a filter before application as needed. The filter preferably has a pore size of 0.1 μm or less, more preferably 0.05 μm or less, and still more preferably 0.03 μm or less. The filter is preferably formed of polytetrafluoroethylene, polyethylene, or nylon.

The composition of the present invention can be applied onto a substrate (for example, formed of silicon or silicon dioxide-covered silicon) used in the production of integrated circuit elements by an appropriate application method using a spinner, a coater, or the like. The application process is preferably spin-coating using a spinner. The spin-coating using a spinner is preferably performed at a rotation rate of 1000 to 3000 rpm (rotations per minute).

After application of the composition of the present invention, the substrate may be dried to form a resist film. Note that, as needed, as underlayers of the resist film, various underlying films (an inorganic film, an organic film, or an antireflection film) may be formed.

The drying process may be, for example, a process of performing heating to achieve drying. The heating can be performed using means included in an ordinary exposure device and/or an ordinary development device, or may alternatively be performed using a hot plate, for example. The heating temperature is preferably 80 to 150°C, more preferably 80 to 140°C, and still more preferably 80 to 130°C. The heating time is preferably 30 to 1000 seconds, more preferably 60 to 800 seconds, and still more preferably 60 to 600 seconds.

The film thickness of the resist film is not particularly limited, but is, from the viewpoint of enabling formation of more precise fine patterns, preferably 10 to 120 nm. In particular, in the case of employing EUV exposure, the film thickness of the resist film is more preferably 10 to 65 nm, and still more preferably 15 to 50 nm. In the case of employing ArF liquid

immersion exposure, the film thickness of the resist film is more preferably 10 to 120 nm, and still more preferably 15 to 90 nm.

Note that, for an overlying layer of the resist film, a topcoat composition may be used to form a topcoat.

The topcoat composition preferably does not mix with the resist film, and can be uniformly applied for an overlying layer of the resist film. The topcoat is not particularly limited; a publicly known topcoat can be formed by a publicly known process; for example, on the basis of descriptions of Paragraphs [0072] to [0082] in JP2014-059543A, a topcoat can be formed.

For example, a topcoat including a basic compound and described in JP2013-61648A is preferably formed on the resist film. Specific examples of the basic compound that can be included in the topcoat include basic compounds that may be included in the composition of the present invention.

The topcoat also preferably includes a compound including at least one group or bond selected from the group consisting of an ether bond, a thioether bond, a hydroxy group, a thiol group, a carbonyl bond, and an ester bond.

Step 2: Exposure step

The step 2 is a step of exposing the resist film.

The exposure process may be a process of irradiating the formed resist film, through a predetermined mask, with an actinic ray or a radiation.

Examples of the actinic ray or the radiation include infrared light, visible light, ultraviolet light, far-ultraviolet light, extreme ultraviolet light, X-rays, and electron beams; preferred is 250 nm or less; more preferred is 220 nm or less; particularly preferred is far-ultraviolet light having wavelengths of 1 to 200 nm; and specific examples thereof include the KrF excimer laser (248 nm), the ArF excimer laser (193 nm), an $F_2$ excimer laser (157 nm), EUV (13.5 nm), X-rays, and electron beams.

After the exposure, before development, baking (heating) is preferably performed. The baking accelerates the reaction in the exposed regions, to provide higher sensitivity and a better pattern profile.

The heating temperature is preferably 80 to 150°C, more preferably 80 to 140°C, and still more preferably 80 to 130°C.

The heating time is preferably 10 to 1000 seconds, more preferably 10 to 180 seconds, and still more preferably 30 to 120 seconds.

The heating can be performed using means included in an ordinary exposure device and/or an ordinary development device, and may alternatively be performed using a hot plate, for example.

This step is also referred to as post-exposure baking.

Step 3: Development step

The step 3 is a step of using a developer to develop the exposed resist film, to form a pattern.

The developer may be an alkali developer or may be a developer containing an organic solvent (hereafter, also referred to as organic-based developer).

Examples of the development process include a process of immersing, for a predetermined time, the substrate in a tank filled with the developer (dipping process), a process of puddling, with the developer, the surface of the substrate using surface tension and leaving the developer at rest for a predetermined time to achieve development (puddling process), a process of spraying the developer to the surface of the substrate (spraying process), and a process of scanning, at a constant rate, over the substrate rotated at a constant rate, a developer ejection nozzle to continuously eject the developer (dynamic dispensing process).

After the step of performing development, a step of performing exchange with another solvent to stop the development may be performed.

The development time is not particularly limited as long as the resin in the unexposed regions is sufficiently dissolved in the time, and is preferably 10 to 300 seconds, and more preferably 20 to 120 seconds.

The temperature of the developer is preferably 0 to 50°C, and more preferably 15 to 35°C.

The alkali developer employed is preferably an alkali aqueous solution including an alkali. The type of the alkali aqueous solution is not particularly limited, but may be, for example, an alkali aqueous solution including a quaternary ammonium salt represented by tetramethylammonium hydroxide, an inorganic alkali, a primary amine, a secondary amine, a tertiary amine, an alcoholamine, a cyclic amine, or the like. In particular, the alkali developer is preferably an aqueous solution of a quaternary ammonium salt represented by tetramethylammonium hydroxide (TMAH). To the alkali developer, an appropriate amount of an alcohol, a surfactant, or the like may be added. The alkali developer ordinarily preferably has an alkali concentration of 0.1 to 20 mass%. The alkali developer ordinarily preferably has a pH of 10.0 to 15.0.

The organic-based developer is preferably a developer containing at least one organic solvent selected from the

group consisting of ketone-based solvents, ester-based solvents, alcohol-based solvents, amide-based solvents, ether-based solvents, and hydrocarbon-based solvents.

A plurality of such solvents may be mixed together, or such a solvent may be mixed with a solvent other than those described above or water. The developer as a whole has a moisture content of preferably less than 50 mass%, more preferably less than 20 mass%, still more preferably less than 10 mass%, and particularly preferably contains substantially no moisture.

In the organic-based developer, the content of the organic solvent relative to the total amount of the developer is preferably 50 mass% or more and 100 mass% or less, more preferably 80 mass% or more and 100 mass% or less, still more preferably 90 mass% or more and 100 mass% or less, and particularly preferably 95 mass% or more and 100 mass% or less.

Other step

The pattern forming method preferably includes a step of, after the step 3, using a rinse liquid to perform rinsing.

After the development step using an alkali developer, in the rinsing step, the rinse liquid employed may be, for example, pure water. Note that, to the pure water, an appropriate amount of surfactant may be added.

To the rinse liquid, an appropriate amount of surfactant may be added.

After the development step using an organic-based developer, in the rinsing step, the rinse liquid employed is not particularly limited as long as it does not dissolve the pattern, and may be a solution including an ordinary organic solvent. The rinse liquid employed is preferably a rinse liquid containing at least one organic solvent selected from the group consisting of hydrocarbon-based solvents, ketone-based solvents, ester-based solvents, alcohol-based solvents, amide-based solvents, and ether-based solvents.

The process of performing the rinsing step is not particularly limited; examples include a process of continuously ejecting, onto the substrate rotated at a constant rate, the rinse liquid (spin-coating process), a process of immersing, in a tank filled with the rinse liquid, the substrate for a predetermined time (dipping process), and a process of spraying, to the surface of the substrate, the rinse liquid (spraying process).

The pattern forming method may include a heating step (Post Bake) performed after the rinsing step. In this step, baking removes the developer and the rinse liquid remaining between the patterns and within the patterns. In addition, this step also provides an effect of annealing the resist pattern to address the rough surface of the pattern. The heating step after the rinsing step is performed ordinarily at 40 to 250°C (preferably 90 to 200°C) for ordinarily 10 seconds to 3 minutes (preferably 30 seconds to 120 seconds).

The formed pattern may be used as a mask for subjecting the substrate to etching treatment. Specifically, the pattern formed in the step 3 may be used as a mask for processing the substrate (or the underlayer film and the substrate), to form a pattern in the substrate.

The process of processing the substrate (or the underlayer film and the substrate) is not particularly limited, but is preferably a process of using the pattern formed in the step 3 as a mask for subjecting the substrate (or the underlayer film and the substrate) to dry etching, to thereby form a pattern in the substrate. The dry etching is preferably oxygen plasma etching.

Various materials used in the composition and the pattern forming method of the present invention (for example, a solvent, a developer, a rinse liquid, an antireflection film-forming composition, and a topcoat-forming composition) preferably do not include impurities such as metals. The content of impurities included in such materials is preferably 1 mass ppm (parts per million) or less, more preferably 10 mass ppb (parts per billion) or less, still more preferably 100 mass ppt or less, particularly preferably 10 mass ppt or less, and most preferably 1 mass ppt or less. The lower limit is not particularly limited, but is preferably 0 mass ppt or more. Examples of the metallic impurities include Na, K, Ca, Fe, Cu, Mg, Al, Li, Cr, Ni, Sn, Ag, As, Au, Ba, Cd, Co, Pb, Ti, V, W, and Zn.

The process of removing, from the various materials, impurities such as metals may be, for example, filtration using a filter. The details of filtration using a filter are described in Paragraph [0321] in WO2020/004306A.

Examples of the process of reducing the amount of impurities such as metals included in the various materials include a process of selecting, as raw materials constituting the various materials, raw materials having lower metal content, a process of subjecting raw materials constituting the various materials to filtration using a filter, and a process of performing distillation under conditions under which contamination is minimized by, for example, lining the interior of the apparatuses with TEFLON (registered trademark).

Instead of the filtration using a filter, an adsorption material may be used to remove impurities; alternatively, the filtration using a filter may be used in combination with an adsorption material. Such adsorption materials can be publicly known adsorption materials, and examples include inorganic-based adsorption materials such as silica gel and zeolite, and organic-based adsorption materials such as active carbon. In order to reduce the amount of impurities such as metals included in the various materials, ingress of metallic impurities in the production steps needs to be prevented. Whether or not metallic impurities are sufficiently removed from the production apparatuses can be determined by measuring the

content of metallic components included in the washing liquid having been used for washing the production apparatuses. The content of metallic components included in the washing liquid having been used is preferably 100 mass ppt (parts per trillion) or less, more preferably 10 mass ppt or less, and still more preferably 1 mass ppt or less. The lower limit is not particularly limited, but is preferably 0 mass ppt or more.

To organic-based treatment liquids such as the rinse liquid, in order to prevent electrostatic buildup and the subsequent electrostatic discharge causing failure of the chemical solution pipe and various parts (such as a filter, an O-ring, and a tube), a conductive compound may be added. The conductive compound is not particularly limited, but may be, for example, methanol. The amount of addition is not particularly limited, but is, from the viewpoint of maintaining preferred development performance or rinsing performance, preferably 10 mass% or less, and more preferably 5 mass% or less. The lower limit is not particularly limited, but is preferably 0.01 mass% or more.

Examples of the chemical solution pipe include various pipes formed of SUS (stainless steel), or coated with polyethylene, polypropylene, or a fluororesin (such as polytetrafluoroethylene or a perfluoroalkoxy resin) treated so as to be antistatic. Similarly for the filter and the O-ring, polyethylene, polypropylene, or a fluororesin (such as polytetrafluoroethylene or a perfluoroalkoxy resin) treated so as to be antistatic can be used. Method for producing electronic device

The present invention also relates to a method for producing an electronic device, the method including the above-described pattern forming method, and an electronic device produced by the production method.

In preferred embodiments, an electronic device according to the present invention is mounted on electric and electronic apparatuses (home appliances, OA (Office Automation), media-related apparatuses, optical apparatuses, communication apparatuses, and the like).

## EXAMPLES

Hereinafter, the present invention will be described further in detail with reference to Examples. In the following Examples, materials, usage amounts, ratios, details of treatments, orders of treatments, and the like can be appropriately changed without departing from the spirit and scope of the present invention. Thus, the scope of the present invention is not construed as being limited to the following Examples.

### Various components of actinic ray-sensitive or radiation-sensitive resin compositions

### Resin (A)

The resin (A) (resins A-1 to A-20) in Tables 3 and 4 will be described below.

The resins A-1 to A-20 employed were synthesized in accordance with a method for synthesizing the resin A-1 (Synthesis Example 1) described later. Table 1 will describe the compositional ratios (molar ratios; sequentially described from the left) of repeating units described later, the weight-average molecular weights (Mw), and the dispersities (Mw/Mn).

Note that the weight-average molecular weights (Mw) and dispersities (Mw/Mn) of the resins A-1 to A-20 were measured by GPC (carrier: tetrahydrofuran (THF)) (polystyrene-equivalent amounts). The compositional ratios (mol% ratios) of the resins were measured by $^{13}$C-NMR (nuclear magnetic resonance).

Table 1 will also describe the SP values [$SP_A$] of the resins A-1 to A-20.

The SP values ([$SP_A$]) of the resins are calculated by the following calculation method. Calculation method of SP values of resins

1. The SP values of the repeating units constituting such a resin are calculated using "HSPiP 5th Edition 5.1.08".
2. The mass-based content ratios of the repeating units relative to the resin and the SP values of the repeating units obtained in 1. above are multiplied, and the resultant values are summed up to determine the SP value of the resin.

In this way, the SP value [$SP_A$] of the resin (A) is calculated.

In 1. of the calculation method, the SP values of the repeating units constituting the resin are values calculated, using the software, using the structures of the monomers corresponding to the raw material monomers of the repeating units.

When two or more resins are used in combination, in 2. of the method, the mass-based content ratios of the resins and the SP values of the resins are multiplied, and the resultant values are summed up to determine the SP value of the resin.

Table 1

| Table 1 | Molar ratio of repeating units | | | | Mw | Mw/Mn | [$SP_A$] |
|---|---|---|---|---|---|---|---|
| Resin A-1 | 50 | 50 | - | - | 6500 | 1.52 | 18.05 |

(continued)

| Table 1 | Molar ratio of repeating units | | | | Mw | Mw/Mn | [$SP_A$] |
|---|---|---|---|---|---|---|---|
| Resin A-2 | 45 | 55 | - | - | 8300 | 1.65 | 18.78 |
| Resin A-3 | 40 | 30 | 30 | - | 7800 | 1.55 | 18.72 |
| Resin A-4 | 40 | 50 | 10 | - | 12000 | 1.68 | 17.59 |
| Resin A-5 | 50 | 50 | - | - | 5500 | 1.49 | 18.95 |
| Resin A-6 | 25 | 30 | 30 | 15 | 8600 | 1.63 | 18.96 |
| Resin A-7 | 40 | 10 | 30 | 20 | 9600 | 1.72 | 18.28 |
| Resin A-8 | 40 | 5 | 55 | - | 10200 | 1.64 | 17.99 |
| Resin A-9 | 30 | 20 | 40 | 10 | 7500 | 1.54 | 19.00 |
| Resin A-10 | 40 | 10 | 40 | 10 | 7000 | 1.61 | 18.10 |
| Resin A-11 | 40 | 10 | 10 | 40 | 6500 | 1.63 | 18.39 |
| Resin A-12 | 40 | 30 | 30 | - | 5900 | 1.59 | 18.59 |
| Resin A-13 | 10 | 30 | 60 | - | 5200 | 1.53 | 18.33 |
| Resin A-14 | 25 | 15 | 60 | - | 6200 | 1.48 | 18.83 |
| Resin A-15 | 50 | 50 | - | - | 7000 | 1.73 | 18.62 |
| Resin A-16 | 30 | 10 | 60 | - | 11500 | 1.56 | 19.35 |
| Resin A-17 | 35 | 10 | 55 | - | 8400 | 1.58 | 19.09 |
| Resin A-18 | 40 | 10 | 50 | - | 9200 | 1.66 | 19.57 |
| Resin A-19 | 40 | 60 | - | - | 6500 | 1.55 | 19.12 |
| Resin A-20 | 30 | 20 | 50 | - | 7600 | 1.56 | 19.56 |

The structural formulas of Resins A-1 to A-20 described in Table 1 are as follows.

**A-1**

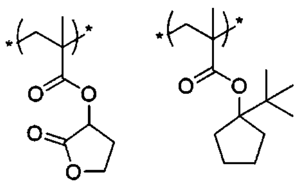

**A-2**

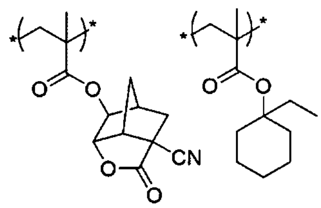

**A-3**

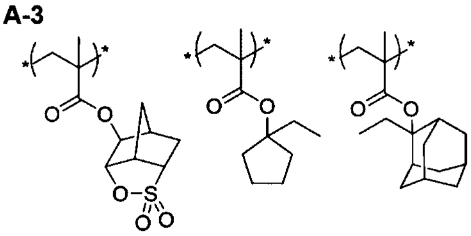

**A-4**

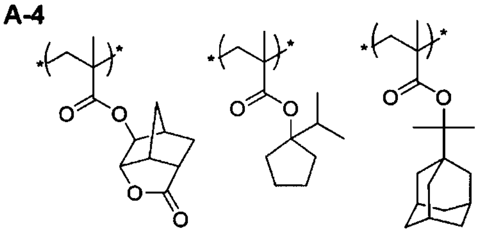

**A-5**

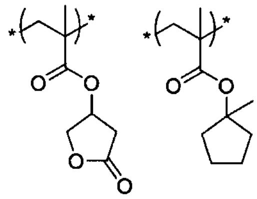

**A-6**

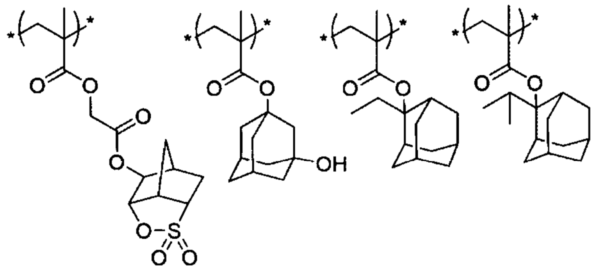

**A-7**

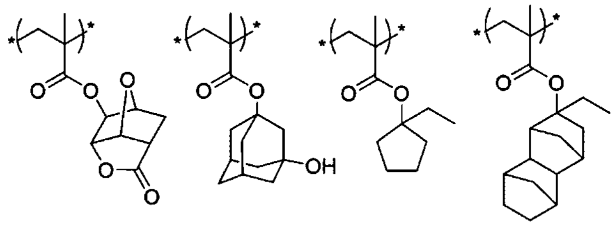

**A-8**

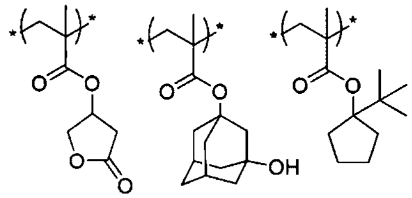

**A-9**

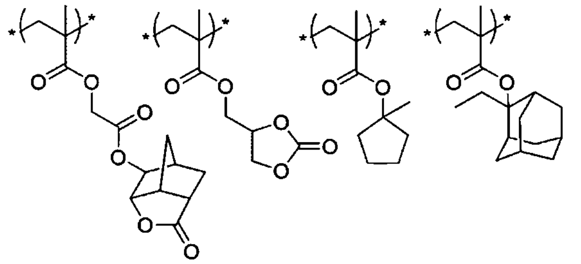

**A-10**

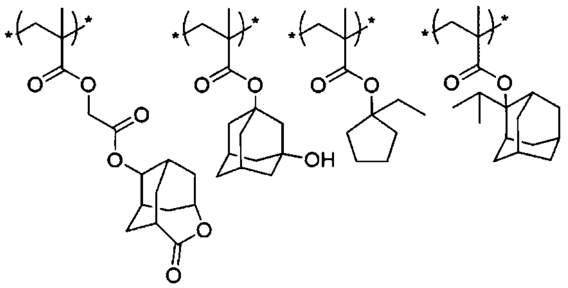

**A-11**

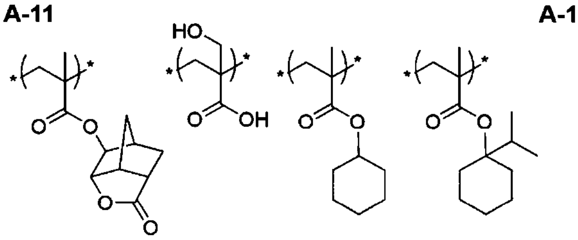

**A-12**

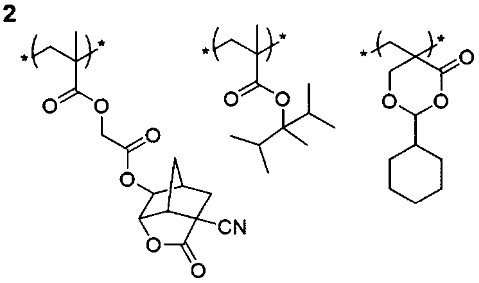

**A-13**

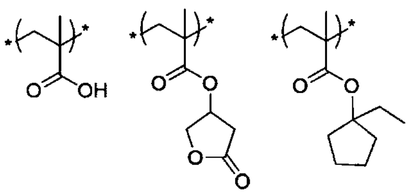

**A-14**

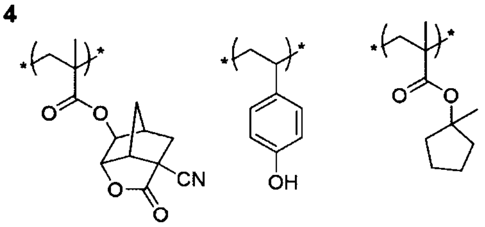

A-15

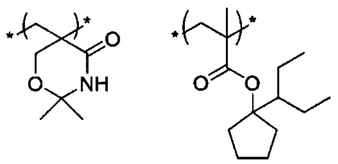

A-16

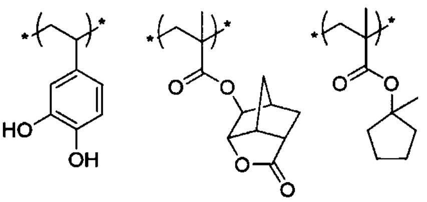

A-17

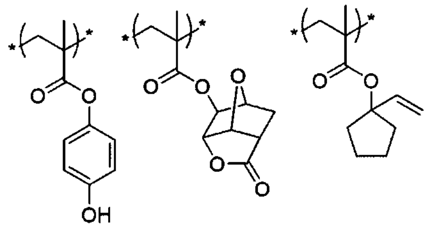

A-18

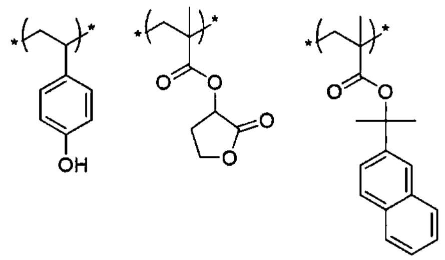

A-19

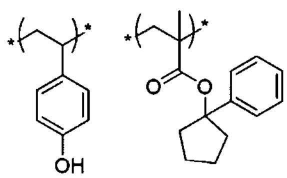

A-20

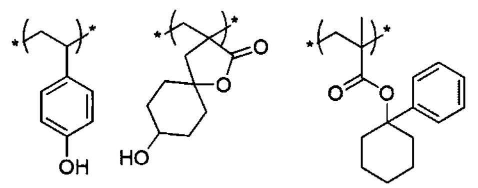

Synthesis Example 1: Synthesis of resin A-1

Cyclohexanone (113 g) was heated to 80 °C under a nitrogen stream. To this liquid under stirring, a mixed solution of a monomer (25.5 g) represented by the following formula M-1, a monomer (31.6 g) represented by the following formula M-2, cyclohexanone (210 g), and dimethyl 2,2'-azobisisobutyrate [V-601, manufactured by Wako Pure Chemical Industries, Ltd.] (6.21 g) was added dropwise over 6 hours to obtain a reaction solution. After completion of the dropwise addition, the reaction solution was further stirred at 80°C for 2 hours. The obtained reaction solution was left to cool, subsequently subjected to reprecipitation using a large amount of methanol/water (mass ratio of 9:1), subsequently filtered, and the obtained solid was vacuum-dried to thereby obtain 52 g of the resin A-1.

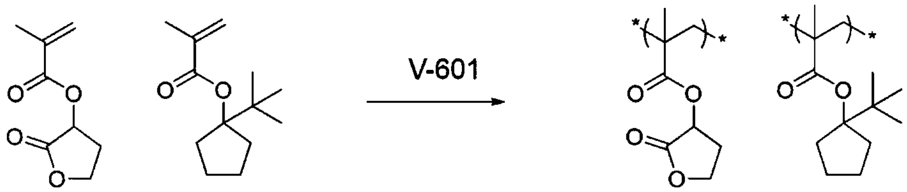


M-1 M-2 A-1

The obtained resin A-1 was subjected to GPC (carrier: tetrahydrofuran (THF)) and found to have a weight-average molecular weight (Mw: polystyrene-equivalent) of 6500 and a dispersity (Mw/Mn) of 1.52. The compositional ratio measured by $^{13}$C-NMR (nuclear magnetic resonance) was 50/50 in terms of molar ratio.

Onium salt (B)

The onium salt (B) employed were PAG1 to PAG31. The structures of PAG1 to PAG31 in Tables 3 and 4 will be described below. PAG1 to PAG31 are photoacid generators.

In Comparative Examples, a photoacid generator that is not the onium salt (B), PAGR2, was used. For

convenience, Table 4 below will describe PAGR2 also in the column of Onium salt (B).

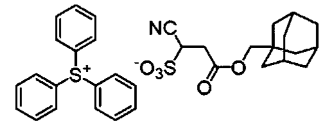

PAG1

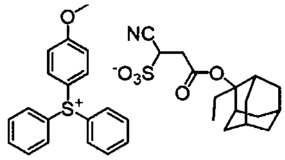

PAG2

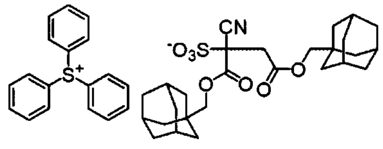

PAG3

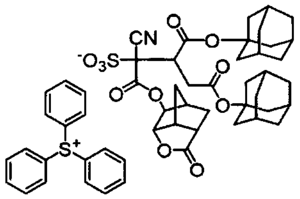

PAG4

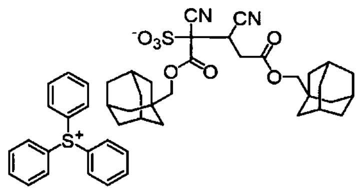

PAG5

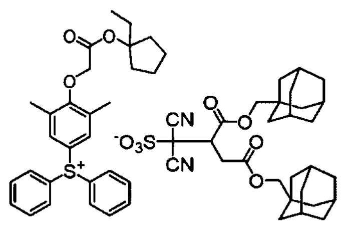

PAG6

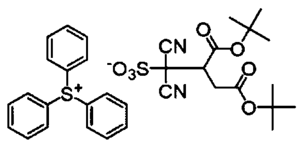

PAG7

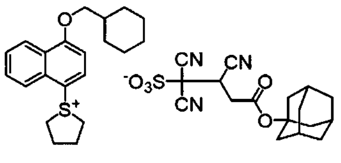

PAG8

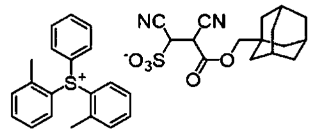

PAG9

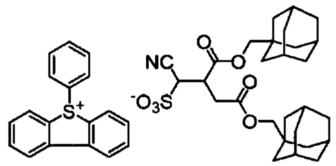

PAG10

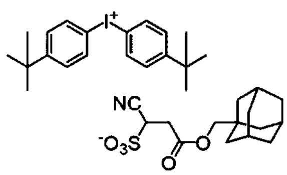

PAG11

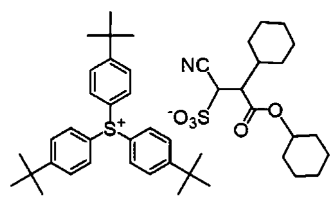

PAG12

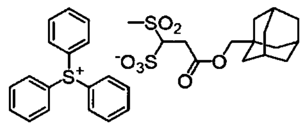

PAG13

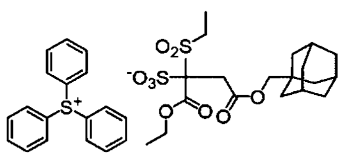

PAG14

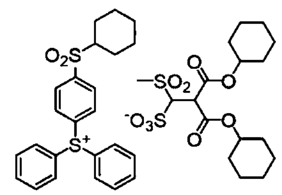

PAG15

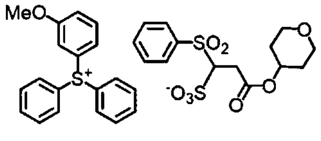

PAG16

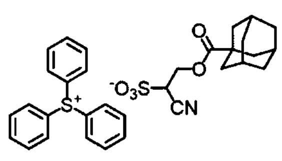

PAG17

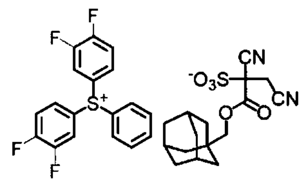

PAG18

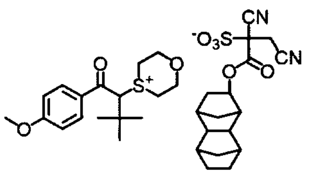

PAG19

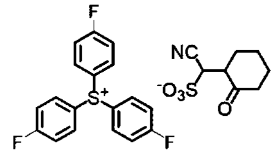

PAG20

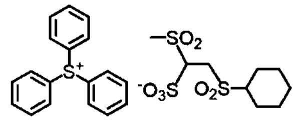

PAG21

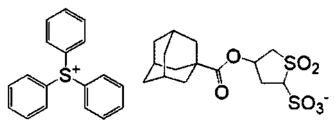

PAG22

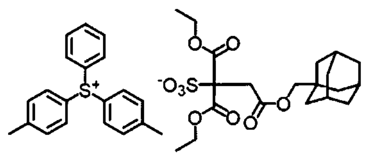

PAG23

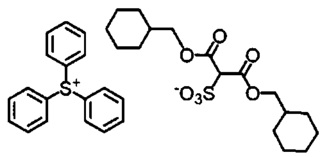

PAG24

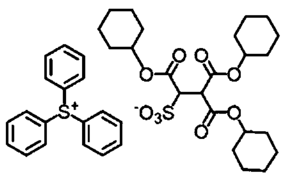

PAG25

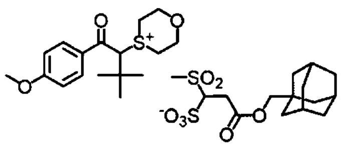

PAG26

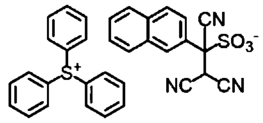

PAG27

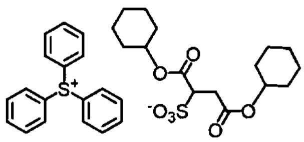

PAG28

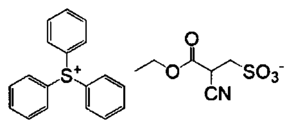

PAG29

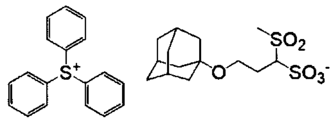

PAG30

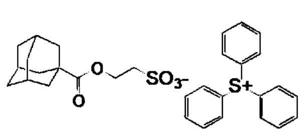

PAG 31

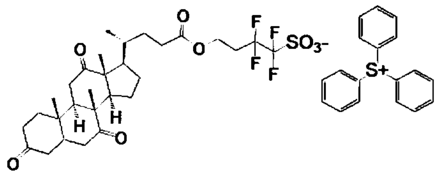

PAG R2

Acid diffusion control agent

The structures of the acid diffusion control agents (Compounds B-1 to B-7) in Tables 3 and 4 will be described below.

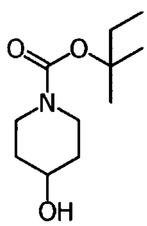

**B-1**

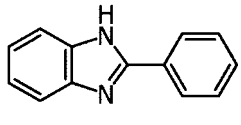

**B-2**

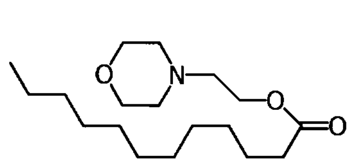

**B-3**

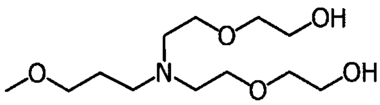

**B-4**

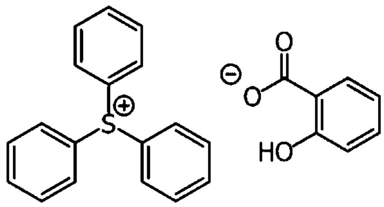

**B-5**

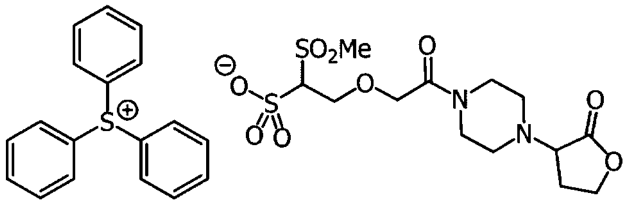

**B-6**

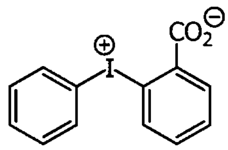

**B-7**

Resin (C)

The resin (C) employed were hydrophobic resins C-1 to C-12. In Comparative Examples, hydrophobic resins not corresponding to the resin (C), CR-1 to CR-2, were used. For convenience, Table 4 below will describe CR-1 to CR-2 also in the column of Resin (C).

The hydrophobic resins (C-1 to C-12 and CR-1 to CR-2) described in Tables 3 and 4 were synthesized.

Table 2 will describe the molar ratios of the repeating units, weight-average molecular weights (Mw), and dispersities (Mw/Mn) in the hydrophobic resins described in Tables 3 and 4.

Note that the weight-average molecular weights (Mw) and dispersities (Mw/Mn) of the hydrophobic resins C-1 to C-12 and CR-1 to CR-2 were measured by GPC (carrier: tetrahydrofuran (THF)) (polystyrene-equivalent amounts). The compositional ratios (mol% ratios) of the resins were measured by $^{13}$C-NMR (nuclear magnetic resonance).

Table 2 will also describe the SP values [$SP_c$] of the hydrophobic resins C-1 to C-12 and CR-1 to CR-2.

The SP values ([$SP_c$]) of the resins are calculated by the following calculation method. Calculation method of SP values of resins

1. The SP values of the repeating units constituting such a resin are calculated using "HSPiP 5th Edition 5.1.08".
2. The mass-based content ratios of the repeating units relative to the resin and the SP values of the repeating units obtained in 1. above are multiplied, and the resultant values are summed up to determine the SP value of the resin.

In this way, the SP value [$SP_C$] of the resin (C) is calculated.

In 1. of the calculation method, the SP values of the repeating units constituting the resin are values calculated using the software and using the structures of the monomers corresponding to the raw material monomers of the repeating units.

When two or more resins are used in combination, in 2. of the calculation method, the mass-based content ratios of the resins and the SP values of the resins are multiplied, and the resultant values are summed up to determine the SP value of the resin.

Table 2

| Table 2 | Unit 1 | mol% | Unit 2 | mol% | Unit 3 | mol% | Unit 4 | mol% | [$SP_C$] | Mw | Mw/Mn |
|---|---|---|---|---|---|---|---|---|---|---|---|
| C-1 | Z-1 | 100 | | | | | | | 15.95 | 15000 | 1.6 |
| C-2 | Z-1 | 62 | Z-13 | 38 | | | | | 16.21 | 25000 | 1.8 |
| C-3 | Z-6 | 26 | Z-13 | 74 | | | | | 16.90 | 10000 | 1.6 |
| C-4 | Z-2 | 39 | Z-3 | 29 | Z-4 | 32 | | | 16.99 | 30000 | 1.7 |
| C-5 | Z-7 | 43 | Z-5 | 9 | Z-16 | 48 | | | 16.13 | 12000 | 1.6 |
| C-6 | Z-1 | 70 | Z-8 | 30 | | | | | 16.31 | 8000 | 1.5 |

(continued)

| Table 2 | Unit 1 | mol% | Unit 2 | mol% | Unit 3 | mol% | Unit 4 | mol% | [$SP_C$] | Mw | Mw/Mn |
|---|---|---|---|---|---|---|---|---|---|---|---|
| C-7 | Z-15 | 76 | Z-9 | 24 | | | | | 15.97 | 18000 | 1.7 |
| C-8 | Z-2 | 62 | Z-10 | 8 | Z-14 | 23 | Z-20 | 7 | 16.95 | 14000 | 1.6 |
| C-9 | Z-1 | 78 | Z-17 | 15 | Z-19 | 7 | | | 16.65 | 10000 | 1.6 |
| C-10 | Z-16 | 68 | Z-18 | 32 | | | | | 16.18 | 19000 | 1.7 |
| C-11 | Z-1 | 63 | Z-13 | 33 | Z-11 | 4 | | | 16.24 | 20000 | 1.7 |
| C-12 | Z-1 | 94 | Z-12 | 6 | | | | | 16.63 | 16000 | 1.6 |
| CR-1 | RZ-1 | 100 | | | | | | | 17.13 | 15000 | 1.5 |
| CR-2 | RZ-2 | 56 | RZ-3 | 44 | | | | | 16.69 | 12000 | 1.6 |

The monomer structures used for the synthesis of the hydrophobic resins C-1 to C-12 and CR-1 to CR-2 in Table 2 are as follows.

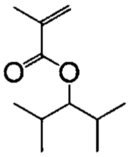

**Z-1**

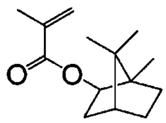

**Z-2**

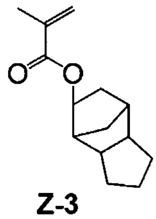

**Z-3**

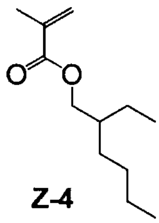

**Z-4**

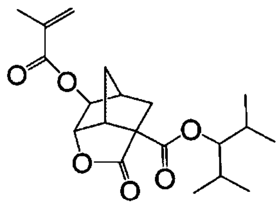

**Z-5**

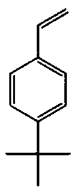

**Z-6**

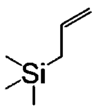

**Z-7**

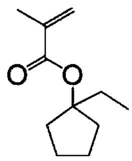

**Z-8**

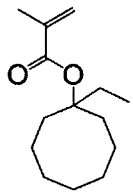

**Z-9**

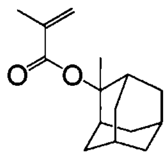

**Z-10**

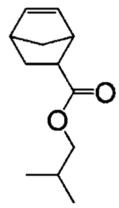

**Z-11**

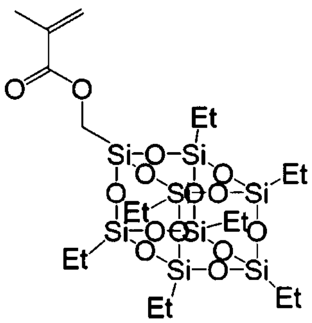

**Z-12**

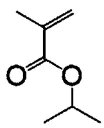

**Z-13**

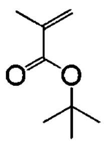

**Z-14**

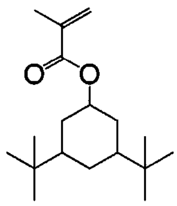

**Z-15**

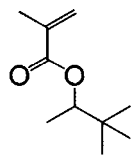

**Z-16**

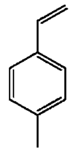

Z-17

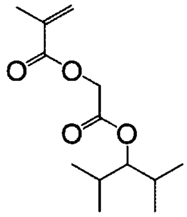

Z-18

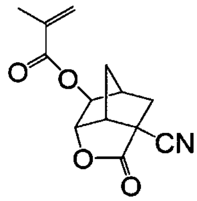

Z-19

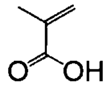

Z-20

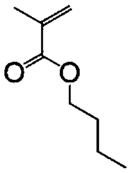

RZ-1

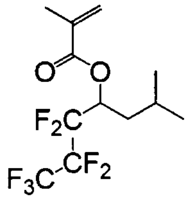

RZ-2

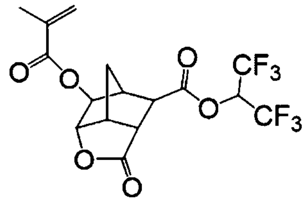

RZ-3

Surfactant

The surfactant employed was E-1.

E-1: PolyFox PF-6320 (manufactured by OMNOVA Solutions Inc.; fluorine-based) Solvents

The solvents employed are as follows.

S1: propylene glycol monomethyl ether acetate (PGMEA)
S2: propylene glycol monomethyl ether (PGME)
S3: γ-butyrolactone
S4: ethyl lactate
S5: cyclohexanone
S6: 2-heptanone

ArF exposure

Preparation of resist compositions

The components described in Tables 3 to 4 were dissolved in the solvents described in Tables 3 to 4 to prepare solutions having a solid-content concentration of 4.0 mass%, and the solutions were filtered through a polyethylene filter having a pore size of 0.02 μm to prepare resist compositions.

Note that the solid content means all the components other than the solvent. The obtained resist compositions were used in Examples and Comparative Examples.

In Tables 3 to 4, the columns "mass%" indicate the content (mass%) of each component relative to the total solid content in the resist composition. Tables 3 to 4 also describe the amounts of the solvents used (mass ratios).

Tables 3 and 4 will describe the SP values [$SP_A$] of the resin (A) and the SP values [$SP_C$] of the resin (C). In the resist composition Re-32, the SP values and the mass-based content ratios of the resin A-6 and the resin A-8 were individually multiplied, and the resultant values were summed up to determine [$SP_A$]. In the resist composition Re-33, the SP values and the mass-based content ratios of the resin C-2 and the resin C-5 were individually multiplied, and the resultant values were summed up to determine [$SP_c$].

The fluorine atom contents relative to the total solid contents of the resist compositions are described in Tables 3 and 4 as "F atom content" (mass%).

Table 3

Table 3

| Resist composition | Resin (A) | | | Onium salt (B) | | Acid diffusion control agent | | Resin (C) | | | Surfactant | | Solvent | | F atom content (mass%) |
|---|---|---|---|---|---|---|---|---|---|---|---|---|---|---|---|
| | Type | mass% | $[SP_A]$ | Type | mass% | Type | mass% | Type | mass% | [SPc] | Type | mass% | Type | Mass ratio | |
| Re-1 | A-1 | 81.0 | 18.05 | PAG1 | 14.7 | B-1 | 2.3 | C-1 | 2.0 | 15.95 | - | - | S1/S2 | 70/30 | 0 |
| Re-2 | A-2 | 79.9 | 18.78 | PAG2/PAG20 | 11.5/4.4 | B-2 | 2.6 | C-6 | 1.5 | 16.31 | E-1 | 0.1 | S1/S2 | 80/20 | 0.48 |
| Re-3 | A-3 | 64.7 | 18.72 | PAG10 | 20.0 | B-3 | 10.3 | C-3 | 5.0 | 16.90 | - | - | S1/S3 | 80/20 | 0 |
| Re-4 | A-4 | 79.9 | 17.59 | PAG4 | 16.0 | B-4 | 2.6 | C-4 | 1.5 | 16.99 | - | - | S1/S2 | 90/10 | 0 |
| Re-5 | A-5 | 80.0 | 18.95 | PAG12 | 14.7 | B-5 | 3.3 | C-5 | 2.0 | 16.13 | - | - | S1/S2/S4 | 70/25/5 | 0 |
| Re-6 | A-6 | 72.0 | 18.96 | PAG13 | 18.0 | B-6 | 6.0 | C-2 | 4.0 | 16.21 | - | - | S1/S2 | 70/30 | 0 |
| Re-7 | A-7 | 80.2 | 18.28 | PAG7 | 15.5 | B-7 | 2.3 | C-7 | 2.0 | 15.97 | - | - | S1/S2 | 70/30 | 0 |
| Re-8 | A-8 | 78.9 | 17.99 | PAG16 | 15.8 | B-5 | 2.3 | C-8 | 3.0 | 16.95 | - | - | S1/S2/S3 | 70/25/5 | 0 |
| Re-9 | A-9 | 72.4 | 19.00 | PAG9 | 15.8 | B-5 | 10.3 | C-9 | 1.5 | 16.65 | - | - | S1/S2 | 70/30 | 0 |
| Re-10 | A-10 | 74.4 | 18.10 | PAG3 | 19.6 | B-5 | 3.5 | C-10 | 2.5 | 16.18 | - | - | S1/S2 | 50/50 | 0 |
| Re-11 | A-11 | 79.0 | 18.39 | PAG11 | 16.2 | B-3 | 3.3 | C-11 | 1.5 | 16.24 | - | - | S1/S3 | 75/25 | 0 |
| Re-12 | A-12 | 77. 2 | 18.59 | PAG5 | 16.2 | B-5 | 3.6 | C-12 | 3.0 | 16.63 | - | - | S1/S2/S6 | 70/25/5 | 0 |
| Re-13 | A-13 | 80.0 | 18.33 | PAG6 | 15.4 | B-5 | 2.6 | C-1 | 2.0 | 15.95 | - | - | S1/S2 | 75/25 | 0 |
| Re-14 | A-1 | 74.5 | 18.05 | PAG14 | 15.4 | B-6 | 5.1 | C-1 | 5.0 | 15.95 | - | - | S1/S2 | 60/40 | 0 |
| Re-15 | A-1 | 75.9 | 18.05 | PAG15 | 16.8 | B-5 | 3.3 | C-1 | 4.0 | 15.95 | - | - | S1/S2/S5 | 70/25/5 | 0 |
| Re-16 | A-1 | 74.3 | 18.05 | PAG8 | 16.8 | B-3 | 5.9 | C-1 | 3.0 | 15.95 | - | - | S1/S2 | 70/30 | 0 |
| Re-17 | A-1 | 74.6 | 18.05 | PAG17 | 16.8 | B-7 | 3.6 | C-3 | 5.0 | 16.90 | - | - | S1/S2 | 90/10 | 0 |
| Re-18 | A-3 | 69.5 | 18.72 | PAG18 | 24.7 | B-4 | 2.3 | C-3 | 3.5 | 16.90 | - | - | S1/S3 | 80/20 | 2.74 |
| Re-19 | A-3 | 71.2 | 18.72 | PAG19 | 23.7 | B-1 | 2.6 | C-3 | 2.5 | 16.90 | - | - | S1/S2/S3 | 80/10/10 | 0 |
| Re-20 | A-3 | 68.7 | 18.72 | PAG20 | 23.7 | B-4 | 3.6 | C-3 | 4.0 | 16.90 | - | - | S1/S2 | 70/30 | 2.53 |
| Re-21 | A-3 | 73.7 | 18.72 | PAG21 | 20.5 | B-1 | 3.3 | C-3 | 2.5 | 16.90 | - | - | S1/S2/S4 | 35/60/5 | 0 |
| Re-22 | A-11 | 70.1 | 18.39 | PAG22 | 20.5 | B-3 | 5.9 | C-3 | 3.5 | 16.90 | - | - | S1/S2 | 40/60 | 0 |

(continued)

| Resist composition | Resin (A) | | | Onium salt (B) | | Acid diffusion control agent | | Resin (C) | | | Surfactant | | Solvent | | F atom content (mass%) |
|---|---|---|---|---|---|---|---|---|---|---|---|---|---|---|---|
| | Type | mass% | $[SP_A]$ | Type | mass% | Type | mass% | Type | mass% | [SPc] | Type | mass% | Type | Mass ratio | |
| Re-23 | A-12 | 74.8 | 18.59 | PAG23 | 21.9 | B-7 | 2.3 | C-3 | 1.0 | 16.90 | - | - | S1/S2 | 95/5 | 0 |
| Re-24 | A-4 | 83.1 | 17.59 | PAG24 | 12.5 | B-1 | 3.6 | C-4 | 0.8 | 16.99 | - | - | S1/S2 | 80/20 | 0 |
| Re-25 | A-6 | 72.1 | 18.96 | PAG25 | 20.5 | B-4 | 5.9 | C-5 | 1.5 | 16.13 | - | - | S1/S4 | 95/5 | 0 |

Table 4

Table 4

| Resist composition | Resin (A) | | | Onium salt (B) | | Acid diffusion control agent | | Resin (C) | | | Surfactant | | Solvent | | F atom content (mass%) |
|---|---|---|---|---|---|---|---|---|---|---|---|---|---|---|---|
| | Type | mass% | $[SP_A]$ | Type | mass% | Type | mass% | Type | mass% | [SPc] | Type | mass% | Type | Mass ratio | |
| Re-26 | A-5 | 74.7 | 18.95 | PAG26 | 20.5 | B-3 | 3.3 | C-6 | 1.5 | 16.31 | - | - | S1/S2 | 70/30 | 0 |
| Re-27 | A-8 | 79.0 | 17.99 | PAG27 | 15.9 | B-1 | 3.6 | C-7 | 1.5 | 15.97 | - | - | S1/S2 | 70/30 | 0 |
| Re-28 | A-10 | 79.9 | 18.10 | PAG28 | 16.3 | B-5 | 2.3 | C-8 | 1.5 | 16.95 | - | - | S1/S4 | 90/10 | 0 |
| Re-29 | A-9 | 76.3 | 19.00 | PAG29 | 16.3 | B-4 | 5.9 | C-9 | 1.5 | 16.65 | - | - | S1/S2 | 50/50 | 0 |
| Re-30 | A-2 | 78.3 | 18.78 | PAG30 | 17.6 | B-4 | 2.6 | C-10 | 1.5 | 16.18 | - | - | S1/S3 | 85/15 | 0 |
| Re-31 | A-6 | 72.0 | 18.96 | PAG13/PAG16 | 6.0/12.0 | B-6 | 6.0 | C-2 | 4.0 | 16.21 | - | - | S1/S2 | 70/30 | 0 |
| Re-32 | A-6/A-8 | 50.0/22.0 | 18.66 | PAG13 | 18.0 | B-6 | 6.0 | C-2 | 4.0 | 16.21 | - | - | S1/S2 | 70/30 | 0 |
| Re-33 | A-6 | 72.0 | 18.96 | PAG13 | 18.0 | B-6 | 6.0 | *C-2/C-5* | 2.0/2.0 | 16.17 | - | - | S1/S2 | 70/30 | 0 |
| Re-34 | A-6 | 72.0 | 18.96 | PAG13 | 18.0 | B-1/B-6 | 3.0/3.0 | C-2 | 4.0 | 16.21 | - | - | S1/S2 | 70/30 | 0 |
| Re-35 | A-14 | 58.5 | 18.83 | PAG13 | 25.0 | B-3 | 15.0 | C-2 | 1.5 | 16.21 | - | - | S1/S2 | 70/30 | 0 |
| Re-36 | A-15 | 46.0 | 18.62 | PAG16 | 30.0 | B-1 | 20.0 | C-1 | 4.0 | 15.95 | - | - | S1/S2 | 70/30 | 0 |
| Re-37 | A-16 | 68.0 | 19.35 | PAG1 | 20.0 | B-5 | 10.0 | C-5 | 2.0 | 16.13 | - | - | S1/S2 | 70/30 | 0 |
| Re-38 | A-17 | 69.0 | 19.09 | PAG18 | 25.0 | B-5 | 5.0 | C-3 | 1.0 | 16.90 | - | - | S1/S2 | 70/30 | 2.77 |
| Re-39 | A-18 | 54.5 | 19.57 | PAG20 | 40.0 | B-7 | 5.0 | C-4 | 0.5 | 16.99 | - | - | S1/S2 | 70/30 | 4.28 |
| Re-40 | A-19 | 53.0 | 19.12 | PAG13 | 35.0 | B-6 | 10.0 | C-6 | 2.0 | 16.31 | - | - | S1/S2 | 70/30 | 0 |
| Re-41 | A-20 | 71.5 | 19.56 | PAG26 | 22.0 | B-4 | 6.0 | C-10 | 0.5 | 16.18 | - | - | S1/S2 | 70/30 | 0 |
| RA-1 | A-1 | 77.7 | 18.05 | PAG31 | 16.0 | B-1 | 3.3 | CR-2 | 3.0 | 16.69 | - | - | S1/S2 | 80/20 | 1.03 |
| RA-2 | A-1 | 75.3 | 18.05 | PAG R2 | 17.5 | B-1 | 4.2 | CR-1 | 3.0 | 17.13 | - | - | S1/S5 | 70/30 | 1.50 |
| RA-3 | A-1 | 74.3 | 18.05 | PAG R2 | 17.5 | B-1 | 4.2 | C-1 | 4.0 | 15.95 | - | - | S1/S5 | 70/30 | 1.50 |
| RA-4 | A-1 | 70.6 | 18.05 | PAG1 | 14.7 | B-1 | 4.2 | C-1 | 10.5 | 15.95 | - | - | S1/S5 | 70/30 | 0 |
| RA-5 | A-14 | 77.7 | 18. 83 | PAG31 | 16.0 | B-1 | 3.3 | CR-2 | 3.0 | 16.69 | - | - | S1/S2 | 80/20 | 1.03 |
| RA-6 | A-14 | 75.3 | 18.83 | PAG R2 | 17.5 | B-1 | 4.2 | CR-1 | 3.0 | 17.13 | - | - | S1/S5 | 70/30 | 1.50 |

(continued)

| Resist composition | Resin (A) | | | Onium salt (B) | | Acid diffusion control agent | | Resin (C) | | | Surfactant | | Solvent | | F atom content (mass%) |
|---|---|---|---|---|---|---|---|---|---|---|---|---|---|---|---|
| | Type | mass% | $[SP_A]$ | Type | mass% | Type | mass% | Type | mass% | [SPc] | Type | mass% | Type | Mass ratio | |
| RA-7 | A-14 | 74.3 | 18.83 | PAG R2 | 17.5 | B-1 | 4.2 | C-1 | 4.0 | 15.95 | - | - | S1/S5 | 70/30 | 1.50 |
| RA-8 | A-14 | 70.6 | 18.83 | PAG1 | 14.7 | B-1 | 4.2 | C-1 | 10.5 | 15.95 | - | - | S1/S5 | 70/30 | 0 |

Pattern forming method (1): ArF exposure, alkali development (positive)

A resist composition immediately after the production in Tables 3 to 4 was applied onto a 6-inch Si wafer having been subjected to hexamethyldisilazane (HMDS) treatment in advance, using a spin coater Mark8 manufactured by Tokyo Electron Ltd., and dried on a hot plate at 100°C for 60 seconds to obtain a resist film having a film thickness of 90 nm. Here, 1 inch is 0.0254 m.

The wafer on which the resist film was formed was subjected to pattern exposure through an exposure mask using an ArF excimer laser scanner (manufactured by ASML, PAS5500/1500, wavelength: 193 nm, NA: 0.50). Subsequently, the resist film was baked at a temperature of 115°C for 60 seconds, then developed with a 2.38 mass% aqueous tetramethylammonium hydroxide solution (TMAHaq) for 30 seconds, rinsed with pure water, and then spin-dried. This provided a resist pattern of a 1:1 line-and-space pattern having a line width of 50 nm.

Performance evaluation

LWR (line width roughness) performance

When a 50 nm (1:1) line-and-space pattern resolved at the optimal exposure dose for resolving a line pattern having a line width of 50 nm on average was observed from above the pattern using a critical dimension scanning electron microscope (SEM (Hitachi, Ltd., S-9380II)), the line widths were observed at 50 points, and the standard deviation ($\sigma$) thereof was determined. The measurement variation of the line widths was evaluated on the basis of $3\sigma$, and the value of $3\sigma$ was defined as LWR (nm). The smaller the value of LWR, the better the LWR performance. The LWR is preferably 4.9 nm or less, more preferably 4.4 nm or less, and particularly preferably 3.9 nm or less.

Residual defects

A section of the 1:1 line-and-space pattern having a line width of 50 nm was observed using a scanning electron microscope (SEM, manufactured by Hitachi, Ltd., S-9380II), and a case where residue was not visually observed at all was evaluated as A, a case where a small but acceptable amount of residue was observed was evaluated as B, and a case where a large amount of residue was observed was evaluated as C.

The results will be described in Table 5.

Table 5

| Table 5 | Resist composition | LWR (nm) | Residual defects |
|---|---|---|---|
| Example 1-1 | Re-1 | 3.5 | A |
| Example 1-2 | Re-2 | 3.8 | A |
| Example 1-3 | Re-3 | 3.6 | A |
| Example 1-4 | Re-4 | 3.5 | A |
| Example 1-5 | Re-5 | 3.8 | A |
| Example 1-6 | Re-6 | 3.6 | A |
| Example 1-7 | Re-7 | 3.8 | A |
| Example 1-8 | Re-8 | 3.8 | A |
| Example 1-9 | Re-9 | 3.6 | A |
| Example 1-10 | Re-10 | 3.8 | A |
| Example 1-11 | Re-11 | 3.8 | A |
| Example 1-12 | Re-12 | 3.5 | A |
| Example 1-13 | Re-13 | 3.5 | A |
| Example 1-14 | Re-14 | 3.5 | A |
| Example 1-15 | Re-15 | 3.6 | A |
| Example 1-16 | Re-16 | 3.6 | A |
| Example 1-17 | Re-17 | 3.7 | A |

(continued)

| Table 5 | Resist composition | LWR (nm) | Residual defects |
|---|---|---|---|
| Example 1-18 | Re-18 | 3.8 | A |
| Example 1-19 | Re-19 | 3.7 | A |
| Example 1-20 | Re-20 | 3.8 | A |
| Example 1-21 | Re-21 | 3.7 | A |
| Example 1-22 | Re-22 | 3.7 | A |
| Example 1-23 | Re-23 | 3.7 | A |
| Example 1-24 | Re-24 | 4.1 | A |
| Example 1-25 | Re-25 | 4.0 | A |
| Example 1-26 | Re-26 | 3.8 | A |
| Example 1-27 | Re-27 | 4.0 | A |
| Example 1-28 | Re-28 | 4.0 | A |
| Example 1-29 | Re-29 | 3.8 | A |
| Example 1-30 | Re-30 | 4.2 | A |
| Example 1-31 | Re-31 | 3.5 | A |
| Example 1-32 | Re-32 | 3.6 | A |
| Example 1-33 | Re-33 | 3.6 | A |
| Example 1-34 | Re-34 | 3.5 | A |
| Comparative Example 1-1 | RA-1 | 5.2 | B |
| Comparative Example 1-2 | RA-2 | 5.5 | C |
| Comparative Example 1-3 | RA-3 | 5.4 | C |
| Comparative Example 1-4 | RA-4 | 5.4 | C |

Pattern forming method (2): ArF exposure, organic-solvent development (negative)

A resist composition immediately after the production in Tables 3 to 4 was applied onto a 6-inch Si wafer having been subjected to hexamethyldisilazane (HMDS) treatment in advance, using a spin coater Mark8 manufactured by Tokyo Electron Ltd., and dried on a hot plate at 100°C for 60 seconds to obtain a resist film having a film thickness of 90 nm. Here, 1 inch is 0.0254 m.

The wafer on which the resist film was formed was subjected to pattern exposure through an exposure mask using an ArF excimer laser scanner (manufactured by ASML, PAS5500/1500, wavelength: 193 nm, NA: 0.50). Subsequently, the resist film was baked at a temperature of 115°C for 60 seconds, then developed with n-butyl acetate for 30 seconds, and spin-dried. This provided a resist pattern of a 1:1 line-and-space pattern having a line width of 50 nm.

The LWR performance and the residual defects were evaluated by the same method as in the above-described performance evaluation of the pattern forming method (1).

The results will be described in Table 6.

Table 6

| Table 6 | Resist composition | LWR (nm) | Residual defects |
|---|---|---|---|
| Example 2-1 | Re-1 | 3.7 | A |
| Example 2-2 | Re-2 | 4.0 | A |
| Example 2-3 | Re-3 | 3.8 | A |
| Example 2-4 | Re-4 | 3.7 | A |
| Example 2-5 | Re-5 | 4.0 | A |

(continued)

| Table 6 | Resist composition | LWR (nm) | Residual defects |
|---|---|---|---|
| Example 2-6 | Re-6 | 3.8 | A |
| Example 2-7 | Re-7 | 4.0 | A |
| Example 2-8 | Re-8 | 4.0 | A |
| Example 2-9 | Re-9 | 3.8 | A |
| Example 2-10 | Re-10 | 4.0 | A |
| Example 2-11 | Re-11 | 4.0 | A |
| Example 2-12 | Re-12 | 3.7 | A |
| Example 2-13 | Re-13 | 3.7 | A |
| Example 2-14 | Re-14 | 3.7 | A |
| Example 2-15 | Re-15 | 3.8 | A |
| Example 2-16 | Re-16 | 3.8 | A |
| Example 2-17 | Re-17 | 3.9 | A |
| Example 2-18 | Re-18 | 4.0 | A |
| Example 2-19 | Re-19 | 3.9 | A |
| Example 2-20 | Re-20 | 4.0 | A |
| Example 2-21 | Re-21 | 3.9 | A |
| Example 2-22 | Re-22 | 3.9 | A |
| Example 2-23 | Re-23 | 3.9 | A |
| Example 2-24 | Re-24 | 4.3 | A |
| Example 2-25 | Re-25 | 4.2 | A |
| Example 2-26 | Re-26 | 4.0 | A |
| Example 2-27 | Re-27 | 4.2 | A |
| Example 2-28 | Re-28 | 4.2 | A |
| Example 2-29 | Re-29 | 4.0 | A |
| Example 2-30 | Re-30 | 4.4 | A |
| Example 2-31 | Re-31 | 3.7 | A |
| Example 2-32 | Re-32 | 3.8 | A |
| Example 2-33 | Re-33 | 3.8 | A |
| Example 2-34 | Re-34 | 3.7 | A |
| Comparative Example 2-1 | RA-1 | 5.4 | B |
| Comparative Example 2-2 | RA-2 | 5.7 | C |
| Comparative Example 2-3 | RA-3 | 5.6 | C |
| Comparative Example 2-4 | RA-4 | 5.6 | C |

EUV exposure

Preparation of resist compositions

The components described in Tables 3 to 4 were dissolved in the solvents described in Tables 3 to 4 and mixed so as to provide a solid-content concentration of 2.0 mass%. Subsequently, such an obtained mixed solution was filtered first through a polyethylene filter having a pore size of 50 nm, then through a nylon filter having a pore size of 10 nm, and finally through a polyethylene filter having a pore size of 5 nm, in this order; in this way, resist compositions were prepared.

Note that the solid content means all the components other than the solvent. The obtained resist compositions were used in Examples and Comparative Examples.

In Tables 3 to 4, the columns "mass%" indicate the content (mass%) of each component relative to the total solid content in the resist composition. Tables 3 to 4 also describe the amounts of the solvents used (mass ratios).

Pattern forming method (3): EUV exposure, alkali development (positive)

An underlayer film-forming composition AL412 (manufactured by Brewer Science, Inc.) was applied onto a silicon wafer, and baked at 205°C for 60 seconds to form an underlayer film having a film thickness of 20 nm. Onto the underlayer film, a resist composition described in Table 7 was applied and baked at 100°C for 60 seconds to form a resist film having a film thickness of 30 nm.

An EUV exposure apparatus (manufactured by Exitech Ltd., Micro Exposure Tool, NA: 0.3, Quadrupole, outer sigma: 0.68, inner sigma: 0.36) was used to subject the obtained silicon wafer having the resist film to pattern irradiation. Note that the reticle employed was a mask having a line size of 25 nm and line:space =1:1.

The exposed resist film was baked at 90°C for 60 seconds, subsequently developed with an aqueous tetramethylammonium hydroxide solution (2.38 mass%) for 30 seconds, and subsequently rinsed with pure water for 30 seconds. Subsequently, this was spin-dried to obtain a positive pattern.

Performance evaluation

LWR performance

When a 25 nm (1:1) line-and-space pattern resolved at the optimal exposure dose for resolving a line pattern having a line width of 25 nm on average was observed from above the pattern using a critical dimension scanning electron microscope (SEM (Hitachi, Ltd., S-9380II)), the line widths were observed at 50 points, and the standard deviation ($\sigma$) thereof was determined. The measurement variation of the line widths was evaluated on the basis of $3\sigma$, and the value of $3\sigma$ was defined as LWR (nm). The smaller the value of LWR, the better the LWR performance. The LWR is preferably 4.2 nm or less, more preferably 4.0 nm or less, and particularly preferably 3.7 nm or less.

Residual defects

A section of the 1:1 line-and-space pattern having a line width of 25 nm was observed using a scanning electron microscope (SEM, manufactured by Hitachi, Ltd., S-9380II), and a case where residue was not visually observed at all was evaluated as A, a case where a small but acceptable amount of residue was observed was evaluated as B, and a case where a large amount of residue was observed was evaluated as C.

The results will be described in Table 7.

Table 7

| Table 7 | Resist composition | LWR (nm) | Residual defects |
|---|---|---|---|
| Example 3-1 | Re-35 | 3.3 | A |
| Example 3-2 | Re-36 | 3.3 | A |
| Example 3-3 | Re-37 | 3.6 | A |
| Example 3-4 | Re-38 | 3.6 | A |
| Example 3-5 | Re-39 | 3.6 | A |
| Example 3-6 | Re-40 | 3.6 | A |
| Example 3-7 | Re-41 | 3.6 | A |
| Comparative Example 3-1 | RA-5 | 4.3 | B |
| Comparative Example 3-2 | RA-6 | 4.5 | C |
| Comparative Example 3-3 | RA-7 | 4.6 | C |
| Comparative Example 3-4 | RA-8 | 4.6 | C |

Pattern forming method (4): EUV exposure, organic-solvent development (negative)

An underlayer film-forming composition AL412 (manufactured by Brewer Science, Inc.) was applied onto a silicon wafer, and baked at 205°C for 60 seconds to form an underlayer film having a film thickness of 20 nm. Onto the underlayer film, a resist composition described in Table 8 was applied and baked at 100°C for 60 seconds to form a resist film having a film thickness of 30 nm.

An EUV exposure apparatus (manufactured by Exitech Ltd., Micro Exposure Tool, NA: 0.3, Quadrupole, outer sigma: 0.68, inner sigma: 0.36) was used to subject the obtained silicon wafer having the resist film to pattern irradiation. Note that the reticle employed was a mask having a line size of 25 nm and line:space = 1:1.

The exposed resist film was baked at 90°C for 60 seconds, and subsequently developed with n-butyl acetate for 30 seconds; and this was spin-dried to obtain a negative pattern.

The LWR performance and the residual defects were evaluated by the same method as in the above-described performance evaluation of the pattern forming method (3).

The results will be described in Table 8.

Table 8

| Table 8 | Resist composition | LWR (nm) | Residual defects |
|---|---|---|---|
| Example 4-1 | Re-35 | 3.4 | A |
| Example 4-2 | Re-36 | 3.4 | A |
| Example 4-3 | Re-37 | 3.7 | A |
| Example 4-4 | Re-38 | 3.7 | A |
| Example 4-5 | Re-39 | 3.7 | A |
| Example 4-6 | Re-40 | 3.7 | A |
| Example 4-7 | Re-41 | 3.7 | A |
| Comparative Example 4-1 | RA-5 | 4.4 | B |
| Comparative Example 4-2 | RA-6 | 4.6 | C |
| Comparative Example 4-3 | RA-7 | 4.7 | C |
| Comparative Example 4-4 | RA-8 | 4.7 | C |

The results of Tables 5 to 8 have demonstrated that the resist compositions used in Examples have high LWR performance and can achieve reduction in the amount of post-development residue.

The present invention can provide an actinic ray-sensitive or radiation-sensitive resin composition that has high LWR performance and can achieve reduction in the amount of post-development residue.

In addition, the present invention can provide a resist film, a pattern forming method, and a method for producing an electronic device that use the above-described actinic ray-sensitive or radiation-sensitive resin composition.

The present invention has been described in detail and with reference to specific embodiments thereof; however, it would be apparent to those skilled in the art that various changes and modifications can be made therein without departing from the spirit and scope of the present invention.

Note that the present application is based on a Japanese patent application filed on March 7, 2023 (JP2023-034922), and the contents of which are incorporated herein by reference.

## Claims

1. An actinic ray-sensitive or radiation-sensitive resin composition comprising a resin (A) which provides increased polarity by action of an acid, an onium salt (B) represented by a formula (1) below, and a resin (C) satisfying all of (i) to (iii) below:

   (i) no fluorine atom is included,
   (ii) an SP value [$SP_C$] of the resin (C) is smaller than an SP value [$SP_A$] of the resin (A) and is 17.00 or less, and
   (iii) a content relative to a total solid content of the actinic ray-sensitive or radiation-sensitive resin composition is 0.01 to 10 mass%,

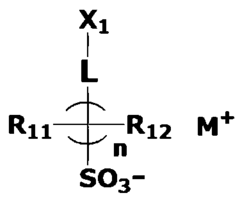

(1)

wherein, in the formula (1),

$R_{11}$ represents a hydrogen atom, a cyano group, a nitro group, a substituent represented by a formula (1A) below, or a substituent represented by a formula (1B) below,

$R_{12}$ represents a hydrogen atom or a substituent which does not have a fluorine atom,

n represents an integer of 1 to 4; when n is an integer of 2 to 4, a plurality of $R_{11}$ and a plurality of $R_{12}$ may be the same or different, and at least one $R_{11}$ represents a cyano group, a nitro group, a substituent represented by the formula (1A) below, or a substituent represented by the formula (1B) below,

L represents a single bond or a divalent linking group,

$X_1$ represents a hydrogen atom or an organic group,

$M^+$ represents an organic cation,

at least two of $R_{11}$, $R_{12}$, L, and $X_1$ may be bonded together to form a ring,

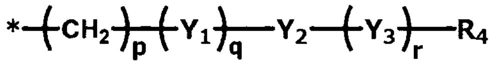

(1A)

in the formula (1A), $Y_1$ and $Y_3$ each independently represent -O- or $-NR_3-$, $R_3$ represents a hydrogen atom or an alkyl group, $Y_2$ represents -C(=O)- or $-SO_2-$, $R_4$ represents an alkyl group, a cycloalkyl group, or an aryl group, p represents an integer of 0 to 2, q and r each independently represent 0 or 1, * represents a bonding site,

$$*\text{-}CH_2\text{-}R_X \qquad (1B)$$

in the formula (1B), $R_X$ represents a cyano group or a nitro group, and * represents a bonding site.

**2.** The actinic ray-sensitive or radiation-sensitive resin composition according to claim 1, wherein the onium salt represented by the formula (1) is represented by a formula (2) below:

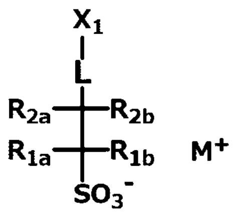

(2)

in the formula (2),

$R_{1a}$ and $R_{2a}$ each independently represent a hydrogen atom, a cyano group, a nitro group, a substituent represented by the formula (1A), or a substituent represented by the formula (1B), and at least one of $R_{1a}$ or $R_{2a}$ represents a cyano group, a nitro group, a substituent represented by the formula (1A), or a substituent represented by the formula (1B),

$R_{1b}$ and $R_{2b}$ each independently represent a hydrogen atom or a substituent which does not have a fluorine atom,

L, $X_1$, and $M^+$ respectively have the same meanings as L, $X_1$, and $M^+$ in the formula (1), and

at least two of $R_{1a}$, $R_{1b}$, $R_{2a}$, $R_{2b}$, L, and $X_1$ may be bonded together to form a ring.

**3.** The actinic ray-sensitive or radiation-sensitive resin composition according to claim 2, wherein, in the formula (2), $R_{1a}$ represents a hydrogen atom, a cyano group, a nitro group, or a substituent represented by a formula (2A) below, $R_{2a}$ represents a cyano group, a nitro group, a substituent represented by the formula (2A) below, or a substituent represented by a formula (2B) below:

$$*-(Y_1)_q-Y_2-(Y_3)_r-R_4 \qquad (2A)$$

in the formula (2A), $Y_1$ and $Y_3$ each independently represent -O- or $-NR_3-$, $R_3$ represents a hydrogen atom or an alkyl group, $Y_2$ represents -C(=O)- or $-SO_2-$, $R_4$ represents an alkyl group, a cycloalkyl group, or an aryl group, q and r each independently represent 0 or 1, * represents a bonding site,

$$*-CH_2-R_Y \qquad (2B)$$

in the formula (2B), $R_Y$ represents a cyano group, a nitro group, or a substituent represented by the formula (2A), and * represents a bonding site.

**4.** The actinic ray-sensitive or radiation-sensitive resin composition according to claim 1, wherein the resin (C) does not have acid decomposability.

**5.** The actinic ray-sensitive or radiation-sensitive resin composition according to claim 1, wherein the resin (C) includes at least one of a repeating unit represented by a formula (3A) below or a repeating unit represented by a formula (3B):

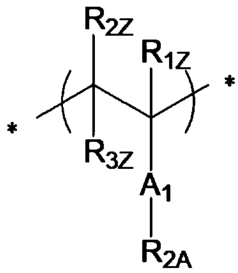

(3A)

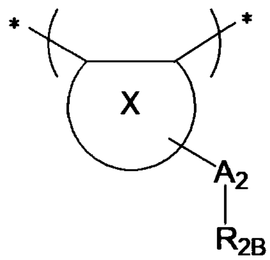

(3B)

in the formula (3A), $R_{1Z}$ represents a hydrogen atom, an alkyl group, a cycloalkyl group, or a cyano group;
$R_{2Z}$ and $R_{3Z}$ each independently represent a hydrogen atom or an alkyl group;
$A_1$ represents a divalent linking group;
$R_{2A}$ represents an organic group including two or more $CH_3$ partial structures; and
at least two of $R_{1Z}$ to $R_{3Z}$ and $A_1$ may be bonded together to form a ring, and
in the formula (3B), X represents an alicyclic group;
$A_2$ represents a divalent linking group; and
$R_{2B}$ represents an organic group including two or more $CH_3$ partial structures.

**6.** The actinic ray-sensitive or radiation-sensitive resin composition according to claim 1, wherein the resin (C) includes a repeating unit represented by a formula (3C) below and does not have acid decomposability,

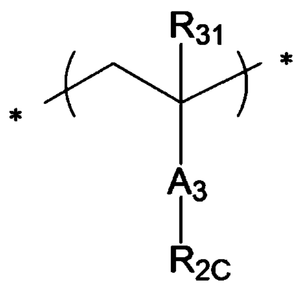

(3C)

in the formula (3C), $R_{31}$ represents a hydrogen atom, an alkyl group, a cycloalkyl group, or a cyano group, $A_3$ represents a divalent linking group, and $R_{2C}$ represents an organic group including two or more $CH_3$ partial structures.

7. The actinic ray-sensitive or radiation-sensitive resin composition according to claim 3, wherein, in the formula (2), $R_{1a}$ represents a cyano group, a nitro group, or a substituent represented by the formula (2A).

8. The actinic ray-sensitive or radiation-sensitive resin composition according to claim 7, wherein the onium salt represented by the formula (2) is represented by a formula (4) below:

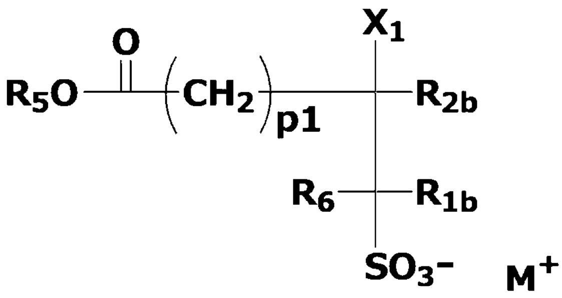

(4)

in the formula (4), $R_5$ represents an alkyl group, a cycloalkyl group, or an aryl group, p1 represents 0 or 1, $R_6$ represents a cyano group or a group represented by $-SO_2-R_7$, $R_7$ represents an alkyl group, a cycloalkyl group, or an aryl group, and $R_{1b}$, $R_{2b}$, $X_1$, and $M^+$ respectively have the same meanings as $R_{1b}$, $R_{2b}$, $X_1$, and $M^+$ in the formula (2).

9. The actinic ray-sensitive or radiation-sensitive resin composition according to claim 1, wherein a mass ratio ((C)/(B)) of a content of the resin (C) to a content of the onium salt (B) in the actinic ray-sensitive or radiation-sensitive resin composition is 0.05 to 3.0.

10. The actinic ray-sensitive or radiation-sensitive resin composition according to claim 1, wherein a fluorine atom content relative to the total solid content of the actinic ray-sensitive or radiation-sensitive resin composition is 1.00 mass% or less.

11. A resist film formed using the actinic ray-sensitive or radiation-sensitive resin composition according to any one of claims 1 to 10.

12. A pattern forming method comprising:

a step of using the actinic ray-sensitive or radiation-sensitive resin composition according to any one of claims 1 to 10 to form a resist film on a substrate;
a step of exposing the resist film; and
a step of developing the exposed resist film using a developer.

13. A method for producing an electronic device, the method comprising the pattern forming method according to claim 12.

## INTERNATIONAL SEARCH REPORT

International application No.
**PCT/JP2024/007719**

**A. CLASSIFICATION OF SUBJECT MATTER**

***G03F 7/004***(2006.01)i; ***G03F 7/20***(2006.01)i; ***G03F 7/038***(2006.01)i; ***G03F 7/039***(2006.01)i
FI: G03F7/004 503A; G03F7/039 601; G03F7/004 501; G03F7/038 601; G03F7/20 501; G03F7/20 521

According to International Patent Classification (IPC) or to both national classification and IPC

**B. FIELDS SEARCHED**

Minimum documentation searched (classification system followed by classification symbols)

G03F7/004; G03F7/20; G03F7/038; G03F7/039

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2017/154345 A1 (FUJIFILM CORPORATION) 14 September 2017 (2017-09-14) example 8 | 1, 4-6, 9-13 |
| A | | 2-3, 7-8 |
| A | WO 2016/181722 A1 (FUJIFILM CORPORATION) 17 November 2016 (2016-11-17) examples | 1-13 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 April 2024** | **23 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/007719**

| Patent document cited in search report | Publication date (day/month/year) | Patent family member(s) | Publication date (day/month/year) |
|---|---|---|---|
| WO 2017/154345 A1 | 14 September 2017 | US 2018/0364571 A1<br>example 8<br>KR 10-2018-0100186 A<br>TW 201800842 A | |
| WO 2016/181722 A1 | 17 November 2016 | US 2018/0107118 A1<br>examples<br>KR 10-2017-0130526 A<br>TW 201701077 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016206586 A
- JP 2012032782 A
- WO 2022024928 A
- JP 2014041327 A
- WO 2018193954 A
- JP 2014098921 A
- WO 2022172715 A
- US 20120251948 A
- WO 2020066824 A
- WO 2020158337 A
- US 20160070167 A
- US 20150004544 A
- US 20160237190 A
- US 20160274458 A
- WO 2020004306 A
- JP 2014059543 A
- JP 2013061648 A


### Non-patent literature cited in the description


- *Materials Letters*, 2008, vol. 62, 3152
- Prediction of polymer properties. Marcel Dekker Inc, 1993
- *Journal of Medicinal Chemistry*, 2011, vol. 54, 3606-3623